# EUROPEAN PATENT SPECIFICATION

(11) **EP 4 349 842 B1**
(45) Date of publication and mention of the grant of the patent: **27.05.2026**
(21) Application number: 22199535.0
(22) Date of filing: 04.10.2022
(51) Int. Cl.: C07F 9/44, C07F 9/655, C07F 9/6553, H10K 85/60

(54) **HYDROXYAMINOPHOSPHINIC ACID DERIVATIVES**
HYDROXYAMINOPHOSPHINSÄURE-DERIVATE
DÉRIVÉS D'ACIDE HYDROXYAMINOPHOSPHINIQUE

(43) Date of publication of application: 10.04.2024
(73) Proprietor: Merck Patent GmbH, 64293 Darmstadt (DE); Jacobs University Bremen gGmbH, 28759 Bremen (DE)
(72) Inventor: Kirsch, Peer, 64293 Darmstadt (DE); Seim, Henning, 64293 Darmstadt (DE); Voges, Frank, 64293 Darmstadt (DE); Roeschenthaler, Gerd-Volker, 28759 Bremen (DE); Pajkert, Romana, 28759 Bremen (DE)
(74) Representative: Merck Patent Association

(56) References cited:
- WO-A1-2020/225398
- MAHAJNA MAHMOUD ET AL: "Oxidative Bioactivation of Methamidophos Insecticide:? Synthesis of N -Hydroxymethamidophos (A Candidate Metabolite) and Its Proposed Alternative Reactions Involving N -> O Rearrangement or Fragmentation through a Metaphosphate Analogue", CHEMICAL RESEARCH IN TOXICOLOGY, vol. 11, no. 1, 1 January 1998 (1998-01-01), US, pages 26 - 34, XP093029004, ISSN: 0893-228X, DOI: 10.1021/tx9701135
- HARGER MARTIN J. P. ET AL: "N-phosphonoyl and N-phosphoroyl hydroxylamines: reactions of their O-sulphonyl derivatives with t-butylamine", JOURNAL OF THE CHEMICAL SOCIETY, PERKIN TRANSACTIONS 1, 1 January 1985 (1985-01-01), Cambridge, UK, pages 2651, XP093029005, ISSN: 0300-922X, DOI: 10.1039/p19850002651

## Description

The present invention relates to hydroxyamino phosphinic acid derivatives, to a method for their preparation and to their use for the fabrication of self-assembled monolayers (SAM), in particular for the fabrication of switchable SAM for electronic devices. The invention further relates to electronic devices comprising said SAM.

Compounds for the preparation of self-assembled monolayers are known from prior art and are widely used, for example, for the derivatization of electrodes for electronic components. These monolayers are ordered arrays of rod-shaped molecules bonded to a substrate via a suitable anchor group and carrying a functional group at the other end of the molecular backbone. Such monolayers are useful for controlling the physical and chemical properties of surfaces and interfaces. Frequently, self-assembled monolayers are used in organic electronics for electrostatic engineering of interfaces by controlling the alignment of interface levels. The performance and lifetime of these devices, such as organic light-emitting diodes (OLEDs), photovoltaics (OPVs), and field-effect transistors (OFETs), depend critically on the properties of both active materials and their interfaces. Interfacial properties can be controlled from simple wettability or adhesion between different materials to direct modifications of the electronic structure of the materials.

Recently, switchable SAM have been proposed for use in computer memory. In computer technology, storage media are required which allow rapid writing and reading access to information stored therein. Solid-state memories or semiconductor memories allow particularly fast and reliable storage media to be achieved, since absolutely no moving parts are necessary. At present, use is mainly made of dynamic random-access memory (DRAM). DRAM allows rapid access to the stored information, but this information has to be refreshed regularly, meaning that the stored information is lost when the power supply is switched off.

The prior art also discloses non-volatile semiconductor memories, such as flash memory or magnetoresistive random access memory (MRAM), in which the information is retained even after the power supply has been switched off. A disadvantage of flash memory is that writing access takes place comparatively slowly and the memory cells of the flash memory cannot be erased ad infinitum. The lifetime of flash memory is typically limited to a maximum of one million read/write cycles. MRAM can be used in a similar way to DRAM and has a long lifetime, but this type of memory has not been able to establish itself owing to the difficult production process.

A further alternative is memory which works on the basis of memristors. The term memristor is a contraction of the words "memory" and "resistor" and denotes a component which is able to change its electrical resistance reproducibly between a high and a low electrical resistance. The respective state (high resistance or low resistance) is retained even without a supply voltage, meaning that non-volatile memories can be achieved with memristors. Crossbar arrays of memristors may be used in a variety of applications, including non-volatile solid-state memory, programmable logic, signal processing, control systems, pattern recognition, and other applications. A memristive cross-bar array includes a number of row lines, a number of column lines intersecting the row lines to form a number of junctions, and a number of resistive memory devices coupled between the row lines and the column lines at the junctions.

WO 2016/110301 A1 andWO 2018/007337 A2 disclose electronic components which are suitable for use in memristive devices. Herein, a non-redox active molecular layer comprising dipolar compounds linked to a substrate via an aliphatic spacer group are proposed, where the compounds are reversibly switched by application of an electric field which causes re-orientation of the molecular dipole and thus enabling a low-resistive state and a high-resistive state depending on the respective orientation of the molecules. WO 2020/225398 A1 discloses aromatic phosphonic acids and their use in electronic switching elements.

Compounds for the preparation of SAM comprise an organic residue and a group suitable for binding to a substrate surface and thus fixing the organic residue to the surface. Suitable anchor groups include thiol, phosphonic acid, phosphoric acid, sulfuric acid, sulfonic acid, carboxylic acid or siloxanes. The choice of the anchor group depends largely on the chemical nature of the substrate, with the anchor group and substrate together dictating the nature and stability of the bond between the individual molecules forming the monolayer and the substate.

The deposition of the SAM onto suitable substrates is preferably performed by either spin coating or dip coating from an organic solvent. The amphiphilic nature of the SAM precursor and the high polarity of the anchoring group often lead to poor solubility of the precursor. These compounds show very low solubility in most polar aprotic solvents, and the SAMs can only be applied from rather dilute solutions in toxic solvents such as THF or dioxane. They do not dissolve in sufficient concentrations in typical semiconductor industry solvent.

There is a need in the art for materials which form SAMs of acceptable quality with very short deposition times and convenient deposition processes. In order to achieve a high quality SAM it is important that the SAM formation proceeds first via a thermodynamically reversible physisorption step before it is fixed into place by an annealing step initiating an irreversible condensation reaction.

In particular, the widely used phosphonic acids form high quality SAMs on substrates such as Al₂O₃, but it is notoriously difficult to obtain a good SAM on materials with a lower isoelectric point.

The present invention has been made in view of the above problems, and an object of the present invention is to provide an anchoring group that enables SAM precursors that do not show the above disadvantages or at least do so to a less extent. A further object is to search for novel compounds which are suitable for the production of electronic components using methods that are conventional in the memory industry.

To solve the problem there is provided a compound selected from the compounds of the formulae Ia-1a to Ia-1d, and la-2: 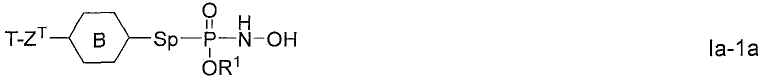 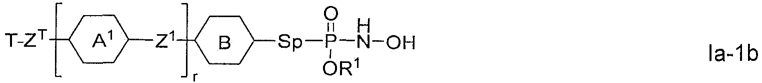 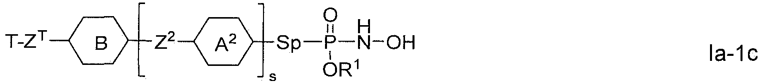 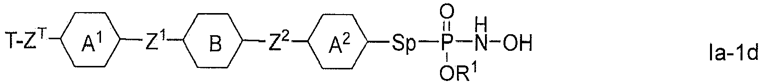 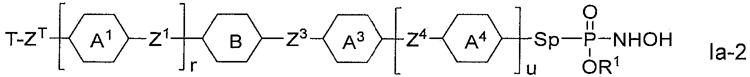
where in the compounds of the formulae Ia-1a, la-1b, Ia-1c and Ia-1d, r is 1 or 2, and s is 1 or 2,
and in the compound of the formula la-2, r and u, identically or differently, are 0, 1 or 2,
and in which
   T is selected from the group of radicals consisting of the following groups:
   a) straight chain or branched alkyl or alkoxy each having 1 to 20 C atoms, where one or more CH₂ groups in these radicals may each be replaced, independently of one another, by -C≡C- , -CH=CH-, 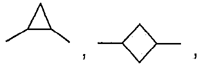 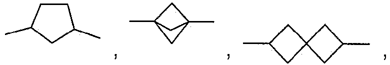 -O-, -S-, -CF₂O-, -OCF₂-, -CO-O-, -O-CO- ,-SiR⁰R⁰⁰- , -NH- , -NR⁰- or -SO₂- in such a way that O atoms are not linked directly to one another, and in which one or more H atoms may be replaced by halogen, CN, SCN or SF₅, wherein R⁰ and R⁰⁰, identically or differently, denote an alkyl or alkoxy radical having 1 to 15 C atoms, in which, in addition, one or more H atoms may be replaced by halogen,
   b) a three- to ten-membered saturated or partially unsaturated aliphatic ring, in which at least one -CH₂- group is replaced with -O-, -S-, -S(O)-, -SO₂-, -NR^{x}- or -N(O)R^{x}-, or in which at least one -CH= group is replaced with -N=,
   c) a diamondoid radical,
Z^{T}, Z¹, Z², and Z⁴, on each occurrence, identically or differently, denote a single bond, -CF₂O-, -OCF₂-, -CF₂S-, -SCF₂-, -CH₂O-, -OCH₂-, -C(O)O-, -OC(O)-, -C(O)S-, -SC(O)-, -(CH₂)ₙ₁-, -(CF₂)ₙ₂-, -CF₂ CH₂-, -CH₂CF₂-, -CH=CH-,-CF=CF-, -CF=CH-, -CH=CF-, -(CH₂)ₙ₃O-, -O(CH₂)ₙ₄-, -C=C-, -O-, -S-, -CH=N-, -N=CH-, -N=N-, -N=N(O)-, -N(O)=N- or -N=C-C=N-, wherein n1, n2, n3, n4, identically or differently, are 1, 2, 3, 4, 5, 6, 7, 8, 9 or 10,
Z³ denotes -O-, -S-, -CH₂-, -C(O)-, -CF₂-, -CHF-, -C(R^{x})₂-, -S(O)- or -SO₂-, 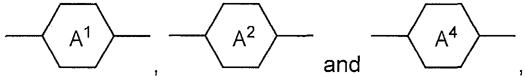 on each occurrence, identically or differently, denote an aromatic, heteroaromatic, alicyclic or heteroaliphatic ring having 4 to 25 ring atoms, which may also contain condensed rings and which may be mono- or polysubstituted by Y, 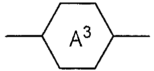 denotes an aromatic or heteroaromatic ring having 5 to 25 ring atoms, which may also contain condensed rings and which may be mono- or polysubstituted by R^{C},
Y on each occurrence, identically or differently, denotes F, Cl, CN, SCN, SF₅ or straight-chain or branched, in each case optionally fluorinated alkyl, alkoxy, alkylcarbonyl, alkoxycarbonyl, alkylcarbonyloxy or alkoxycarbonyloxy having 1 to 12 C atoms, 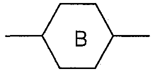 denotes a group 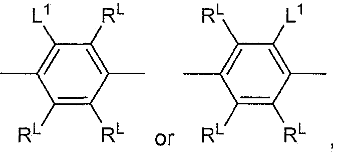 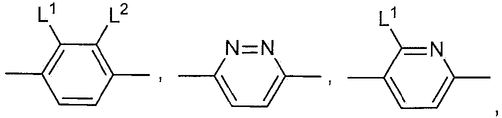 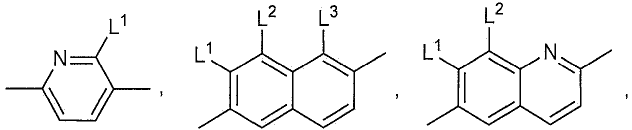 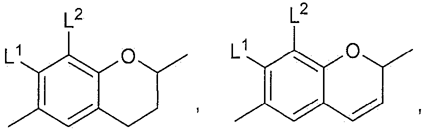 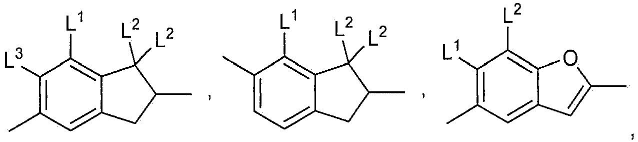 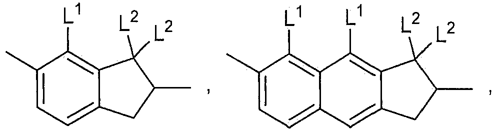 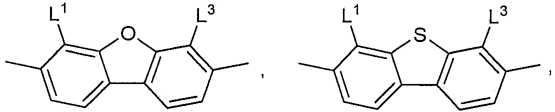 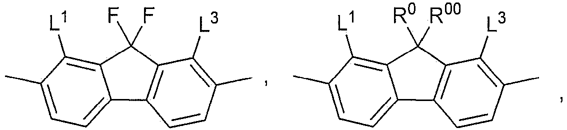 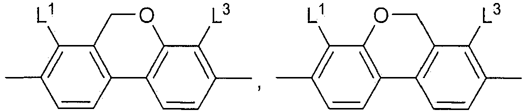 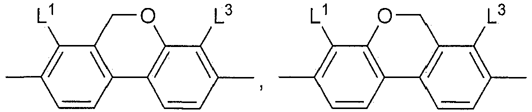 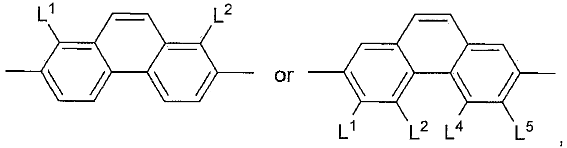 wherein the groups may be oriented in both directions,
L¹ to L⁵, identically or differently, denote H, F, Cl, Br, I, CN, SF₅, CF₃, OCF₃, or OCHF₂, where at least one of the present radicals L¹ to L⁵ in the respective groups is not H,
R^{L} on each occurrence, identically or differently, denotes H, alkyl having 1 to 6 C atoms, alkenyl having 2 to 6 C atoms or alkoxy having 1 to 5 C atoms,
R^{C} on each occurrence, identically or differently, denotes straight-chain or branched, in each case optionally fluorinated alkyl, alkoxy, alkylthio, alkylcarbonyl, alkoxycarbonyl, alkylcarbonyloxy or alkoxycarbonyloxy having 1 to 12 C atoms or cycloalkyl or alkylcycloalkyl each having 3 to 12 C atoms,
R⁰, R⁰⁰, R^{x} denote straight-chain or branched alkyl having 1 to 6 C atoms,
R¹ denotes H or straight chain or branched alkyl having 1 to 12 C atoms,
Sp denotes a single bond or Sp'-X' in which X' is bonded to a ring A², A³, A⁴ or B
   in which
   Sp' denotes straight-chain or branched alkylene having 1 to 20, preferably 1 to 12 C atoms, which is optionally mono- or polysubstituted by F, Cl, Br, I or CN and in which, in addition, one or more non-adjacent CH₂ groups may each be replaced, independently of one another, by - O-, -S-, -NH-, -NR⁰-, -SiR⁰⁰R⁰⁰⁰-, -CO-, -COO-, -OCO-, -OCO-O-, -S-CO-, -CO-S-, -NR⁰-CO-O-, -O-CO-NR⁰-, -NR⁰-CO-NR⁰-, -CH=CH- or -C≡C- in such a way that O and/or S atoms are not linked directly to one another,
   X' denotes -O-, -S-, -CO-, -COO-, -OCO-, -O-COO-, -CO-NR⁰⁰-, -NR⁰⁰-CO-, -NR⁰⁰-CO-NR⁰⁰-, -OCH₂-, -CH₂O-, -SCH₂-, -CH₂S-, -CF₂O-, -OCF₂-, -CF₂S-, -SCF₂-, -CF₂CH₂-, -CH₂CF₂-, -CF₂CF₂-, -CH=N-, -N=CH-, -N=N-, -CH=CR⁰⁰-, -CY^{x}=CY^{x'}-, -C≡C-, -CH=CH-COO-, -OCO-CH=CH- or a single bond, in which R⁰, R⁰⁰ and R⁰⁰⁰ each, independently of one another, denote H or alkyl having 1 to 12 C atoms, and Y^{x} and Y^{x'} each, independently of one another, denote H, F, Cl or CN.

The present invention further relates to a process for the production of the compound of the formula Ib defined below.

According to another aspect of the present invention there is provided a switching device comprising, in this sequence,
a first electrode,
a molecular layer bonded to the first electrode, and
a second electrode,
where the molecular layer is essentially formed from one or more, preferably one, compounds selected from the group of compounds of the formulae la-1a, la-1b, la-1c, la-1d, and la-2, defined above and below.

The invention furthermore relates to a process for the production of the switching device according to the invention comprising at least the following steps:
i. production of a first electrode having a surface;
ii. deposition of a molecular layer comprising one or more compounds selected from the group of compounds of the formulae la-1a, la-1b, la-1c, la-1d, and la-2, as defined above onto the surface of the first electrode;
iii. application of a second electrode.

According to another aspect of the present invention there is provided an electronic component where the component is a memristive crossbar array comprising a multitude of switching devices according to the present invention. Said crossbar array can be integrated into a three-dimensional array of cells comprising a stack of two or more crossbar arrays. Such configurations are known as 3D cross-point or 3D X-point memory devices.

The invention further relates to the use of a molecular layer obtained from one or more compounds as indicated in claim 1 in a memristive electronic component.

The resulting devices can be used in memory, sensors, field-effect transistors or Josephson junctions, preferably in resistive memory devices.

The present invention further relates to the use of the switching devices in memory, sensors, field-effect transistors or Josephson junctions.

The switching devices according to the invention are suitable for use in electronic components, in particular in memory, sensors, field-effect transistors or Josephson junctions, very particularly in memristive components such as memristive crossbar-arrays, which exhibit the advantageous properties indicated above.

The compounds of the formulae Ia-1a, la-1b, Ia-1c, la-1d, and la-2, which comprise a hydroxyaminophosphinic acid or a hydroxyaminophosphinic acid derived anchoring group are surprisingly well soluble in solvents used in the memory industry, in particular in halogenated hydrocarbons (chlorobenzene, trichloroethylene, Solkan-365 (HFC-365mfc, 1,1,1,3,3-pentafluorobutane), or weakly polar esters, ethers and ketones (propylene glycol monomethyl ether acetate (PGMEA), propylene glycol monomethyl ether (PGME), methyl amyl ketone (MAK), ethyl acetate, methyl tert-butyl ether (MTBE), cyclohexanone), but also in common solvents such as γ-butyrolactone, N-methyl pyrrolidone (NMP), tetrahydrofuran (THF), toluene, anisole, chlorobenzene, or CH₂Cl₂.

The compounds of the formulae la-1a, la-1b, la-1c, la-1d, and la-2 show an improvement of SAM quality and speed of SAM formation, particularly on more acidic substrates with a lower isoelectric point (e.g., TiN, Ta₃N₅,TaNₓ, TaON, Ta₂O₅, SiO₂, ZrO₂, HfO₂, WO₃,

RuO₂, Cu₂O, TiO₂, Co₂O₃) and on metals (e.g., Si, Co, Ni, W, Ru, Cu, Pt via their native oxides or surface oxidation by oxygen plasma, UV/O₃ treatment or similar methods).

The SAM precursors of the formulae Ia-1a, Ia-1b, Ia-1c, Ia-1d, and la-2 and electronic components obtained from these compounds are distinguished by a surprisingly high chemical and thermal stability. Switchable electronic components obtained from the compounds of the formulae Ia-1a, la-1b, Ia-1c, la-1d, and la-2 require only a low voltage and low electrical field strength for switching the device and show a long retention of the resistive state. The switching device exhibits high reliability and endurance and a high stability against dielectric breakdown. Furthermore, the memory window is advantageously large.

The electrode materials that can be used in the device according to the invention are highly compatible with devices and fabrication processes of the semiconductor industry and are surprisingly well suitable for the formation of a stable and homogeneous molecular monolayer.

### Brief description of the drawings.

Fig. 1A shows a schematic illustration of the layer structure of a first embodiment of the electronic switching device.
Fig. 1B shows a schematic illustration of the layer structure of a second embodiment of the electronic switching device according to the invention.
Fig. 2A shows current-voltage curves of an electronic switching device fabricated using a compound of the state of the art.
Fig. 2B shows a current-voltage curve of an electronic switching device according to the invention fabricated using a compound of formula I.

The term "diamondoid" refers to unsubstituted cage compounds of the adamantane series including adamantane, diamantane, triamantane, tetramantanes, pentamantanes, hexamantanes, heptamantanes, octamantanes, and the like, including all stereoisomers thereof.

The compounds have a "diamondoid" topology, which means their carbon atom arrangement is superimposable on a fragment of a face centered cubic diamond lattice.

Diamondoids include "lower diamondoids" and "higher diamondoids," as these terms are defined herein, as well as mixtures of any combination of lower and higher diamondoids. The term "lower diamondoids" refers to adamantane, diamantane and triamantane. These lower diamondoid components show no isomers or chirality and are readily synthesized, distinguishing them from "higher diamondoids." The term "higher diamondoids" refers to unsubstituted tetramantane components; to unsubstituted pentamantane components; to unsubstituted hexamantane components; to unsubstituted heptamantane components; to unsubstituted octamantane components; as well as mixtures of the above and stereoisomers of tetramantane, pentamantane, hexamantane, heptamantane, and octamantane. Adamantane chemistry has been reviewed by Fort, Jr. et al. in "Adamantane: Consequences of the Diamondoid Structure," Chem. Rev. vol. 64, pp. 277-300 (1964). Adamantane is the smallest member of the diamondoid series and may be thought of as a single cage crystalline subunit. Diamantane contains two subunits, triamantane three, tetramantane four, and so on. While there is only one isomeric form of adamantane, diamantane, and triamantane, there are four different isomers of tetramantane, (two of which represent an enantiomeric pair), i.e., four different possible ways or arranging the four adamantane subunits. The number of possible stereoisomers increases non-linearly with each higher member of the diamondoid series, pentamantane, hexamantane, heptamantane, octamantane, etc. Adamantane, which is commercially available, has been studied extensively. The studies have been directed toward a number of areas, such as thermodynamic stability, functionalization, and the properties of adamantane-containing materials. For instance, Schreiber et al., New J. Chem., 2014, 38, 28-41 describes the synthesis and application of functionalized diamondoids to form large area SAMs on silver and gold surfaces. In K. T. Narasimha et al., Nature Nanotechnology 11, March 2016 page 267-273, monolayers of diamondoids
are described to effectively confer enhanced field emission properties to metal surfaces due to a significant reduction of the work function of the metal.

As used herein, an anchor group is a functional group by means of which a compound is adsorbed onto or bonded to the surface of the substrate or electrode by physisorption, chemisorption or by chemical reaction. This chemical reaction includes the transformation of a precursor of an anchor group *in situ,* for example on the surface of a substrate or electrode.

A spacer group in the sense of the present invention is a flexible chain between dipolar moiety and anchor group which causes a separation between these sub-structures and, owing to its flexibility, at the same time improves the mobility of the dipolar moiety after bonding to a substrate.

The spacer group can be branched or straight chain. Chiral spacers are branched and optically active and non-racemic.

Herein, alkyl is straight-chain or branched and has 1 to 15 C atoms, is preferably straight-chain and has, unless indicated otherwise, 1, 2, 3, 4, 5, 6 or 7 C atoms and is accordingly preferably methyl, ethyl, propyl, butyl, pentyl, hexyl or heptyl.

Herein, an alkoxy radical is straight-chain or branched and contains 1 to 15 C atoms. It is preferably straight-chain and has, unless indicated otherwise, 1, 2, 3, 4, 5, 6 or 7 C atoms and is accordingly preferably methoxy, ethoxy, propoxy, butoxy, pentoxy, hexoxy or heptoxy.

Herein, an alkenyl radical is preferably an alkenyl radical having 2 to 15 C atoms, which is straight-chain or branched and contains at least one C-C double bond. It is preferably straight-chain and has 2 to 7 C atoms. Accordingly, it is preferably vinyl, prop-1- or -2-enyl, but-1-, -2- or -3-enyl, pent-1-, -2-, -3- or - 4-enyl, hex-1-, -2-, -3-, -4- or -5-enyl, hept-1-, -2-, -3-, -4-, -5- or -6-enyl. If the two C atoms of the C-C double bond are substituted, the alkenyl radical can be in the form of E and/or Z isomer (trans/cis). In general, the respective E isomers are preferred. Of the alkenyl radicals, prop-2-enyl, but-2- and -3-enyl, and pent-3- and -4-enyl are particularly preferred.

Herein alkynyl is taken to mean an alkynyl radical having 2 to 15 C atoms, which is straight-chain or branched and contains at least one C-C triple bond. 1- and 2-propynyl and 1-, 2- and 3-butynyl are preferred.

In the formulae la-1a, la-1b, la-1c, la-1d, and la-2, preferred aryl groups are derived, for example, from the parent structures benzene, naphthalene, tetrahydronaphthalene, 9,10-dihydrophenanthrene, fluorene, indene and indane.

In the formulae la-1a, la-1b, la-1c, la-1d, and la-2, preferred heteroaryl groups are, for example, five-membered rings, such as, for example, furan, thiophene, selenophene, oxazole, isoxazole, 1,2-thiazole, 1,3-thiazole, 1,2,3-oxadiazole, 1,2,4-oxadiazole, 1,2,5-oxadiazole, 1,3,4-oxadiazole, 1,2,3-thiadiazole, 1,2,4-thiadiazole, 1,2,5-thiadiazole and 1,3,4-thiadiazole, six-membered rings, such as, for example, pyridine, pyridazine, pyrimidine, pyrazine, 1,3,5-triazine, 1,2,4-triazine and 1,2,3-triazine, or condensed rings, such as, for example, indole, isoindole, indolizine, indazole, benzimidazole, benzotriazole, purine, naphthimidazole, benzoxazole, naphthoxazole, benzothiazole, benzofuran, isobenzofuran, dibenzofuran, thieno[2,3b]thiophene, thieno[3,2b]thiophene, dithienothiophene, isobenzothiophene, dibenzothiophene, benzothiadiazo-thiophene, 2H-chromen (2H-1-benzopyran), 4H-chromene (4H-1-benzopyran) and coumarin (2H-chromen-2-one), or combinations of these groups.

In the formulae la-1a, la-1b, la-1c, la-1d, and la-2, preferred cycloaliphatic groups are cyclobutane, cyclopentane, cyclohexane, cyclohexene, cycloheptane, decahydronaphthalene, bicyclo[1.1.1]pentane, bicyclo[2.2.2]octane, spiro[3.3]heptane and octahydro-4,7-methanoindane.

Preferred spacer groups Sp are selected from the formula Sp'-X' in which X' is bonded to a ring A¹, A², A³, A⁴ or B of formulae la-1a, la-1b, la-1c, la-1d, and la-2,in which
- Sp': denotes straight-chain or branched alkylene having 1 to 20, preferably 1 to 12 C atoms, which is optionally mono- or polysubstituted by F, Cl, Br, I or CN and in which, in addition, one or more non-adjacent CH₂ groups may each be replaced, independently of one another, by -O-, -S-, -NH-, -NR⁰-, -SiR⁰⁰R⁰⁰⁰-, -CO-, -COO-, -OCO-, -OCO-O-, -S-CO-, -CO-S-, -NR⁰-CO-O-, -O-CO-NR⁰-, -NR⁰-CO-NR⁰-, -CH=CH- or -C≡C- in such a way that O and/or S atoms are not linked directly to one another,
- X': denotes -O-, -S-, -CO-, -COO-, -OCO-, -O-COO-, -CO-NR⁰⁰-, -NR⁰⁰-CO-, -NR⁰⁰-CO-NR⁰⁰-, -OCH₂-, -CH₂O-, -SCH₂-, -CH₂S-, -CF₂O-, -OCF₂-, -CF₂S-, -SCF₂-, -CF₂CH₂-, -CH₂CF₂-, -CF₂CF₂-, -CH=N-, -N=CH-, -N=N-, -CH=CR⁰⁰-, -CY^{x}=CY^{x'}-, -C≡C-, -CH=CH-COO-, -OCO-CH=CH- or a single bond,
- R⁰, R⁰⁰ and R⁰⁰⁰: each, independently of one another, denote H or alkyl having 1 to 12 C atoms, and
- Y^{x} and Y^{x'}: each, independently of one another, denote H, F, Cl or CN.
- X': is preferably -O-, -S-, -CO-, -COO-, -OCO-, -O-COO-, -CO-NR⁰-,
- -NR⁰-CO-, -NR⁰-CO-NR⁰-: or a single bond.

Preferred groups Sp' are -(CH₂)ₚ₁-, -(CF₂)ₚ₁-, -(CH₂CH₂O)_{q1}-CH₂CH₂-, -(CF₂CF₂O)_{q1}-CF₂CF₂-, -CH₂CH₂-S-CH₂CH₂-, -CH₂CH₂-NH-CH₂CH₂- or -(SiR⁰⁰R⁰⁰⁰-O)ₚ₁₋, in which p1 is an integer from 1 to 12, q1 is an integer from 1 to 3, and R⁰⁰ and R⁰⁰⁰ have the meanings indicated above.

Particularly preferred groups -X'-Sp'- are -(CH₂)ₚ₁-, -O-(CH₂)ₚ₁-, -(CF₂)ₚ₁-, -O(CF₂)ₚ₁-, -OCO-(CH₂)ₚ₁- and -OC(O)O-(CH₂)ₚ₁-, in which p1 has the meaning indicated above.

Particularly preferred groups Sp' are, for example, in each case straight-chain ethylene, propylene, butylene, pentylene, hexylene, heptylene, octylene, nonylene, decylene, undecylene, dodecylene, octadecylene, perfluoroethylene, perfluoropropylene, perfluorobutylene, perfluoropentylene, perfluorohexylene, perfluoroheptylene, perfluorooctylene, perfluorononylene, perfluorodecylene, perfluoroundecylene, perfluorododecylene, perfluorooctadecylene, ethyleneoxyethylene, methyleneoxybutylene, ethylenethioethylene, ethylene-N-methyliminoethylene, 1-methylalkylene, ethenylene, propenylene and butenylene.

Particularly preferred groups X' are -O- or a single bond.

The compounds of the general formulae la-1a, la-1b, la-1c, la-1d, and la-2 can be prepared as illustrated below by methods known per se, as described in the literature (for example in the standard works, such as Houben-Weyl, Methoden der organischen Chemie [Methods of Organic Chemistry], Georg-Thieme-Verlag, Stuttgart), and under reaction conditions which are known and suitable for the said reactions. Use can be made here of variants known per se which are not mentioned here in greater detail.

If desired, the starting materials can also be formed in situ by not isolating them from the reaction mixture, but instead immediately converting them further into the compounds of the general formulae Ia-1a, la-1b, Ia-1c, la-1d, and la-2.

The syntheses of compounds of the general formulae la-1a, la-1b, la-1c, la-1d, and la-2 according to the invention are described in illustrative terms in the examples. The starting substances can be obtained by generally accessible literature procedures or are commercially available.

A process according to the invention for the preparation of a compound of formula Ib via the compound of formula la comprises the steps of
a) reaction of a phosphonochloridate of formula II with an O-(trialkylsilyl)hydroxylamine in the presence of a base, to give N-[(alkoxy)phosphoryl]hydroxylamines of formula la, and
b) ester cleavage of the compound of formula la for example with a trialkylsilylhalide, preferably trimethylsilylbromide or trimethylsilyliodide to give the compounds of the formula Ib;
as shown in scheme 1.

In step a) a preferred trialkylsilylhydroxylamine is O-(trimethylsilyl)hydroxylamine, and the base is preferably an amine, preferably a tertiary amine, very preferably triethylamine, ethyl diisopropylamine, or diazabicyclooctane.

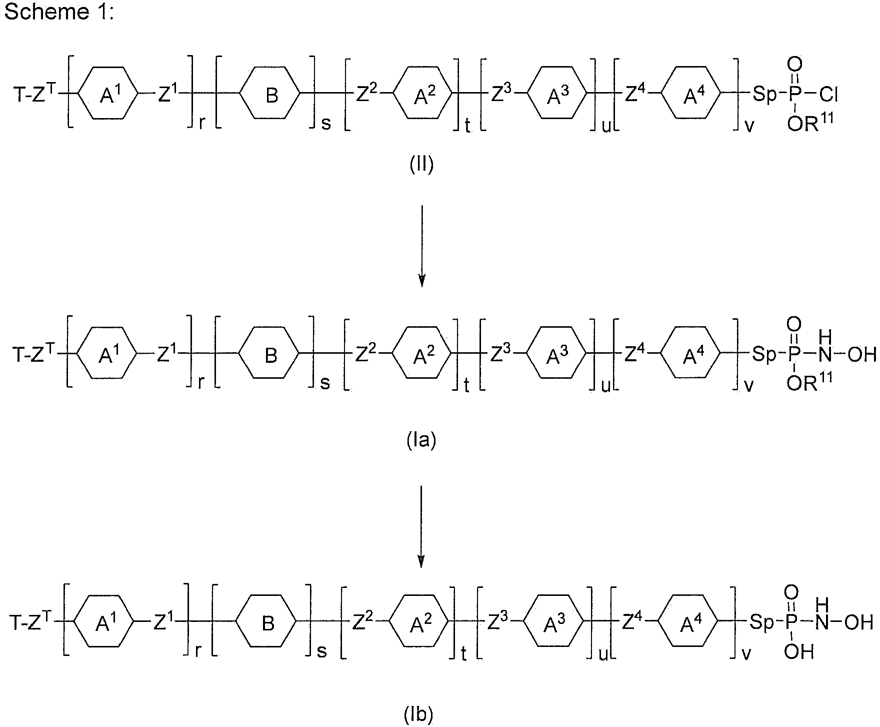

In scheme 1, R¹¹ denotes straight chain alkyl having 1 to 12 C atoms or branched alkyl having 3 to 12 C atoms and the remaining groups and parameters occurring have the meanings defined above for the formulae la-1a, la-1b, la-1c, la-1d, and la-2.

The phosphonochloridates II are obtainable from dialkyl phosphonates III by known processes, e.g., treatment with an acid chloride, for example with oxalyl chloride, thionyl chloride, phosphorous pentachloride, phosphorous oxychloride, dichlorotriphenyl-phosphorane or phosgene, optionally in the presence of a base, for example pyridine, diazabicyclooctane, or triethylamine.(scheme 2). The dialkylphosphonates (III) can be prepared as described in WO 2018/007337 A2, WO 2019/238649 A2, WO 2020/225270 A2,
WO 2020/225398 A2, WO 2021/078699 A2, WO 2021/078714 A2 and WO 2021/083934 A2. 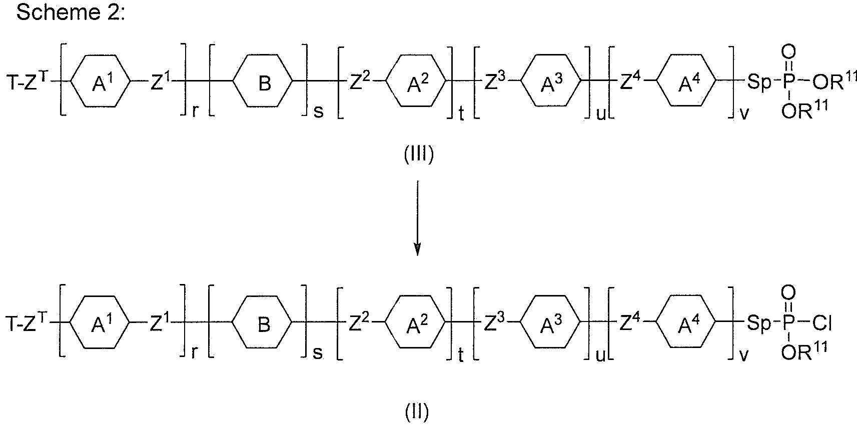 in which R¹¹ denotes straight chain alkyl having 1 to 12 C atoms or branched alkyl having 3 to 12 C atoms, and the remaining groups and parameters have the same meanings as in scheme 1.

Preferably, in the formulae Ia-1a, Ia-1b, Ia-1c, la-1d, and la-2, the radical T denotes 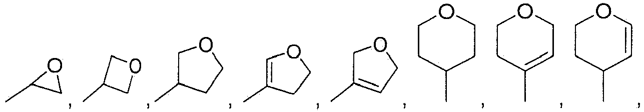 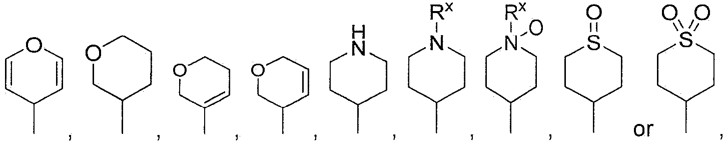 very preferably 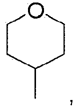 in which R^{x} denotes alkyl having 1 to 6 C atoms, preferably methyl.

In another preferred embodiment, in the formulae la-1a, la-1b, la-1c, la-1d, and la-2, the radical T denotes straight chain or branched alkyl having 1 to 12 C atoms, where one or more CH₂ groups in these radicals may each be replaced, independently of one another, by -C≡C- , -CH=CH-, 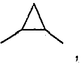 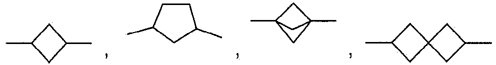 or -O-, in such a way that O atoms are not linked directly to one another, and in which one or more H atoms may be replaced by halogen, preferably by F.

In the compounds of the formulae Ia-1a to Ia-1d, preferably
- T: denotes H, or straight chain or branched alkyl or 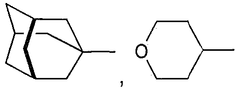 alkoxy each having 1 to 7 C atoms or straight chain or branched alkenyl having 2 to 7 C atoms, preferably straight chain alkyl or alkoxy each having 1 to 7 C atoms,
- Z^{T}: denotes CH₂O, OCH₂, CH₂CH₂, or a single bond, preferably a single bond
- Z¹ and Z²,: identically or differently, denote CH₂O, OCH₂, CH₂CH₂, CF₂O, OCF₂, C(O)O, OC(O) or a single bond, preferably a single bond,
- A¹ and A²,: identically or differently, denote 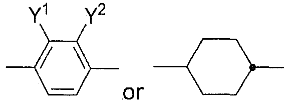
- Y¹ and Y²,: on each occurrence, identically or differently, denote H, F of Cl, preferably H or F, and
- Sp: denotes branched or unbranched 1,ω-alkylene having 1 to 12 C atoms, in which one or more non-adjacent CH₂-groups may be replaced by O, and
- R¹: denotes H.

Very preferred are the compounds of the formulae Ia-1b and 1a-1c, in particular la-1c.

In the compounds of the formula la-2, preferably 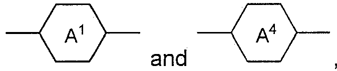 identically or differently, denote 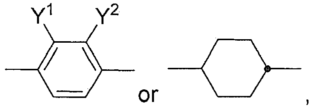 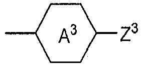 denotes 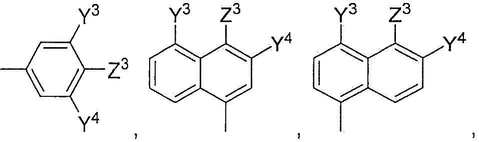 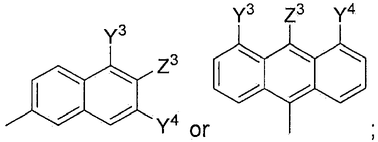
- Z^{T}: denotes a single bond, -CH₂O-, -OCH₂- or -CH₂CH₂-,
- Y¹ and Y²: denote H, F or Cl,
- Y³ and Y⁴,: identically or differently, denote methyl, ethyl, isopropyl, cyclopropyl, cyclobutyl, cyclopentyl, cyclopentenyl, cyclohexyl, cyclohexenyl, methoxy, trifluoromethyl, trifluoromethoxy, or trifluoromethylthio,
- Z³: denotes CH₂ or O,
- Z¹ and Z⁴,: independently of one another, denote a single bond, -C(O)O-, - OC(O)-, -CF₂O-, -OCF₂-, -CH₂O-, OCH₂- or -CH₂CH₂-,
- r and u: independently are 0, 1 or 2, very preferably u is 0 and r is 0 or 1, and
- R¹: denotes H.

In the compounds of the formulae Ia-1a to Ia-1d, and la-2, the group 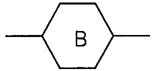 preferably denotes 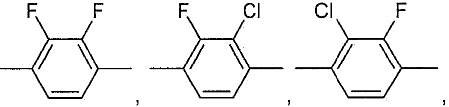 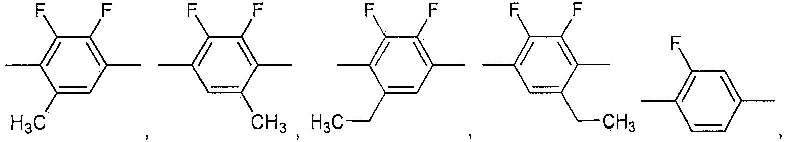 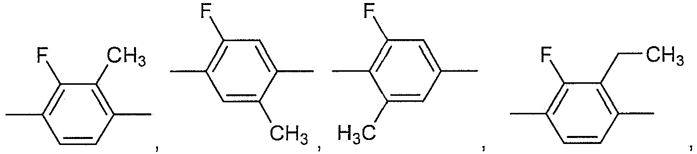 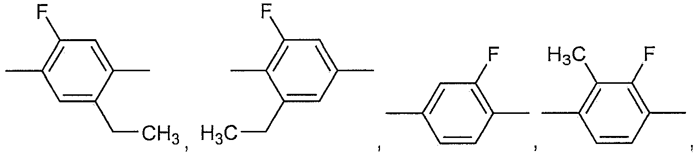 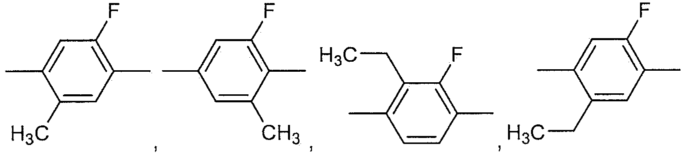 or 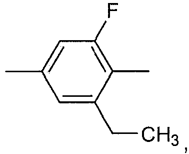 very preferably

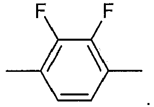

In a preferred embodiment, the compounds of the formulae Ia-1a to Ia-1d, and la-2, are chiral.

The molecular layers obtained from chiral compounds of the formulae la-1a to la-1d, and la-2 enable memristic devices with significantly further reduced stochastic noise and faster switching, reducing the read and write error rate, which has a positive effect on
energy-efficiency. In addition, increased tunnel current are observed allowing for the integration to smaller junction sizes.

Preferably, the chiral compound has an enantiomeric excess (ee) of above 50%, preferably above 80%, 90%, or 95%, more preferably above 97%, in particular above 98%.

Chirality is achieved by a branched chiral group Sp of formulae la-1a, Ia-1b, Ia-1c, Ia-1d, and la-2 above having one or more, preferably one or two, very preferably one, asymmetrically substituted carbon atom (or: asymmetric carbon atom, C*), hereinafter referred to as Sp*. In Sp* the asymmetric carbon atom is preferably linked to two differently substituted carbon atoms, a hydrogen atom and a substituent selected from the group halogen (preferably F, Cl, or Br), alkyl or alkoxy with 1 to 5 carbon atoms in each case, and CN.

The chiral organic radical Sp* preferably has the formula 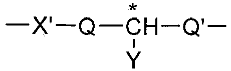 in which
- X': has the meanings defined above and preferably denotes -CO-O-, -O-CO-, -O-CO-O-, -CO-, -O-, -S-, -CH=CH-, -CH=CH-COO- or a single bond, more preferably -CO-O-, -O-CO-, -O- or a single bond, very preferably -O- or a single bond,
- Q and Q': identically or differently, denote a single bond or optionally fluorinated alkylene having 1 to 10 carbon atoms, in which a CH₂ group not linked with X can also be replaced by -O-, -CO-, -O-CO-, -CO-O- or -CH=CH-, preferably alkylene having 1 to 10 carbon atoms or a single bond, particularly preferably -(CH₂)ₙ₅- or a single bond,
- n5: is 1, 2, 3, 4, 5, or 6,
- Y: denotes optionally fluorinated alkyl having 1 to 15 carbon atoms, in which one or two non-adjacent CH₂ groups can also be replaced by -O-, -CO-, -O-CO-, -CO-O- and/or -CH=CH-, further CN or halogen, preferably optionally fluorinated alkyl or alkoxy having 1 to 7 C atoms, -CN or Cl, particularly preferably -CH₃, -C₂H₅, -CF₃ or Cl,

In addition, chirality is achieved by a chiral group T of formulae Ia-1a to Ia-1d, and la-2, above having one or more, preferably one or two, very preferably one asymmetrically substituted carbon atom (or: asymmetric carbon atom, C*), hereinafter referred to as R*.

In R* the asymmetric carbon atom is preferably linked to two differently substituted carbon atoms, a hydrogen atom and a substituent selected from the group halogen (preferably F, Cl, or Br), alkyl or alkoxy with 1 to 5 carbon atoms in each case, and CN.

The chiral organic radical preferably has the formula 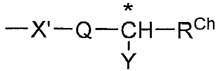 in which
- X': has the meanings defined above for formula la-1a and preferably denotes -CO-O-, -O-CO-, -O-CO-O-, -CO-, -O-, -S-, -CH=CH-, -CH=CH-COO- or a single bond, more preferably -CO-O-, -O-CO-, -O-, or a single bond, very preferably -O- or a single bond,
- Q: denotes a single bond or optionally fluorinated alkylene having 1 to 10 carbon atoms, in which a CH₂ group not linked with X can also be replaced by -O-, -CO-, -O-CO-, -CO-O- or -CH=CH-, preferably alkylene having 1 to 5 carbon atoms or a single bond, particularly preferably -CH₂-, -CH₂CH₂- or a single bond,
- Y: denotes optionally fluorinated alkyl having 1 to 15 carbon atoms, in which one or two non-adjacent CH₂ groups can also be replaced by -O-, -CO-, -O-CO-, -CO-O- and/or -CH=CH-, further CN or halogen, preferably optionally fluorinated alkyl or alkoxy having 1 to 7 C atoms, -CN or Cl, particularly preferably -CH₃, -C₂H₅, -CF₃ or Cl,
- R^{Ch}: denotes an alkyl group having 1 to 15 carbon atoms that is different from Y, in which one or two non-adjacent CH₂ groups can also be replaced by -O-, -CO-, -O-CO-, -CO-O- and/or -CH=CH-, preferably denotes straight-chain alkyl having 1 to 10, in particular 1 to 7, carbon atoms, in which the CH₂ group linked to the asymmetric carbon atom can be replaced by -O-, -O-CO- or -CO-O-.

In the memory cell according to the invention, preferably, the first electrodes and/or second electrodes are made from a metal, a conductive alloy, a conductive ceramic, a semiconductor, a conductive oxidic material, conductive or semi conductive organic molecules or a layered conductive 2D material. The first and/or second electrode may comprise combinations of more than one of said materials, for example in form of a multi-layer system. The material of the first and the second electrode may be chosen identically or differently.

Suitable metals include Ag, Al, Au, Co, Cr, Cu, Mo, Nb, Ni, Pt, Ru, W, Pd, Pt, wherein Al, Cr and Ti are preferred.

Suitable conductive ceramic materials include CrN, HfN, MoN, NbN, TiO₂, RuO₂, VO₂, NSTO (niobium-doped strontium titanate), TaN and TiN, WN, WCN, VN and ZrN, wherein TiN is preferred.

Suitable semiconductor materials include indium tin oxide (ITO), indium gallium oxide (IGO), InGa-α-ZnO (IGZO), aluminium-doped zinc oxide (AZO), tin-doped zinc oxide (TZO), fluorine-doped tin oxide (FTO) and antimony tin oxide.

Suitable element semiconductors include Si, Ge, C (diamond, graphite, graphene, fullerene), α-Sn, B, Se and Te. Suitable compound semiconductors include group III-V semiconductors, in particular GaAs, GaP, InP, InSb, InAs, GaSb, GaN, TaN, TiN, MoN, WN, AIN, InN, Alₓ Ga₁₋ₓAs and InₓGa₁₋ₓ Ni, group II-VI semiconductors, in particular ZnO, ZnS, ZnSe, ZnTe, CdS, CdSe, CdTe, Hg₍₁₋ₓ₎Cd₍ₓ₎ Te, BeSe, BeTeₓ and HgS; and group III-VI semiconductors, in particular GaS, GaSe, GaTe, InS, InSeₓ and InTe, group I-III-VI semiconductors, in particular CulnSe2, CulnGaSe2, CulnS2 and CulnGaS2, group IV-IV semiconductors, in particular SiC and SiGe, group IV-VI semiconductors, in particular SeTe.

Suitable highly doped semiconductor materials include p+Si, n+Si.

An example of a suitable layered conductive 2D material is graphene.

Suitable semiconductive organic molecules include polythiophene, tetracene, pentacene, phthalocyanines, PTCDA, MePTCDI, quinacridone, acridone, indanthrone, flavanthrone, perinone, AIQ3 , and mixed systems, in particular PEDOT:PSS and polyvinylcarbazole/TLNQ complexes.

In a preferred embodiment, the first and second electrodes, identically or differently, comprise a material selected from the group consisting of Ag, Al, Au, Co, Cr, Cu, Mo, Nb, Ni, Pt, Ru, Si, W, CrN, HfN, MoN, NbN, TiN, TaN, Ta₃N₅, TaNx, TaON, WN, WCN, VN, ZrN, Ta₂O₅, SiO₂, ZrO₂, HfO₂, WO₃, RuO₂, Cu₂O, TiO₂, Co₂O₃, and niobium-doped strontium titanate.

More preferably, the first and second electrodes, identically or differently, comprise, preferably consist of a metal nitride selected from CrN, HfN, MoN, NbN, TiN, TaN, WN, tungsten carbide nitride (WCN), VN and ZrN.

In particular, the first electrode consist of a metal nitride selected from CrN, HfN, MoN, NbN, TiN, TaN, WN, WCN, VN and ZrN, and the second electrode consists of TiN.

Very particularly, the first and the second electrode both consist of TiN.

In another preferred embodiment, the first electrode on which the SAM is formed from the compounds of the formulae la-1a, la-1b, Ia-1c, Ia-1d, and/or la-2 comprises a material selected from the group consisting of TiN, Ta₃N₅, TaNₓ, TaON, Ta₂O₅, SiO₂, ZrO₂HfO₂, WO₃, RuO₂, Cu₂O, TiO₂, Co₂O₃, Si, Co, Ni, W, Ru, Cu, and Pt and the second electrode comprises a material selected from the group consisting of Ag, Al, Au, Co, Cr, Cu, Mo, Nb, Ni, Pt, Ru, Si, W, CrN, HfN, MoN, NbN, TiN, TaN, WN, WCN, VN and ZrN.

In the following description of the illustrative embodiments of the invention, identical or similar components and elements are denoted by identical or similar reference numbers, where repeated description of these components or elements is avoided in individual cases. The figures only depict the subject-matter of the invention schematically.

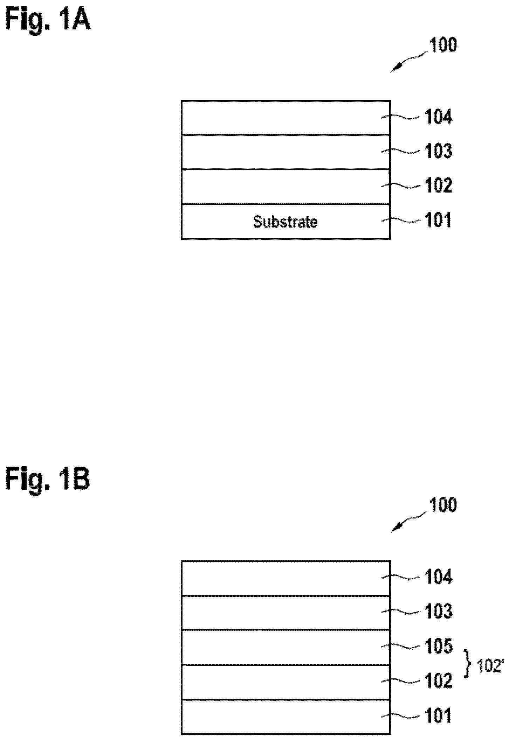

FIG. 1A illustrates a nanoscale non-volatile solid state resistive device 100 having a molecular switching layer 103 according to an embodiment of the present invention. Device 100 is a two-terminal memory in the present embodiment. Device 100 includes a first electrode 102, a molecular switching layer 103, and a second electrode 104. Device 100 is a resistive memory device in the present embodiment but may be other types of device in other embodiments. The molecular switching layer can be selectively set to various resistance values by applying a voltage to the electrodes and reset, using appropriate control circuitry. The resistance of the device 100 changes according to the orientation of the molecular dipoles of the molecular switching layer 103. Device 100 is formed over an outer semiconductor substrate 101. The semiconductor substrate may be a silicon substrate, or a compound substrate of a III-V or II-VI type. In an embodiment, the substrate is not made of semiconductor material, e.g., made of plastic.

Particularly suitable substrates are selected from:
- element semiconductors, such as Si, Ge, C (diamond, graphite, graphene, fullerene), α-Sn, B, Se and Te;
- compound semiconductors, preferably
   - group III-V semiconductors, in particular GaAs, GaP, InP, InSb, InAs, GaSb, GaN, TaN, TiN, MoN, WN, AIN, InN, AlₓGa₁₋ₓAs and InₓGa₁₋ₓNi,
   - group II-VI semiconductors, in particular ZnO, ZnS, ZnSe, ZnTe, CdS, CdSe, CdTe, Hg₍₁₋ₓ₎Cd₍ₓ₎Te, BeSe, BeTeₓ and HgS;
   - group III-VI semiconductors, in particular GaS, GaSe, GaTe, InS, InSeₓ and InTe,
   - group I-III-VI semiconductors, in particular CuInSe₂, CuInGaSe₂, CuInS₂ and CuInGaS₂,
   - group IV-IV semiconductors, in particular SiC and SiGe,
   - group IV-VI semiconductors, in particular SeTe;
- organic semiconductors, in particular polythiophene, tetracene, pentacene, phthalocyanines, PTCDA, MePTCDI, quinacridone, acridone, indanthrone, flavanthrone, perinone, AlQ₃, and mixed systems, in particular PEDOT:PSS and polyvinylcarbazole/TLNQ complexes;
- metals, in particular Ta, Ti, Co, Mo, Pt, Ru, Au, Ag, Cu, Al, W and Mg;
- conductive oxidic materials, in particular indium tin oxide (ITO), indium gallium oxide (IGO), InGa-α-ZnO (IGZO), aluminium-doped zinc oxide (AZO), tin-doped zinc oxide (TZO), fluorine-doped tin oxide (FTO) and antimony tin oxide.

Preference is given to the use of crystalline silicon as substrate 101, where silicon wafers having a (100) surface are particularly preferred. Silicon wafers whose surface is oriented at (100) are employed as conventional substrate in microelectronics and are available in high quality and with a low proportion of surface defects.

In the switching devices according to the invention, the molecules of formulae la-1a to la-1d, and la-2 forming the molecular layer 103 are bonded to the first electrode 102 by means of the hydroxyaminophosphinic acid anchor group as defined above in the formulae la-1a to la-1d, and la-2.

The molecular layer may optionally be bonded to a relatively thin (preferably 0.5 - 5 nm thick) oxidic interlayer 105, for example TiO₂, Al₂O₃, ZrO₂, HfO₂, or SiO₂, which is located on the first electrode 102, thus in this embodiment, the first electrode comprises a first layer comprising the material defined in claim 1 and a second oxidic layer to which the molecular layer 103 is bonded (Fig. 1B). Hence, first electrode 102 and interlayer 105 are operable as an alternative first electrode 102'.

The molecular layer of the present invention is a layer of electrically insulating, non-conducting and non-semiconducting organic compounds.

The molecular layer is essentially formed from precursors of the formulae la-1a to la-1d, and/or la-2. Preferably, the precursors used for the formation of the molecular layer consist of compounds of the formulae Ia-1a to Ia-1d, and/or la-2.

The thickness of the molecular layer is preferably 10 nm or less, particularly preferably 5 nm or less, very particularly preferably 3 nm or less.

The molecular layer may consist of one, two, three or more molecule layers comprising compounds of the formulae la-1a to la-1d, and/or la-2.

The molecular layer employed in accordance with the invention is preferably a molecular monolayer.

In an embodiment, the molecular layer is a self-assembled monolayer (SAM).

The production of self-assembled monolayers is known to the person skilled in the art; a review is given, for example, in A. Ulman, Chem. Rev. 1996, 96, 1533-1554.

The degree of coverage of the substrate is preferably 90% to 100%, particularly preferably 95% to 100%, very particularly preferably 98% to 100%.

Preferably, the second electrode 104 consists of TiN.

In an embodiment, first electrodes 102, which in the embodiment of Figure 1A are implemented in the form of conductor tracks which run perpendicular to the drawing plane, are arranged on the substrate 101.

A second electrode 104, which, like the first electrode 102, is in the form of a conductor track, is arranged on the side of the molecular layer 103 facing away from the substrate 101. However, the second electrode 104 is rotated by 90° relative to the first electrode 102, so that a cross-shaped arrangement arises. This arrangement is also called a crossbar array, where the 90° angle is selected here as an example and arrangements in which second electrodes 104 and first electrodes 102 cross at an angle deviating from the right angle are also conceivable. A switching device 100, which is formed from a layer system having, in this sequence, a second electrode 104, a molecular layer 103 and a first electrode 102, is arranged at each crossing point between a second electrode 104 and a first electrode 102. In an embodiment a diode is also assigned to each switching device 100.

The crossbar array enables each switching device 100 to be addressed electrically by applying a voltage between the corresponding first electrode 102 and second electrode 104.

The production and structuring of the electrodes is carried out by means of processes known to the person skilled in the art and is explained in greater detail below with reference to the working examples.

The structures of the electrodes 102,104 can be produced by means of structuring methods known to the person skilled in the art from microelectronics. For example, a lithography method can be employed for the production of the first electrodes 102. In this, a metal layer is applied to the substrate 101 by means of vapour deposition. The metal layer is subsequently coated with a photoresist, which is exposed with the structures to be produced. After development and, where necessary, baking of the resist, the parts of the metal layer that are not required are removed, for example, by wet-chemical etching. The remaining resist is subsequently removed, for example using a solvent.

A further possibility for the production of the electrodes 102, 104 is vapour deposition with the aid of a shadow mask. In this method, a mask whose openings correspond to the shape of the electrodes 102,104 to be produced is placed on the component and a metal is subsequently applied by vapour deposition. The metal vapour is only able to precipitate and form the electrode 102, 104 on the component in the areas not covered by the mask.

Suitable and preferred processes for the fabrication of the switching device according to the invention are published in EP 3 813 132 A1, paragraph [0113] to [0126]. The compounds according to the invention can be used as described therein.

A substrate 101 whereon a plurality of devices 100 is to be defined is provided. The substrate is silicon (p doped, resistivity <0.001 Ω cm⁻¹, prime grade) in the present embodiment. In a preferred embodiment, the silicon substrate comprises a SiO₂ layer which serves as an isolating layer and improves derivatization. In other embodiments, other semiconductor materials such as III-V and II-VI type semiconductor compounds may be used as the substrate. Device 100 may be formed as part of a front-end process or a back-end process depending on implementation. Accordingly, substrate 101 may include one or more layers of material formed and patterned thereon when the substrate is provided for the present process.

A first electrode is formed over substrate 101 using any deposition process, such as, for example, chemical vapor deposition (CVD), plasma enhanced CVD (PECVD), radio-frequency CVD (RFCVD), physical vapor deposition (PVD), atomic layer deposition (ALD), molecular beam deposition (MBD), pulsed laser deposition (PLD), and/or liquid source misted chemical deposition (LSMCD), and/or sputtering, or another deposition or growth process to form at least a top portion of the first electrode. The bottom electrode preferably should comprise a material having a high voltage threshold for ion migration, and it can be blanket or structured by photolithography or other advanced lithography processes known to a person skilled in the art, e.g. nano-imprint lithography or dip-pen lithography.

Optionally, the first electrode is treated with oxygen, argon or nitrogen plasma or UV/ozone in order to obtain a hydrophilic oxidic surface which is populated with hydroxyl groups. It is clear that an oxidic surface of this type merely serves for surface modification with the aim of possible derivatisation via condensation reactions and does not represent an insulator layer or interlayer in the true sense. Sufficiently large tunnel currents through this oxidic surface are possible owing to the low thickness in the order of 1 nm.

A molecular layer 103 is formed over the first electrode 102.

The deposition of the molecular layer onto the first electrode is carried out with the pure substance or from solution, preferably from solution. Suitable deposition methods and solvents are known to the person skilled in the art; examples are spin coating or dip coating.

The molecules of the molecular layer are preferably bonded to the first electrode by chemisorption or covalently, more preferably covalently. The bonding is carried out by known methods which are familiar to the person skilled in the art, for example by condensation with hydroxyl groups located on the surface of the substrate.

In an alternative embodiment, the molecular layer 103 can also be linked to a first electrode not directly but via a thin oxidic adhesion layer 105 derived from a metal different from that of the first electrode (e.g. Al₂O₃, ZrO₂) and which is deposited onto the first electrode using the deposition techniques mentioned above for the first electrode, preferably CVD.

Preferred is grafting of a molecular layer directly onto a titanium nitride first electrode 102 by means of molecules of the formulae Ia-1a, la-1b, Ia-1c, la-1d, and/or la-2 in which the anchor group is a group -P(O)(OH)(NHOH).

In a preferred embodiment, the device is annealed after deposition of the monolayer. The annealing is carried out at a temperature of greater than 20°C and less than 300°C, preferably at greater than 50°C and less than 200°C, particularly preferably at greater than 90°C and less than 150°C. The time duration of the annealing is 1 to 48 h, preferably 4 to 24 h, particularly preferably 8 to 16 h.

The first electrode 102 is patterned to obtain an electrode extending along a direction (e.g., horizontal direction). A plurality of first electrodes extending along the first direction in parallel is formed at this step.

Patterned second electrodes are formed on the molecular layer 103 by a lift-off process using a known processing sequence including a lift-off photoresist, patterning step, electrode deposition, and lift off, or using a photoresist.

The second electrode 104 can be deposited, e.g., by sputtering or atomic layer deposition, preferably by sputtering.

According to another aspect of the present invention, a plurality of cells is arranged in a three dimensional array of cells. Accordingly, the array extends in two directions of a plane, which may be defined by a substrate onto which the electronic element is formed and may also extend in a vertical direction perpendicular to this plane. A number of cells arranged in the each of the two directions or dimensions of the plane may be very high, ranging from at least two to several thousands, millions or even billions of cells. For example, in a configuration of 1024 cells in an x-direction and 1024 cells in a y-direction, a single two dimensional layer of cells comprises 1048576 cells. Such a two-dimensional arrangement of cells, wherein each of the cells is located at a crossing of two orthogonal electrode lines is known as crossbar array.

The number of levels or layers of cells arranged in the vertical direction or dimension is typically lower and ranges from 2 to at least 64, preferably up to at least 1024 or even higher. Preferably, the array comprises at least 16 levels of cells, more preferably at least 32 levels of cells and most preferred at least 64 levels of cells. Such a three-dimensional arrangement of cells is known as a 3D crossbar array or 3D cross point device.

### Examples

The present invention is illustrated in detail by the following non-restrictive working examples.

Synthesis Example 1: P-(4-(2,3-difluoro-4-(4-pentylcyclohexyl)phenoxy)butyl)-N-hydroxyphosphonamidic acid

### Step 1: 1-(4-Bromobutoxy)-2,3-difluoro-4-(4-pentylcyclohexyl)benzene

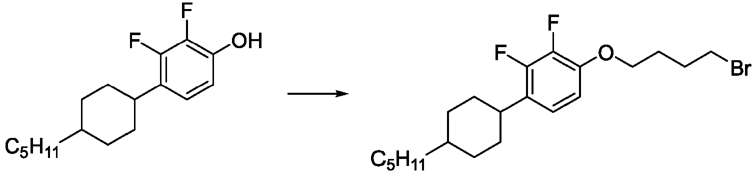

To a solution of 2,3-difluoro-4-(4-pentylcyclohexyl)phenol (5 g, 17 mmol) in 60 ml of dry DMF potassium carbonate (3.6 g, 26 mmol) is added and the resultant mixture is stirred at room temperature for 1 hour. Then 1,4-dibromobutane (7.3 g, 4.0 ml, 34 mmol) is added, followed by the addition of potassium iodide (0.2 g, 1 mmol). After 18 h of stirring at room temperature, the mixture is filtered off and the filtrate is concentrated *in vacuo.* The residue is taken up with diethyl ether (100 ml), washed with brine (3 x 50 ml), dried over sodium sulfate and concentrated under reduced pressure to give white solid which is suspended in cold n-pentane, filtered off and washed three times with cold pentane to give 1-(4-bromobutoxy)-2,3-difluoro-4-(4-pentylcyclohexyl)benzene as white solid, m.p. 47 - 48 °C.

¹H NMR (400 MHz, CDCl₃): δ 6.83 (dd, *J* = 9.2, 2.3 Hz, 1H), 6.68 (dd, *J* = 7.33, 1.9 Hz, 1H), 4.04 (t, *J* = 5.7 Hz, 2H), 3.49 (t, *J* = 6.1 Hz, 2H), 2.82 (tt, *J* = 12.1, 2.9 Hz, 1H), 2.31 (q, *J =* 5.9 Hz, 2H), 1.88 - 1.78 (m, 6H), 1.46 - 1.36 (m, 2H), 1.35 - 1.17 (m, 2H), 1.09 - 0.99 (m, 9H), 0.86 (t, ³*J*_{HH} = 7.3 Hz, 3H) ¹³C NMR (101 MHz, CDCl₃): δ 149.0 (dd, *J* = 245.1, 10.2 Hz), 145.6 (dd, *J* = 8.2, 2.9 Hz), 141.0 (dd, *J* = 246.9, 15.3 Hz), 128.2 (dd, *J* = 12.5, 1.3 Hz), 120.3 (dd, *J* = 5.7, 4.6 Hz), 109.2 (d, *J* = 3.3 Hz), 67.1 (s), 40.1 (s), 36.7 (s), 33.3 (s), 33.1 (s), 32.4 (s), 31.7 (s), 31.5 (s), 27.7 (s), 23.4 (s), 14.1 (s).

### Step 2: Diethyl (4-(2,3-difluoro-4-(4-pentylcyclohexyl)phenoxy)butyl)phosphonate

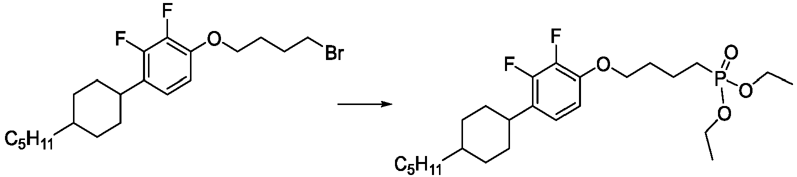

To a solution of diethyl phosphite (0.69 g, 0.64 ml, 5 mmol) in 80 ml of dry THF cooled to 0 °C sodium hydride (0.24 g, 6 mmol, 60 % dispersion in oil) is added portionwise. It is stirred 30 min at 0 °C and then a solution of 1-(4-bromobutoxy)-2,3-difluoro-4-(4-pentylcyclohexyl)benzene (2 g, 5 mmol) in 5 ml of anhydrous THF is added. The resultant mixture is then stirred at 66 °C for 4 h. The reaction is quenched with 1M solution of HCl (100 ml), organic phase is separated and water phase is extracted with diethyl ether (3 x 30 ml). Organic phase is then dried over Na₂SO₄, filtered off and the solvent is evaporated to give an oily residue which is purified by column chromatography eluting with ethyl acetate to give diethyl (4-(2,3-difluoro-4-(4-pentylcyclohexyl)phenoxy)butyl)phosphonate as a yellowish oil.

¹H NMR (401 MHz, CDCl₃): δ 6.81 (t, *J* = 8.2 Hz, 1H), 6.63 (t, *J* = 8.1 Hz, 1H), 4.15 - 4.02 (m, 4H), 4.01 (dd, *J* = 11.7, 5.9 Hz, 2H), 2.70 (tt, *J* = 12.1, 1.1 Hz, 1H), 1.85 (dt, *J* = 21.4, 11.1 Hz, 9H), 1.50 - 1.11 (m, 16H), 1.05 (dd, *J* = 17.1, 6.4 Hz, 2H), 0.87 (t, *J* = 6.7 Hz, 3H); ¹⁹F NMR (377 MHz, CDCl₃): δ -143.15 (dd, *J* = 19.6, 7.4 Hz, 1F), -159.47 (ddd, *J* = 19.6, 7.6, 2.1 Hz, 1F); ³¹P NMR (162 MHz, CDCl₃): δ 32.42 (s, 1P).

### Step 3: Ethyl (4-(2,3-difluoro-4-(4-pentylcyclohexyl)phenoxy)butyl)phosphonochloridate

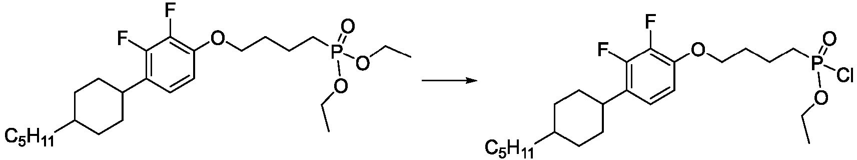

Oxalyl chloride (200 mg, 1.6 mmol) is added dropwise to a stirred solution of diethyl (4-(2,3-difluoro-4-(4-pentylcyclohexyl)phenoxy)butyl)phosphonate (780 mg, 1.6 mmol) dissolved in 5 ml of dry dichloromethane at room temperature. When addition is complete, the mixture is stirred for another 4 h under reflux. Afterwards all volatiles are removed *in vacuo* to give ethyl (4-(2,3-difluoro-4-(4-pentylcyclohexyl)phenoxy)butyl)-phosphonochloridate as a yellow oil. ¹H NMR (401 MHz, CDCl₃): δ 6.83 (td, *J* = 8.3, 2.6 Hz, 1H), 6.64 (td, *J* = 7.7, 1.9 Hz, 1H), 4.37 - 4.27 (m, 1H), 4.27 - 4.18 (m, 1H), 4.03 (t, *J* = 5.4 Hz, 2H), 2.80 - 2.66 (m, 1H), 2.23 (dt, *J* = 15.1, 6.5 Hz, 2H), 2.00 - 1.88 (m, 3H), 1.49 - 1.39 (m, 4H), 1.41 - 1.37 (m, 6H), 1.35 - 1.17 (m, 9H), 1.12 - 0.98 (m, 2H), 0.88 (t, *J* = 6.6 Hz, 3H); ¹⁹F NMR (377 MHz, CDCl₃): δ -143.15 (dd, *J* = 19.6, 7.4 Hz, 1F), -159.47 (dd, *J* = 19.6, 7.6, 1F); ³¹P NMR (162 MHz, CDCl₃): δ 44.62 (s, 1P)

### Step 4: Ethyl P-(4-(2,3-difluoro-4-(4-pentylcyclohexyl)phenoxy)butyl)-N-hydroxyphosphonamidate

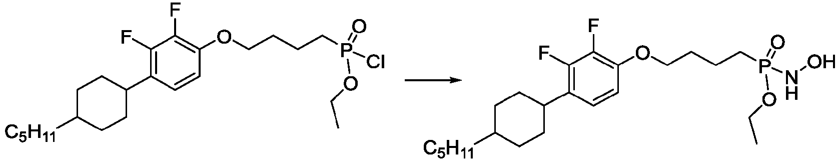

A solution of ethyl (4-(2,3-difluoro-4-(4-pentylcyclohexyl)phenoxy)butyl)-phosphonochloridate (760 mg, 1.6 mmol) in 1 ml of dry dichloromethane is added at 0 °C to a stirred mixture of O-trimethylsilylhydroxylamine (180 mg, 1.8 mmol) and triethylamine (159 mg, 0.22 ml, 1.8 mmol) in dry dichloromethane (20 ml). After further 5 h at room temperature, volatile matter is evaporated, ether (10 ml) is added and the solid (Et₃NHCl) is filtered off. The filtrate is treated with methanol (3 ml) for 10 min to effect desilylation and is then evaporated to dryness to give an oily residue which is purified by column chromatography eluting with ethyl acetate to give the ethyl *P*-(4-(2,3-difluoro-4-(4-pentylcyclohexyl)phenoxy)butyl)*-N*-hydroxyphosphonamidate.

1H NMR (401 MHz, CDCl3): δ 6.82 (t, J = 8.2 Hz, 1H), 6.62 (t, J = 8.2 Hz, 1H), 4.16 - 4.10 (m, 4H), 3.90 (t, J = 5.9 Hz, 2H), 2.71 (t, J = 12.3 Hz, 1H), 1.76 - 1.96 (m, 4H), 1.48 - 1.32 (m, 9H), 1.26 (ddd, J = 22.9, 13.6, 6.0 Hz, 4H), 1.04 (q, J = 11.8 Hz, 2H), 0.88 (t, J = 6.8 Hz, 3H); 19F NMR (377 MHz, CDCl3): δ -143.06 (d, J = 19.6 Hz, 1F), -159.37 (d, J = 20.2 Hz, 1F); 31P NMR (162 MHz, CDCl3): δ 26.91 (s, 1P)

### Step 5: P-(4-(2,3-difluoro-4-(4-pentylcyclohexyl)phenoxy)butyl)-N-hydroxy-phosphonamidic acid

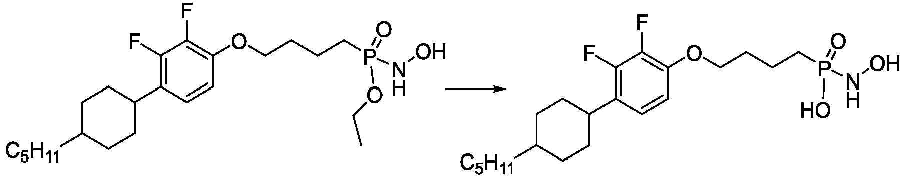

Bromotrimethylsilane (3.5 g, 3 ml, 22 mmol) is added to neat ethyl *P*-(4-(2,3-difluoro-4-(4-pentylcyclohexyl)phenoxy)butyl)-*N*-hydroxyphosphonamidate (0.33 g, 0.77 mmol)) under argon. The resulting solution is stirred at room temperature for 24 h. Volatile materials are removed in vacuo and the residue is treated with methanol (2 ml). After stirring for 12 h at room temperature the solvent is evaporated under reduced pressure to give P-(4-(2,3-difluoro-4-(4-pentylcyclohexyl)phenoxy)butyl)-N-hydroxyphosphonamidic acid as a solid. 1H NMR (401 MHz, DMSO-d6): δ 10.36 (s, 3H), 6.81 (t, J = 8.2 Hz, 1H), 6.63 (t, J = 8.2 Hz, 1H), 3.99 (t, J = 5.9 Hz, 2H), 2.71 (t, J = 12.3 Hz, 1H), 1.76 - 1.96 (m, 4H), 1.48 - 1.32 (m, 9H), 1.26 (ddd, J = 22.9, 13.6, 6.0 Hz, 4H), 1.04 (q, J = 11.8 Hz, 2H), 0.88 (t, J = 6.8 Hz, 3H); 19F NMR (377 MHz, DMSO-d6): δ -143.06 (d, J = 19.6 Hz, 1F), -159.37 (d, J = 20.2 Hz, 1F); 31P NMR (162 MHz, DMSO-d6): δ 26.91 (s, 1P); 13C NMR (101 MHz, DMSO-d6): δ 149.4 (dd, J = 245.1, 10.2 Hz), 146.0 (dd, J = 8.2, 2.9 Hz), 141.5 (dd, J = 246.9, 15.3 Hz), 128.7 (dd, J = 12.5, 1.3 Hz), 121.5 (dd, J = 5.7 Hz, 4.6 Hz), 110.3 (d, J = 2.0 Hz), 69.29 (s), 33.48 (s), 32.99 (s), 30.12 (s), 29.86 (s), 28.51 (d, J = 135.8 Hz), 27.10 (s), 26.51 (s), 22.60 (s), 19.99 (s), 19.95 (s), 14.49 (s).

### Application Tests

### Comparative Characterization of SAMs

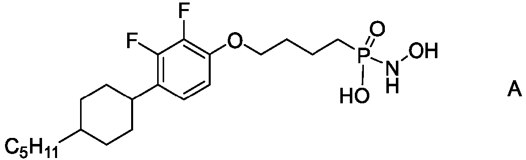

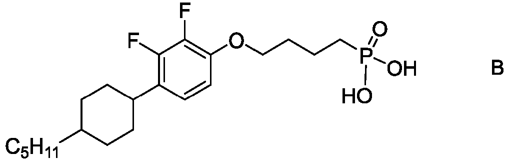

### Preparation of Test Chips:

Test chips are prepared by the following steps in this order using the acids compound A (Synthesis Example 1) and for comparison with compound B from the state of the art:
1. Preparation of *N*-hydroxylamidophosphonic acid **A** and phosphonic acid **B** (as reference) solution in THF (c = 1 mmol/l)
2. UV ozone treatment 15 min of test chips: 1) 8x8 mm p⁺⁺Si (525 µm)/Al₂O₃ (2-3 nm, deposited by ALD), and 2) 8x8 mm p⁺⁺Si (525 µm)/Ti (10 nm, sputtered)/TiN (30 nm, sputtered)
3. Immersion of chip 1 or 2 into *N-*hydroxylamidophosphonic or phosphonic acid solution for 72h to give chips 1A, 1B, 2A and 2B
4. Drying in a stream of N₂ gas
5. Bake (T = 120°C) in N₂ atmosphere for 1 h
6. Cleaning by short rinsing with THF
7. Drying in a stream of N₂ gas

### Water contact angle (WCA) measurement:

| Test chip | Compound | WCA |
|---|---|---|
| 1A | A | 105.3° |
| 1B | B | 104.7° |
| 2A | A | 115.0° |
| 2B | B | 115.8° |

The WCAs for **A** are at approx. on the same level as the reference compounds **B** on Al₂O₃ (1) as well as on TiN (2) substrates.

Comparative current-voltage (IV) characteristics are recorded using a standard setup as described for example in EP 3 481916 A1.

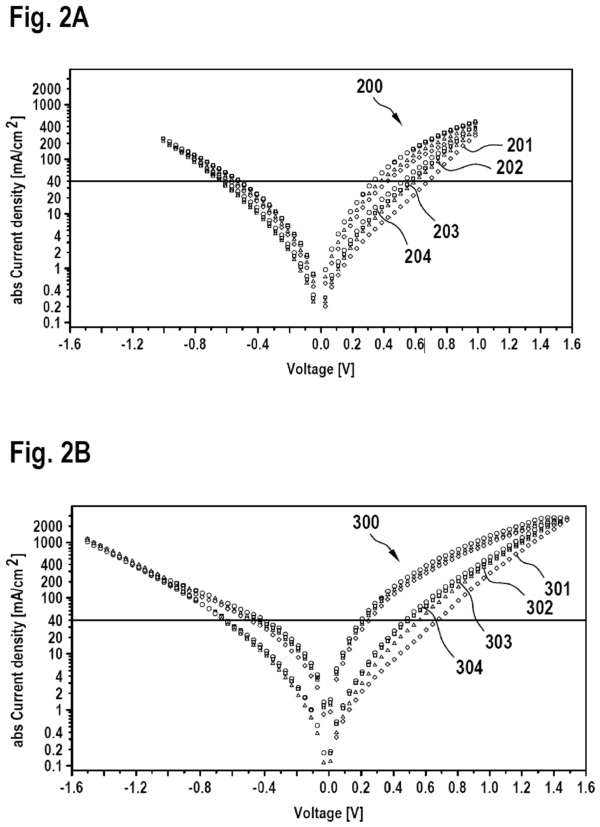

Fig. 2A shows the IV characteristics (200, absolute current density vs. voltage) of reference compound B on a TiN substrate (8x8 mm p++Si (525 µm)/Ti (10 nm, sputtered)/TiN (30 nm, sputtered); contacted by a Hg droplet with ca. 160 mm diameter. Fig. 2B shows the IV characteristics (300, absolute current density vs. voltage) of compound A according to the invention on a TiN substrate (8x8 mm p++Si (525 µm)/Ti (10 nm, sputtered)/TiN (30 nm, sputtered); contacted by a Hg droplet with ca. 160 mm diameter. The upper curves 200 show the result of four sweeps 201, 202, 203 and 204. The lower curves 300 show the result of four sweeps 301, 302, 303 and 304. The result indicates that N-hydroxyphosphonamide compound A is more stable against dielectric breakdown than the phosphonic acid compound B (1.5 V and 1.0 V, respectively). The IV curves 300 show a pronounced hysteretic behaviour with a high-resistive state (HRS) to low resistive state (LRS) ratio of about one order of magnitude.

In analogy to Synthesis Example 1 the following compounds are obtained:

| | |
|---|---|
| 2 | 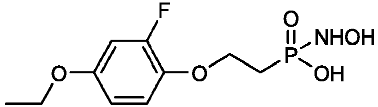 |
| 3 | 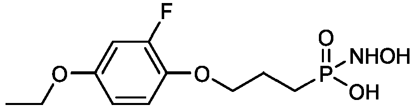 |
| 4 | 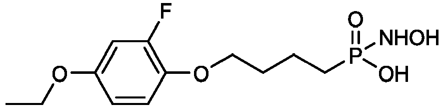 |
| 5 | 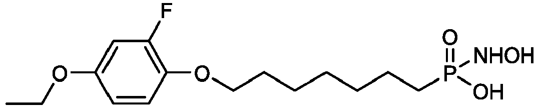 |
| 6 | 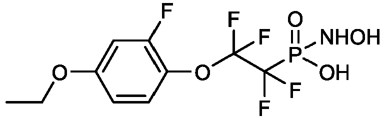 |
| 7 | 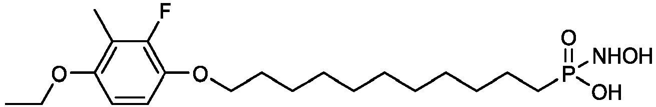 |
| 8 | 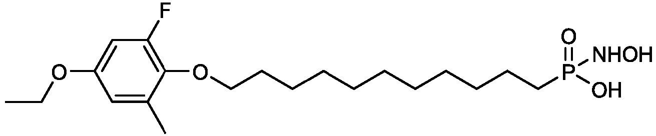 |
| 9 | 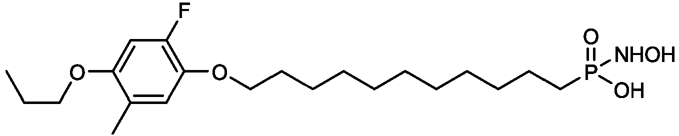 |
| 10 | 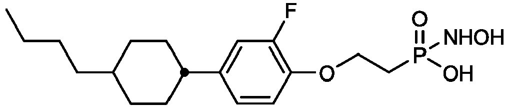 |
| 11 | 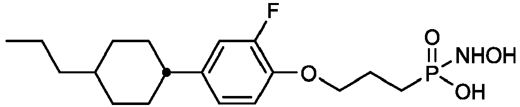 |
| 12 | 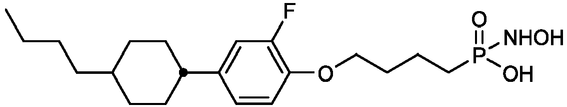 |
| 13 | 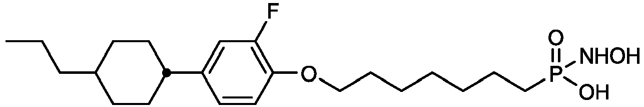 |
| 14 | 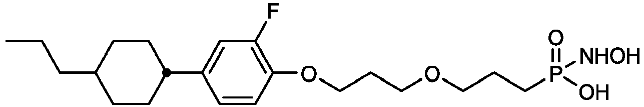 |
| 15 | 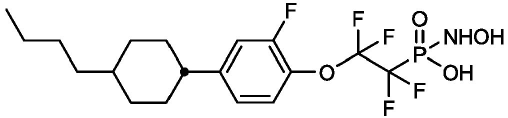 |
| 16 | 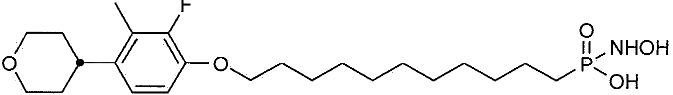 |
| 17 | 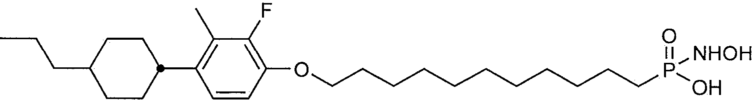 |
| 18 | 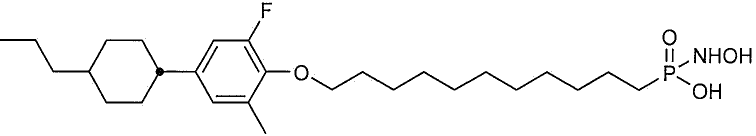 |
| 19 | 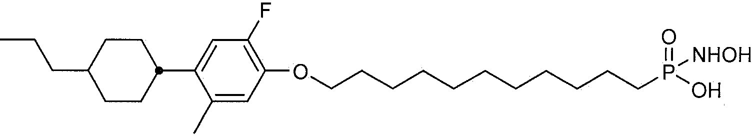 |
| 20 | 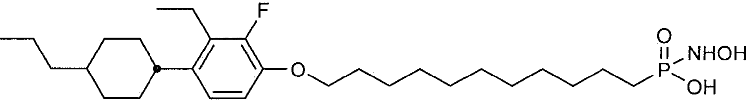 |
| 21 | 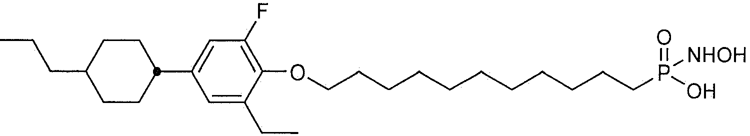 |
| 22 | 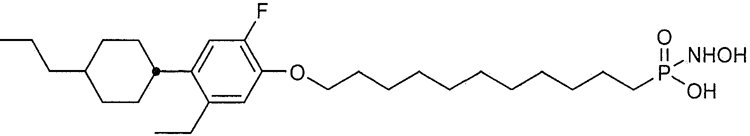 |
| 23 | 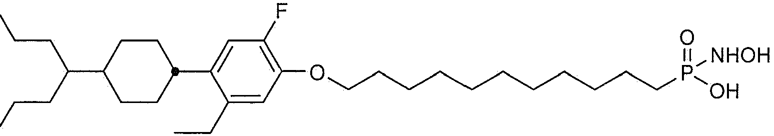 |
| 24 | 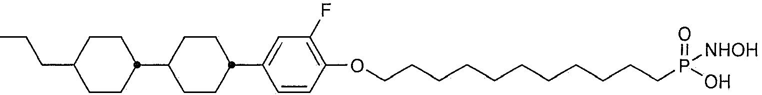 |
| 25 | 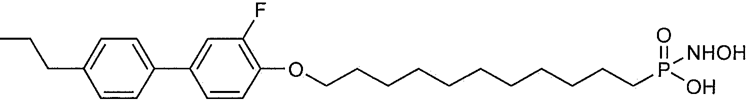 |
| 26 | 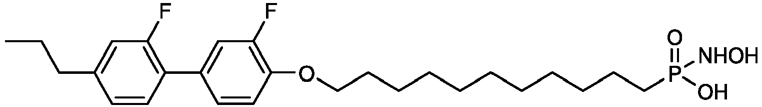 |
| 27 | 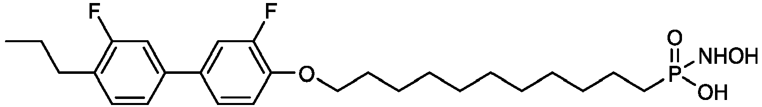 |
| 28 | 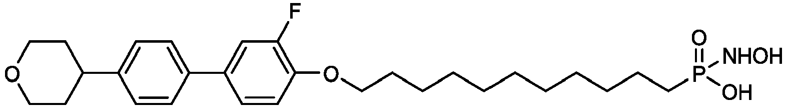 |
| 29 | 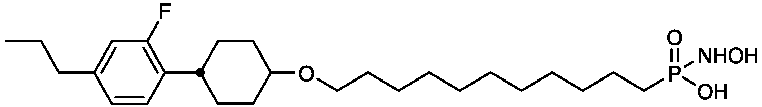 |
| 30 | 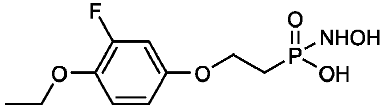 |
| 31 | 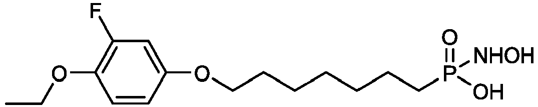 |
| 32 | 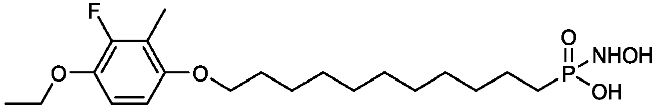 |
| 33 | 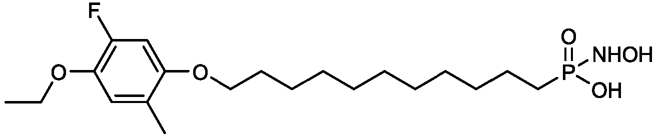 |
| 34 | 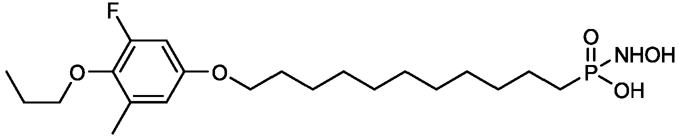 |
| 35 | 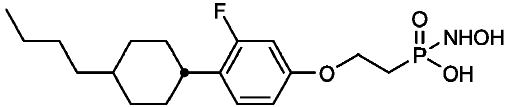 |
| 36 | 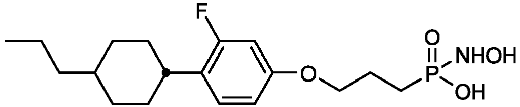 |
| 37 | 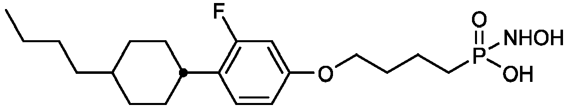 |
| 38 | 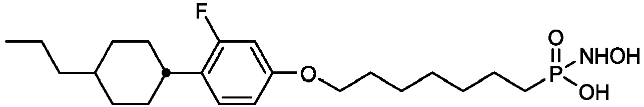 |
| 39 | 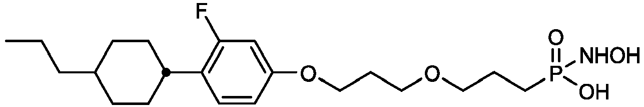 |
| 40 | 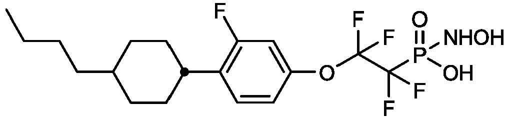 |
| 41 | 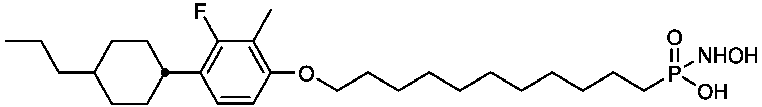 |
| 42 | 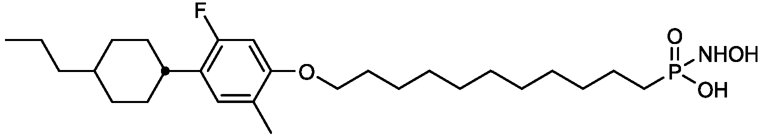 |
| 43 | 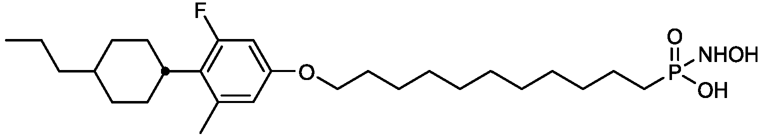 |
| 44 | 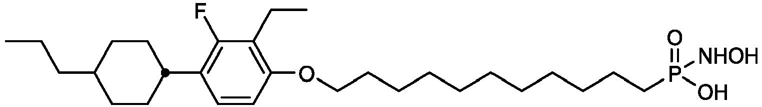 |
| 45 | 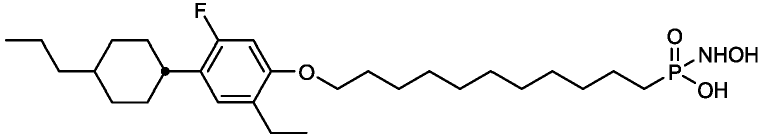 |
| 46 | 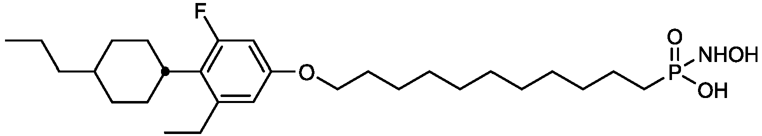 |
| 47 | 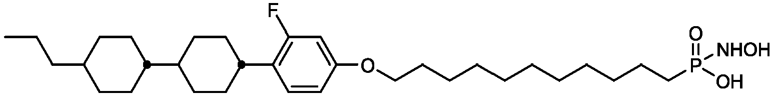 |
| 48 | 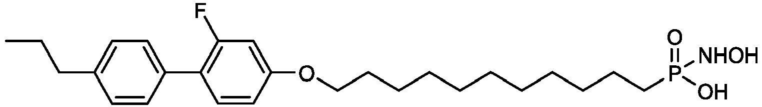 |
| 49 | 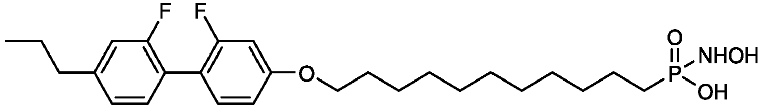 |
| 50 | 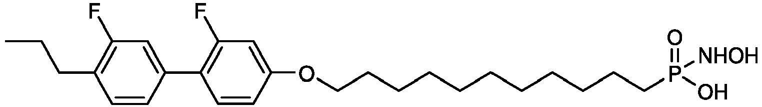 |
| 51 | 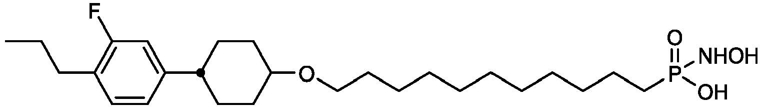 |
| 52 | 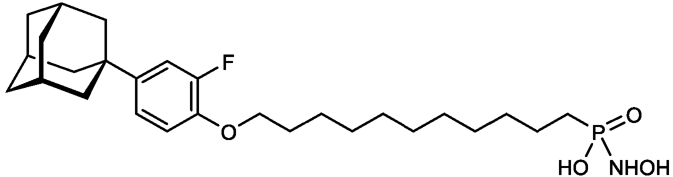 |
| 53 | 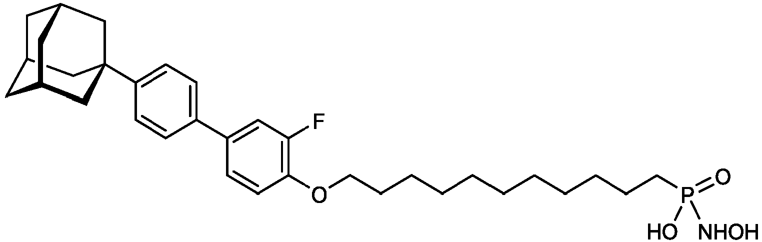 |
| 54 | 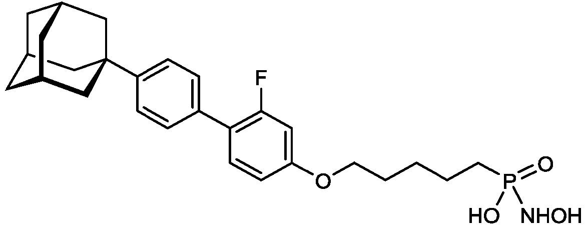 |
| 55 | 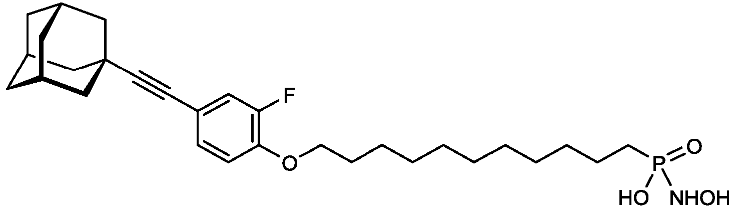 |
| 56 | 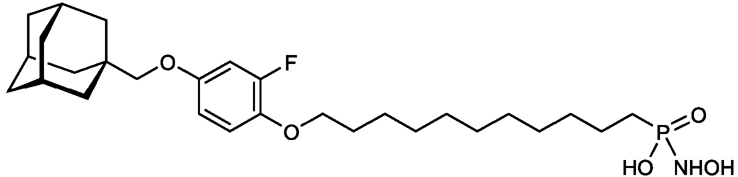 |
| 57 | 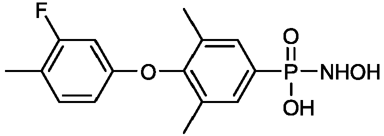 |
| 58 | 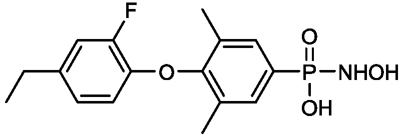 |
| 59 | 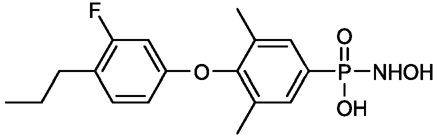 |
| 60 | 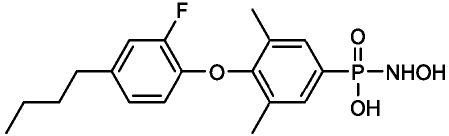 |
| 61 | 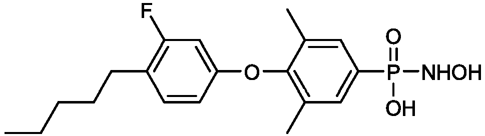 |
| 62 | 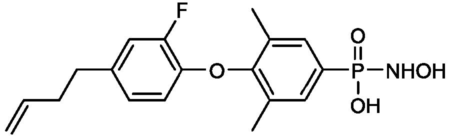 |
| 63 | 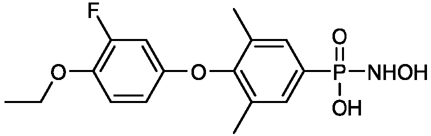 |
| 64 | 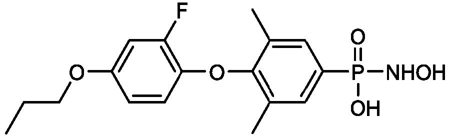 |
| 65 | 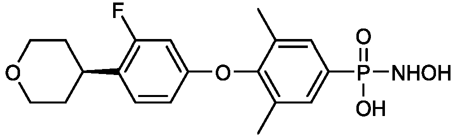 |
| 66 | 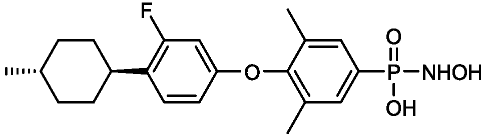 |
| 67 | 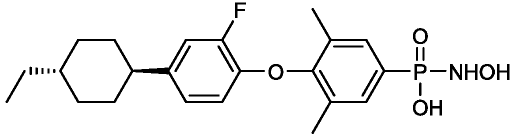 |
| 68 | 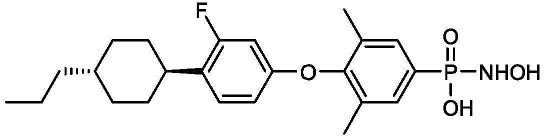 |
| 69 | 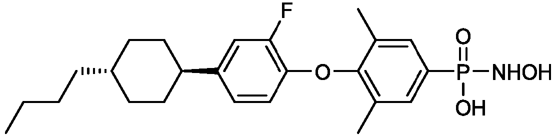 |
| 70 | 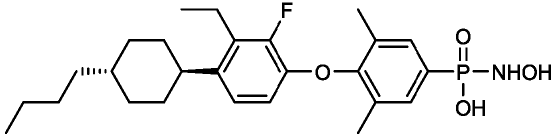 |
| 71 | 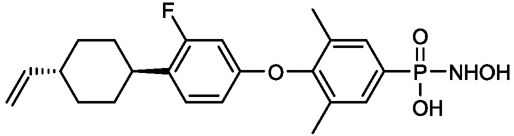 |
| 72 | 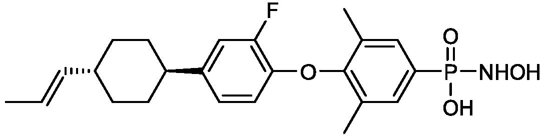 |
| 73 | 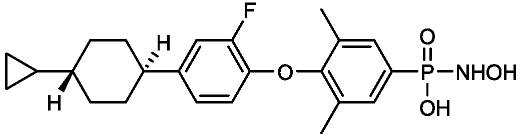 |
| 74 | 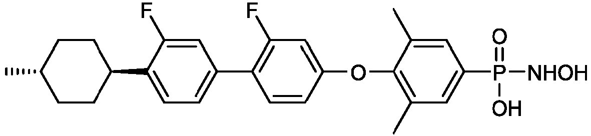 |
| 75 | 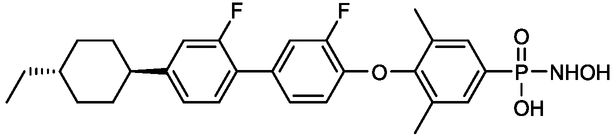 |
| 76 | 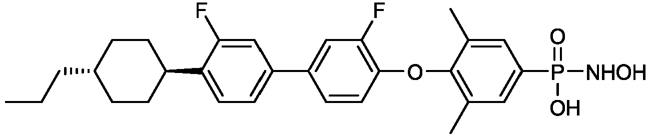 |
| 77 | 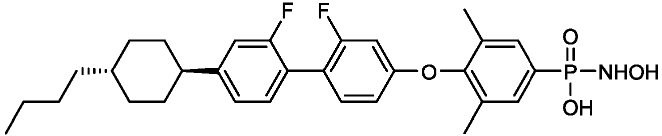 |
| 78 | 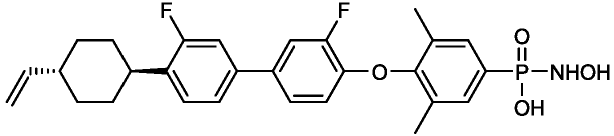 |
| 79 | 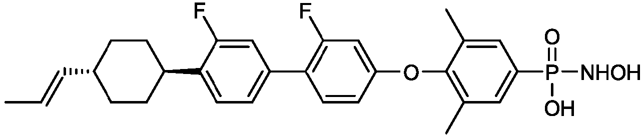 |
| 80 | 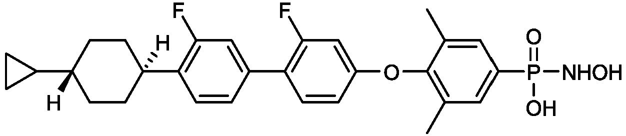 |
| 81 | 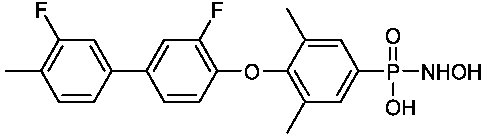 |
| 82 | 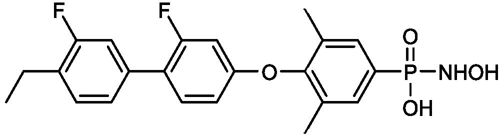 |
| 83 | 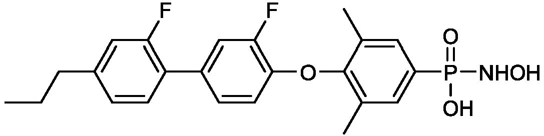 |
| 84 | 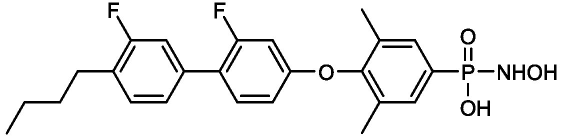 |
| 85 | 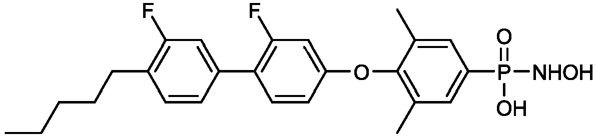 |
| 86 | 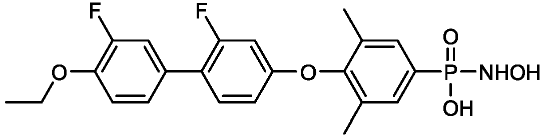 |
| 87 | 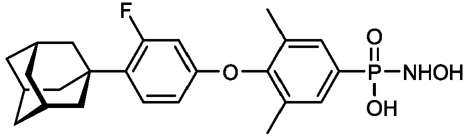 |
| 88 | 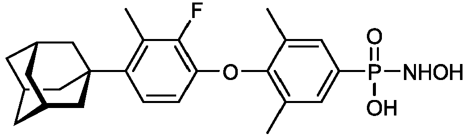 |
| 89 | 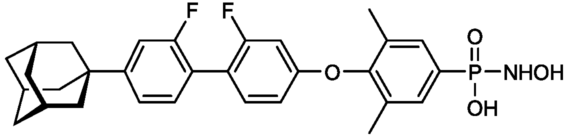 |
| 90 | 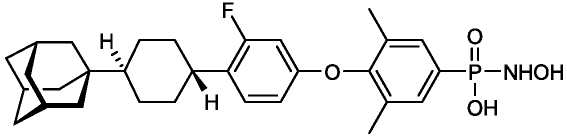 |
| 91 | 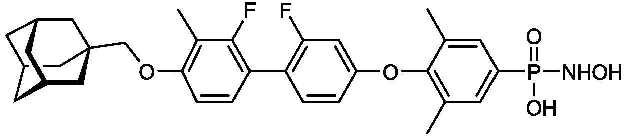 |
| 92 | 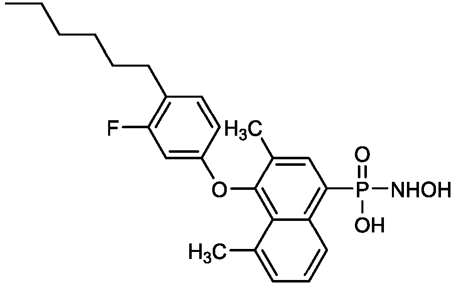 |
| 93 | 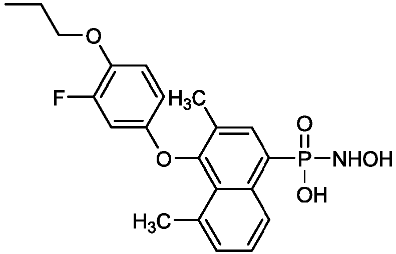 |
| 94 | 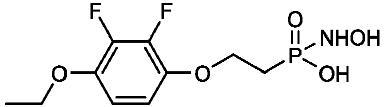 |
| 95 | 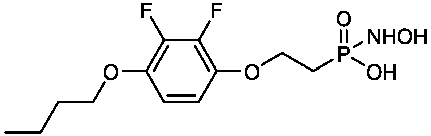 |
| 96 | 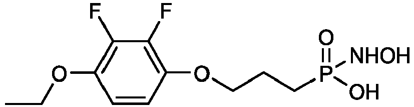 |
| 97 | 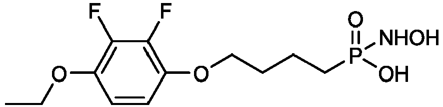 |
| 98 | 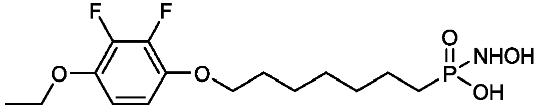 |
| 99 | 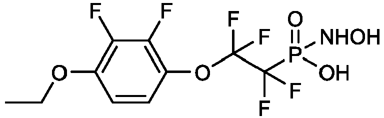 |
| 100 | 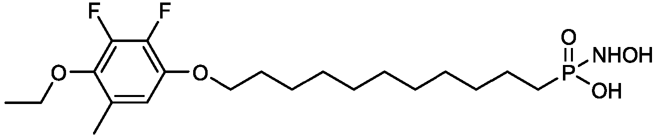 |
| 101 | 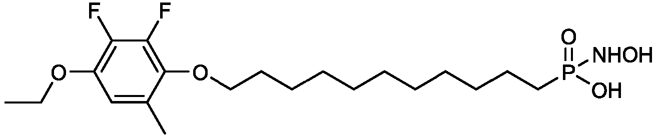 |
| 102 | 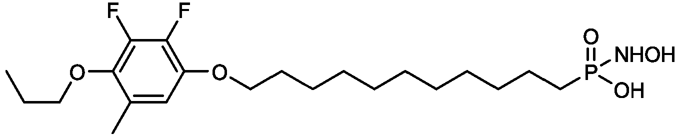 |
| 103 | 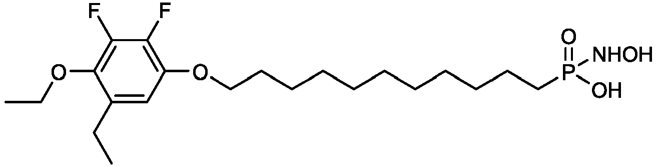 |
| 104 | 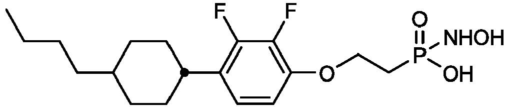 |
| 105 | 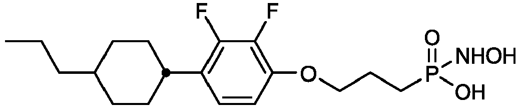 |
| 106 | 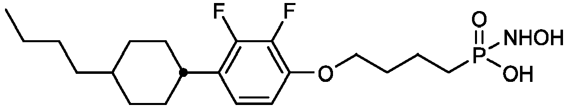 |
| 107 | 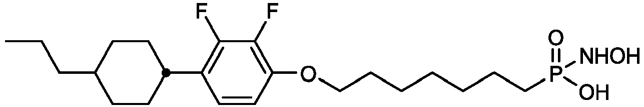 |
| 108 | 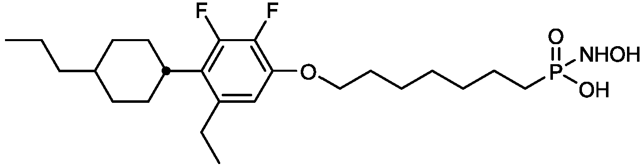 |
| 109 | 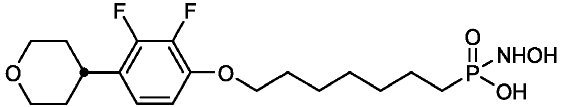 |
| 110 | 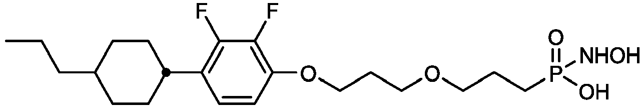 |
| 111 | 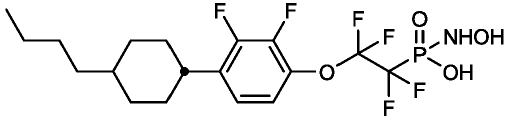 |
| 112 | 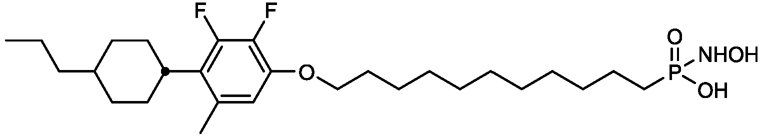 |
| 113 | 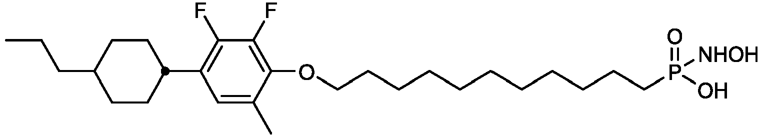 |
| 114 | 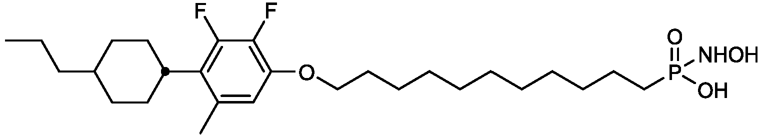 |
| 115 | 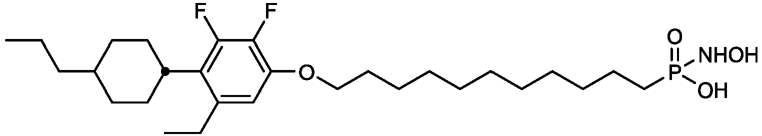 |
| 116 | 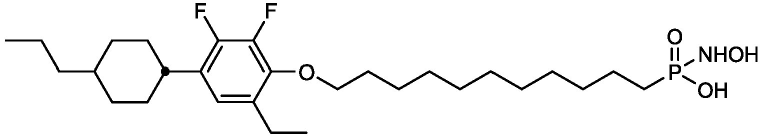 |
| 117 | 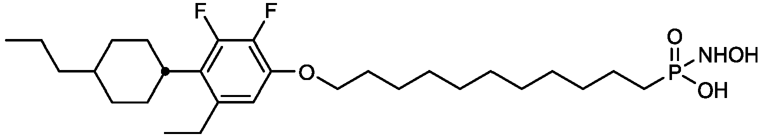 |
| 118 | 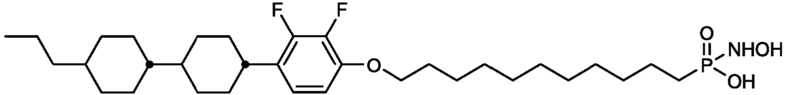 |
| 119 | 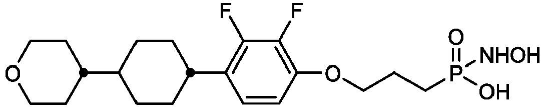 |
| 120 | 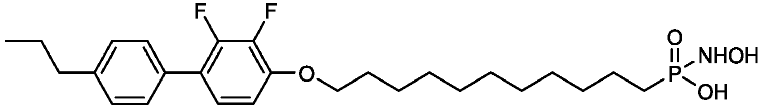 |
| 121 | 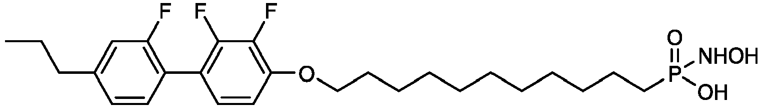 |
| 122 | 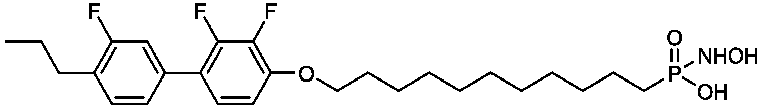 |
| 123 | 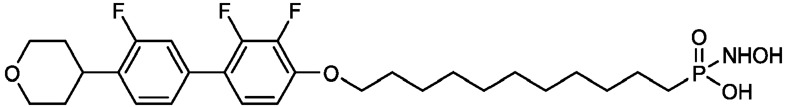 |
| 124 | 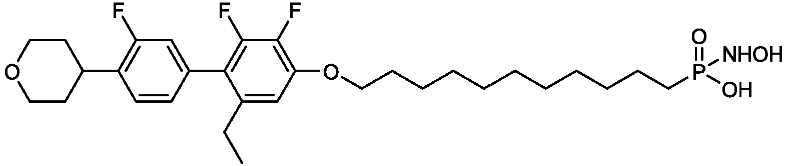 |
| 125 | 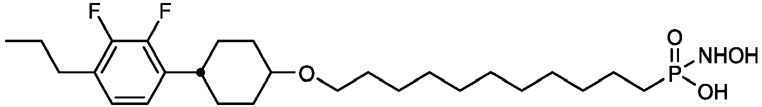 |
| 126 | 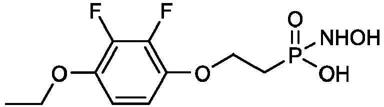 |
| 127 | 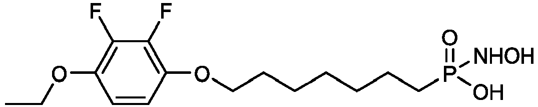 |
| 128 | 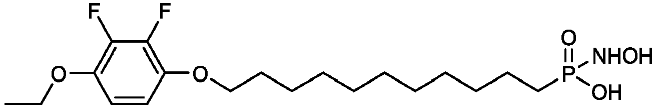 |
| 129 | 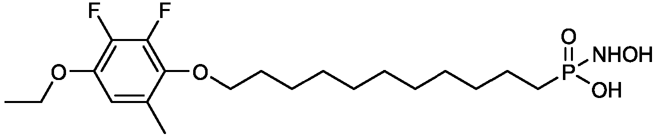 |
| 130 | 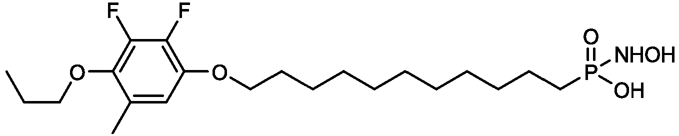 |
| 131 | 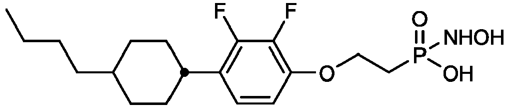 |
| 132 | 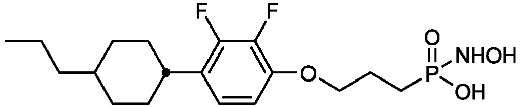 |
| 133 | 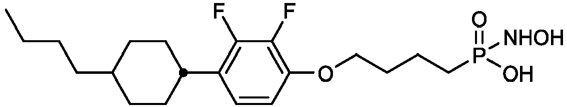 |
| 134 | 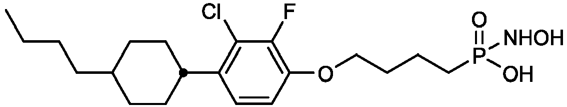 |
| 135 | 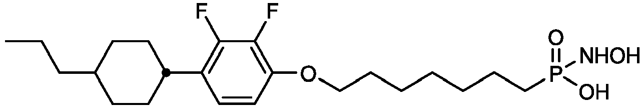 |
| 136 | 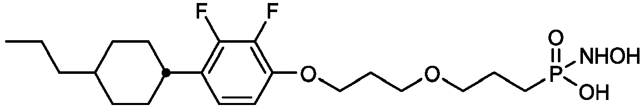 |
| 137 | 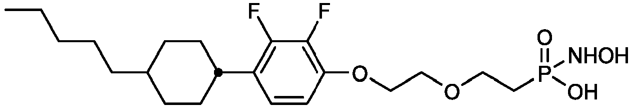 |
| 138 | 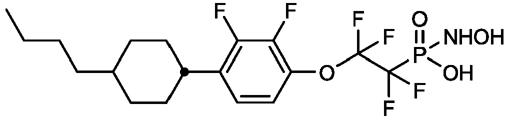 |
| 139 | 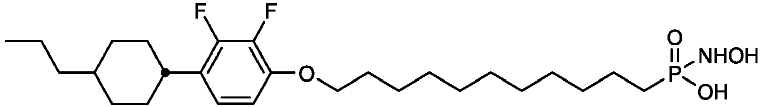 |
| 140 | 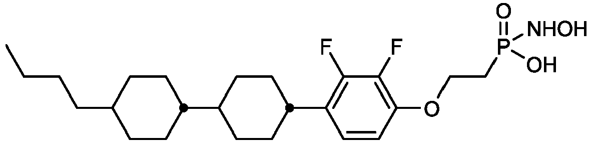 |
| 141 | 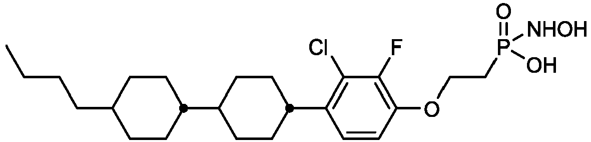 |
| 142 | 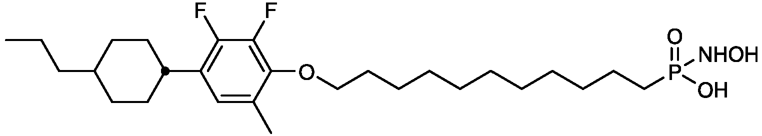 |
| 143 | 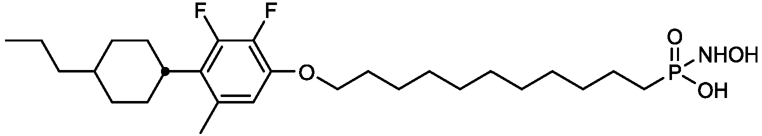 |
| 144 | 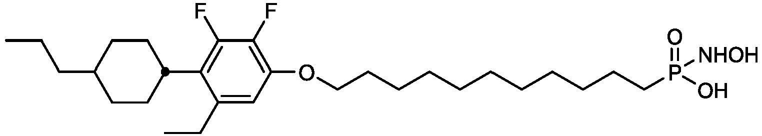 |
| 145 | 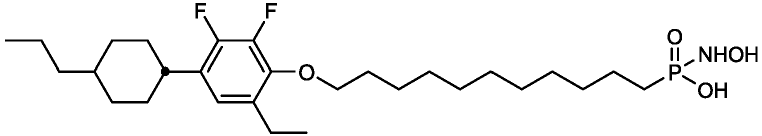 |
| 146 | 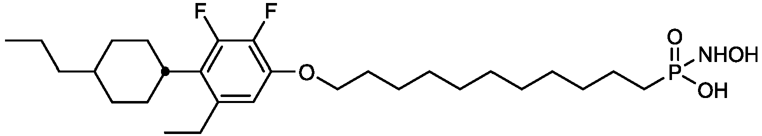 |
| 147 | 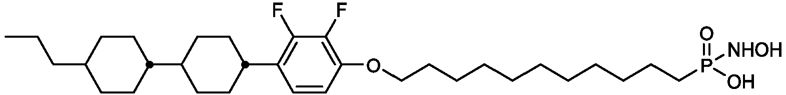 |
| 148 | 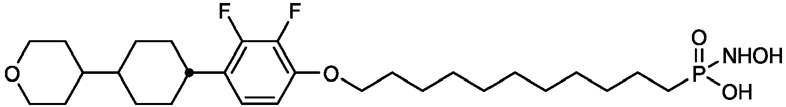 |
| 149 | 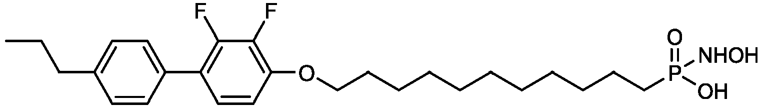 |
| 150 | 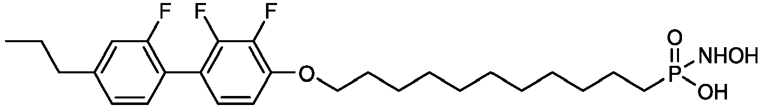 |
| 151 | 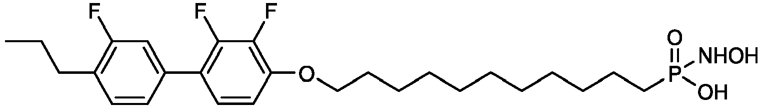 |
| 152 | 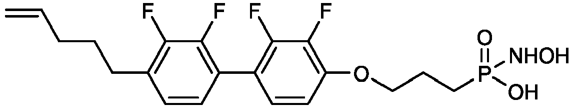 |
| 153 | 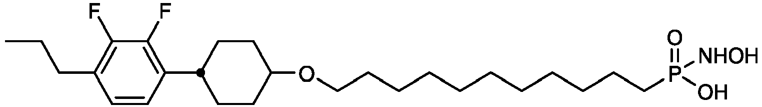 |
| 154 | 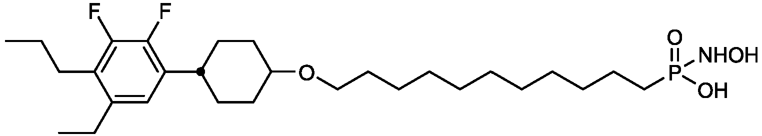 |
| 155 | 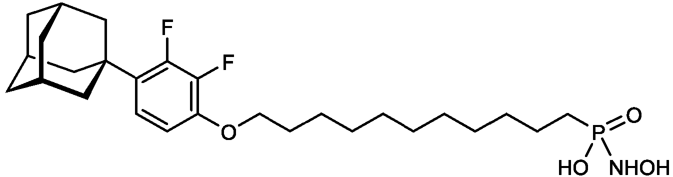 |
| 156 | 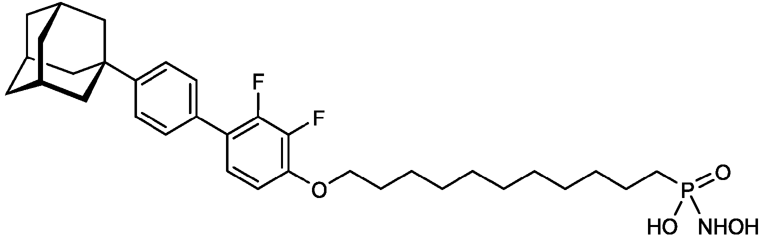 |
| 157 | 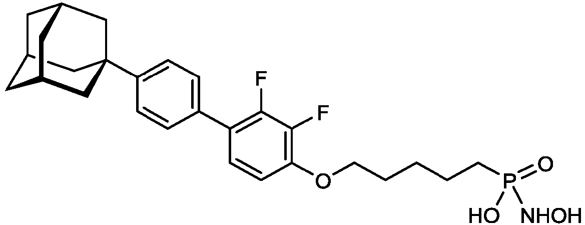 |
| 158 | 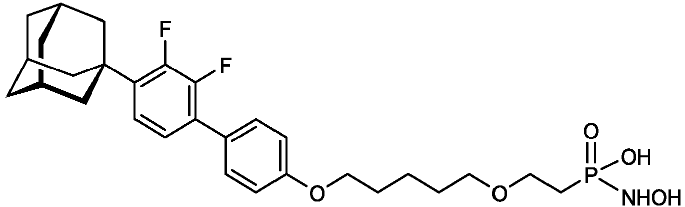 |
| 159 | 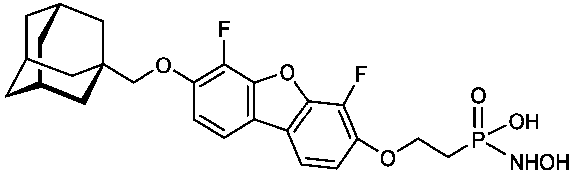 |
| 160 | 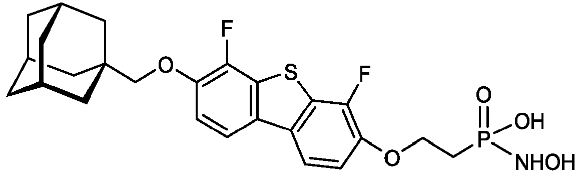 |
| 161 | 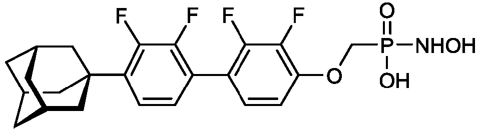 |
| 162 | 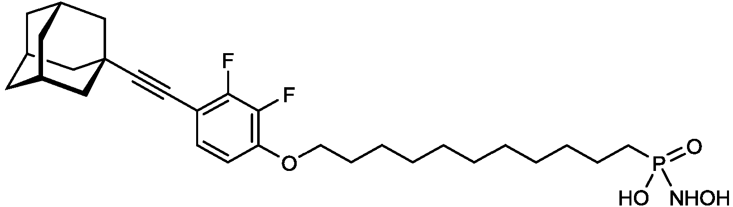 |
| 163 | 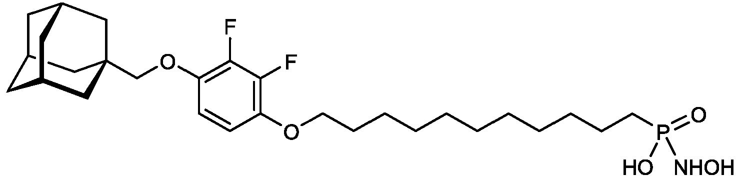 |
| 164 | 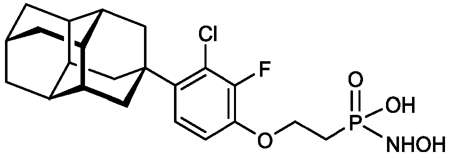 |
| 165 | 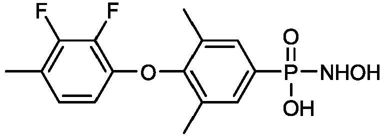 |
| 166 | 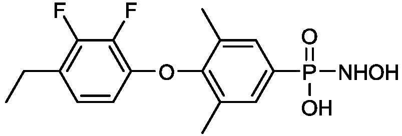 |
| 167 | 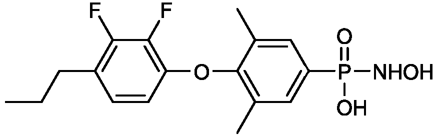 |
| 168 | 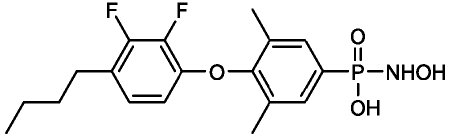 |
| 169 | 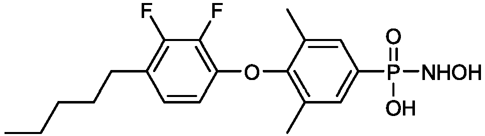 |
| 170 | 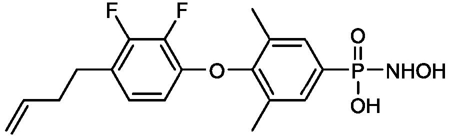 |
| 171 | 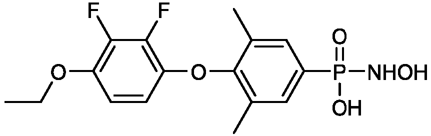 |
| 172 | 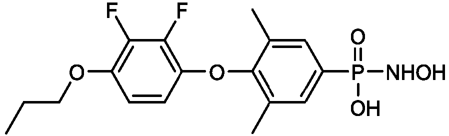 |
| 173 | 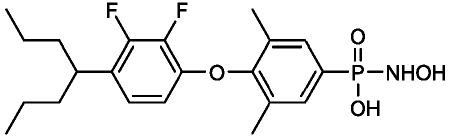 |
| 174 | 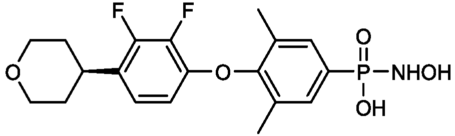 |
| 175 | 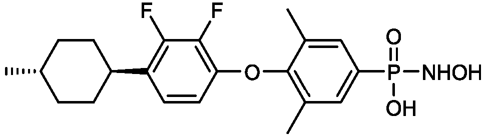 |
| 176 | 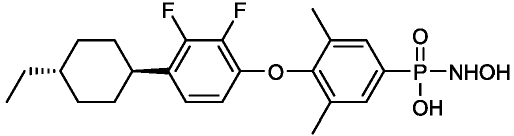 |
| 177 | 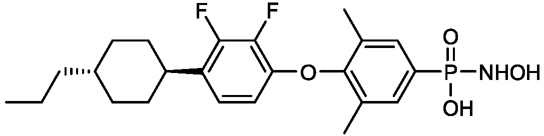 |
| 178 | 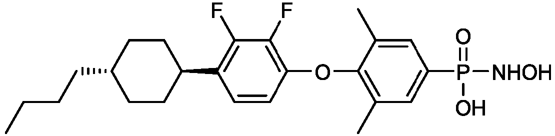 |
| 179 | 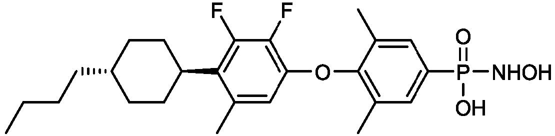 |
| 180 | 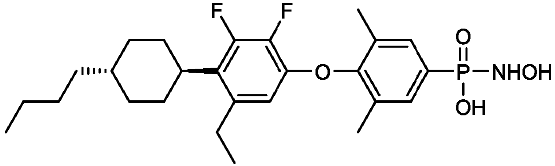 |
| 181 | 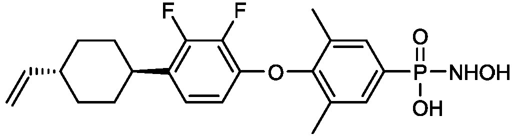 |
| 182 | 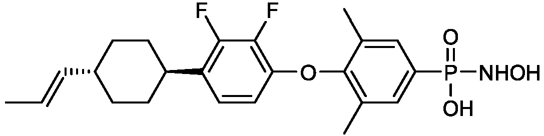 |
| 183 | 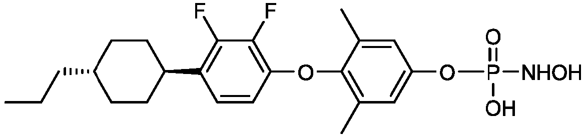 |
| 184 | 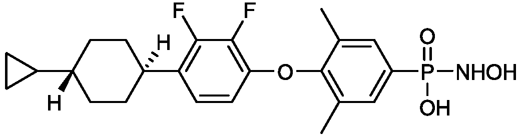 |
| 185 | 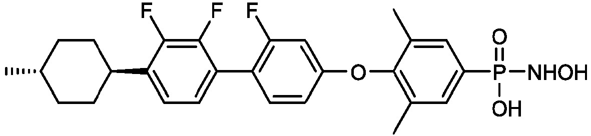 |
| 186 | 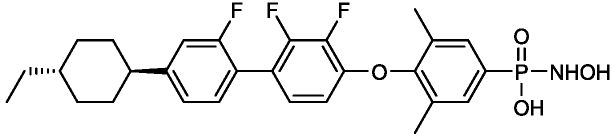 |
| 187 | 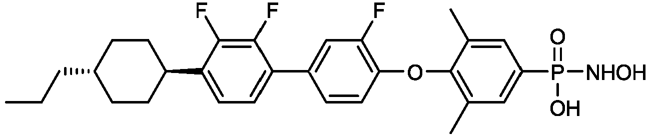 |
| 188 | 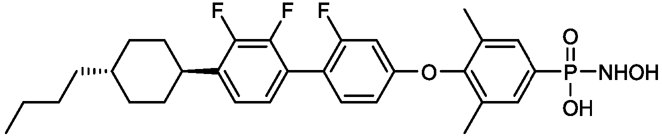 |
| 189 | 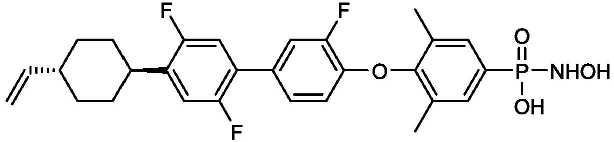 |
| 190 | 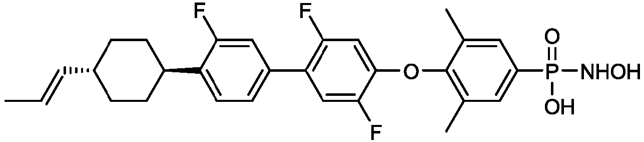 |
| 191 | 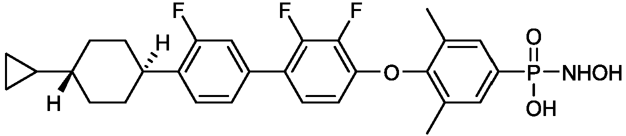 |
| 192 | 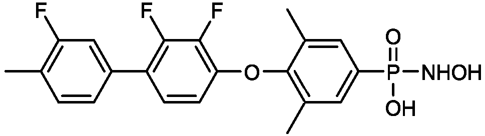 |
| 193 | 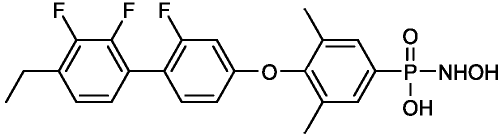 |
| 194 | 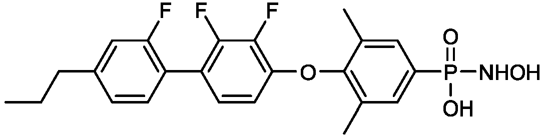 |
| 195 | 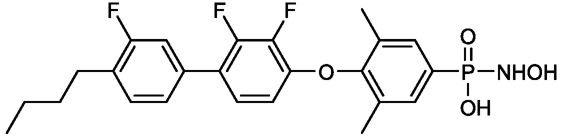 |
| 196 | 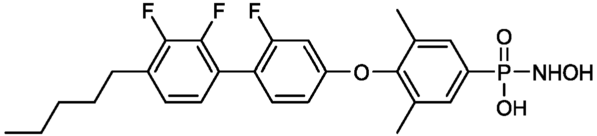 |
| 197 | 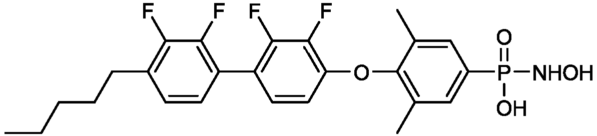 |
| 198 | 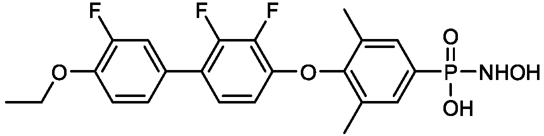 |
| 199 | 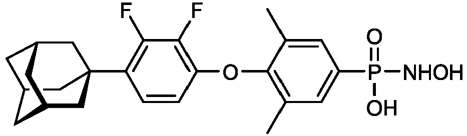 |
| 200 | 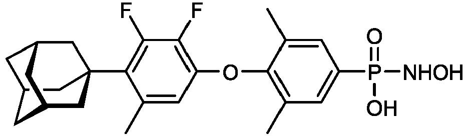 |
| 200 | 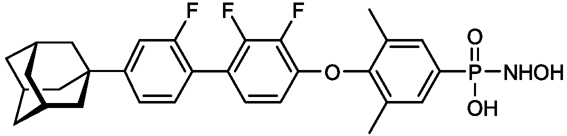 |
| 201 | 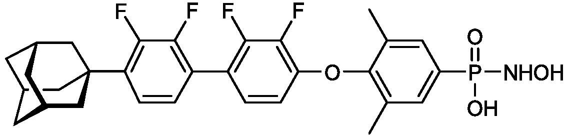 |
| 202 | 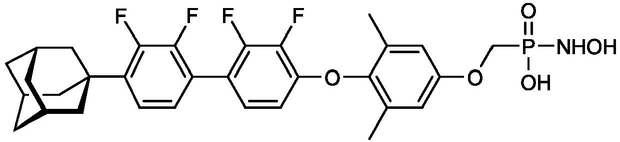 |
| 203 | 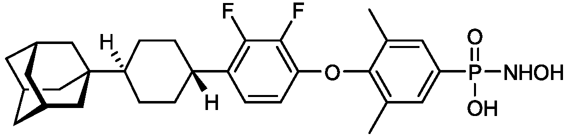 |
| 204 | 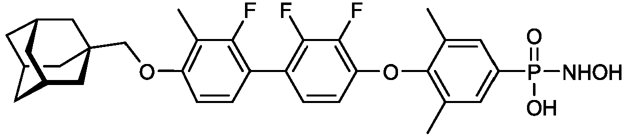 |
| 205 | 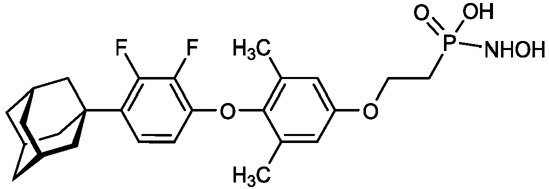 |
| 206 | 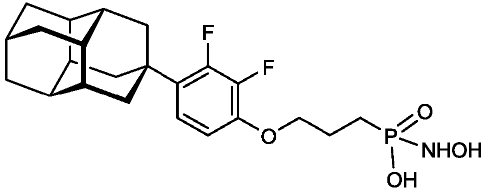 |
| 207 | 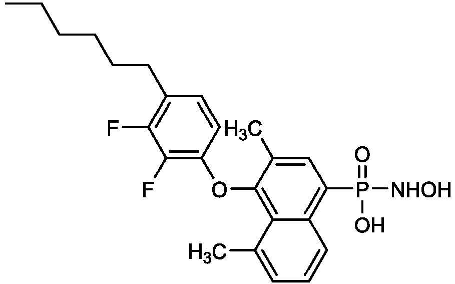 |
| 208 | 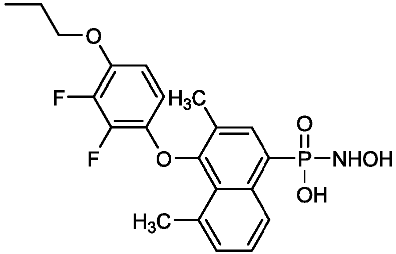 |
| 209 | 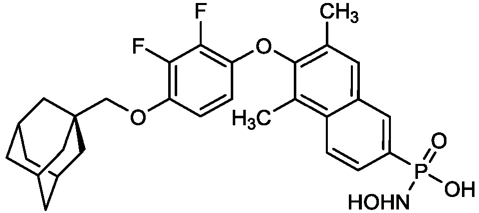 |
| 210 | 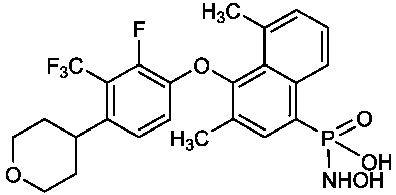 |
| 211 | 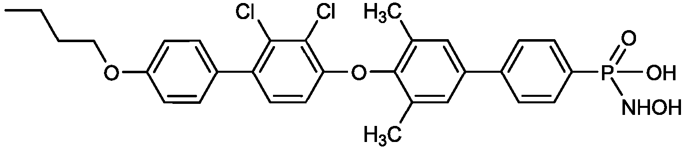 |
| 212 | 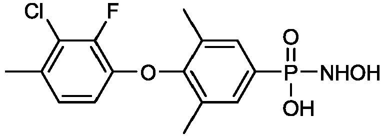 |
| 213 | 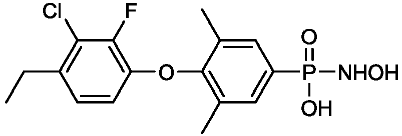 |
| 214 | 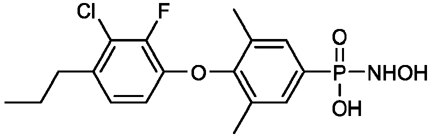 |
| 215 | 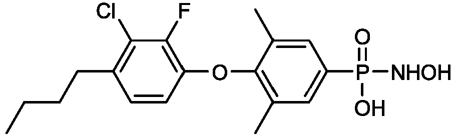 |
| 216 | 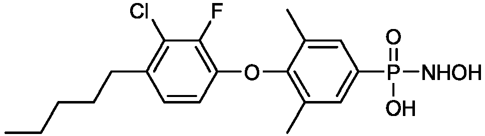 |
| 217 | 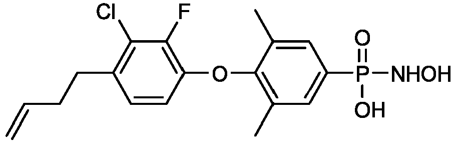 |
| 218 | 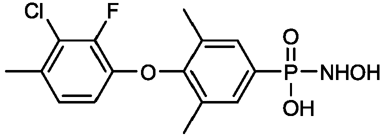 |
| 219 | 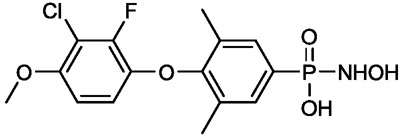 |
| 220 | 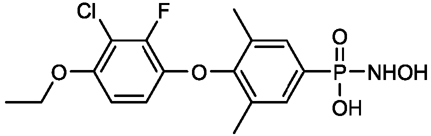 |
| 221 | 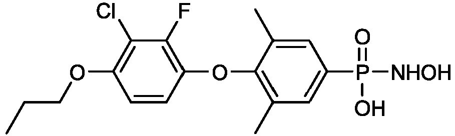 |
| 222 | 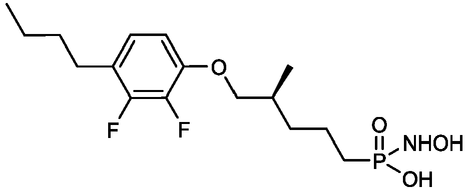 |
| 223 | 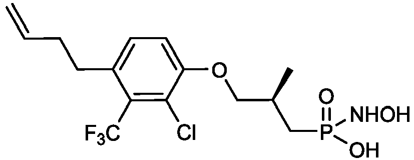 |
| 224 | 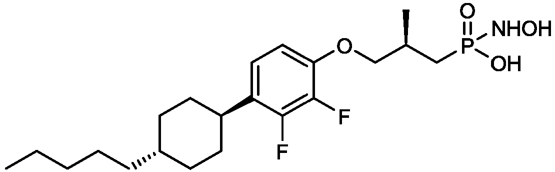 |
| 225 | 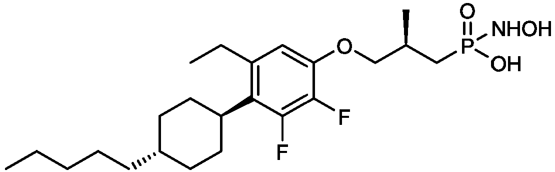 |
| 226 | 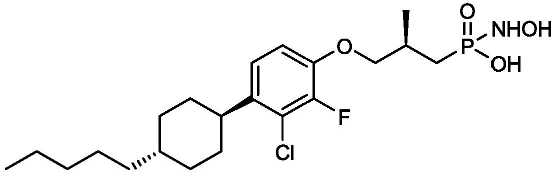 |
| 227 | 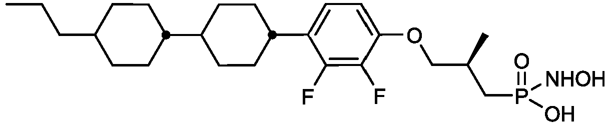 |
| 228 | 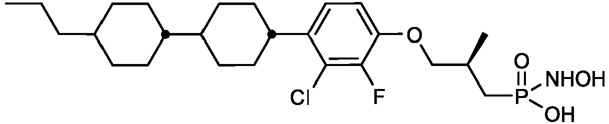 |
| 229 | 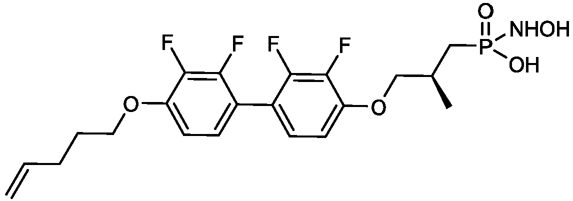 |
| 230 | 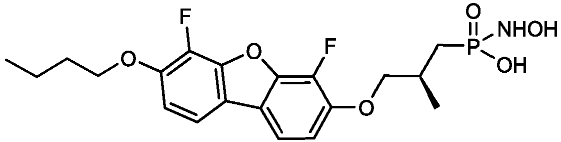 |
| 231 | 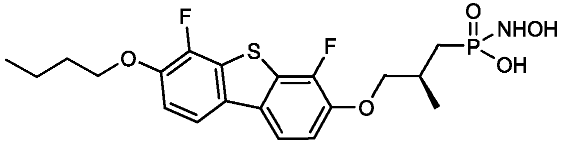 |
| 232 | 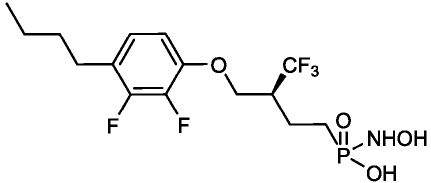 |
| 233 | 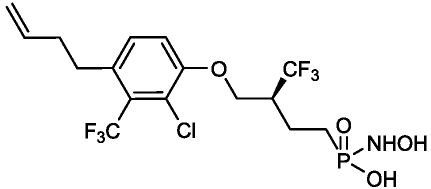 |
| 234 | 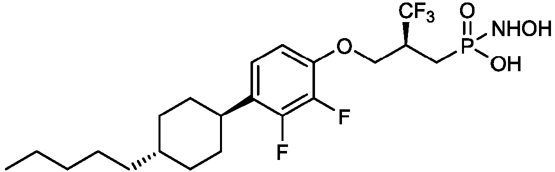 |
| 235 | 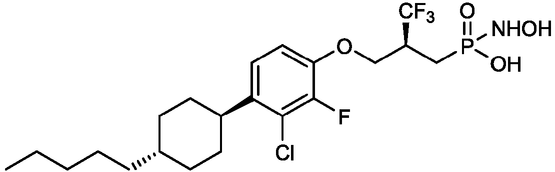 |
| 236 | 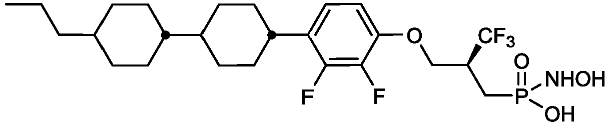 |
| 237 | 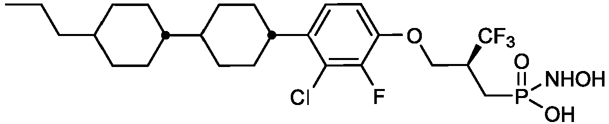 |
| 238 | 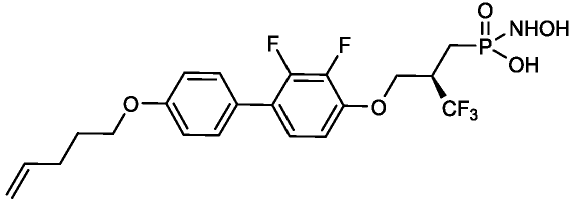 |
| 239 | 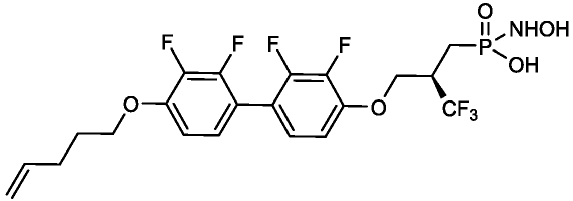 |
| 240 | 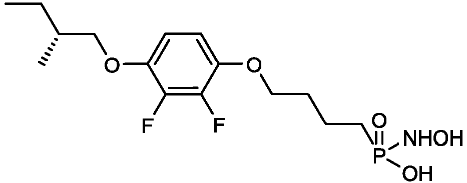 |
| 241 | 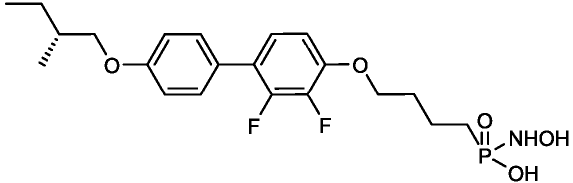 |
| 242 | 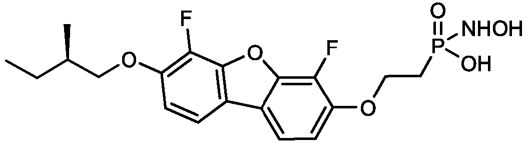 |
| 243 | 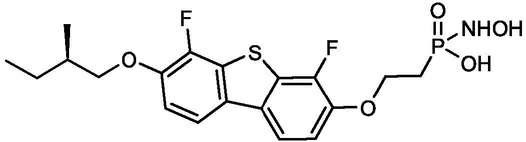 |
| 244 | 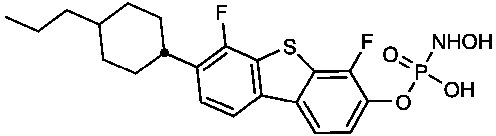 |
| 245 | 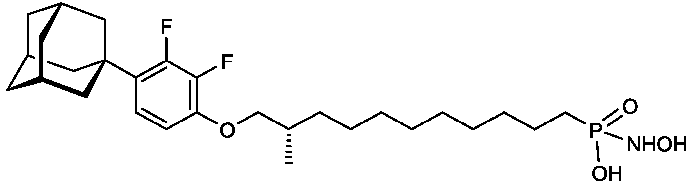 |

## Claims

1. A compound selected from the compounds of the formulae la-1a to la-1d, and la-2: 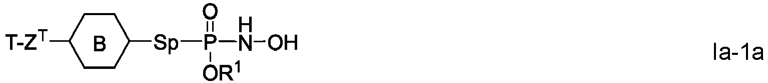 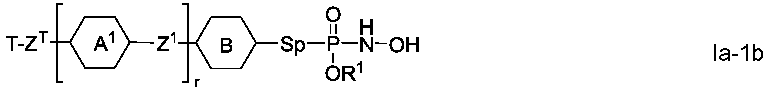 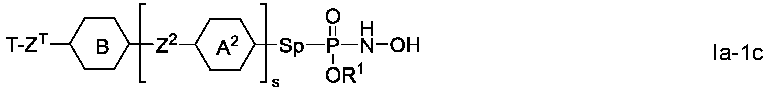 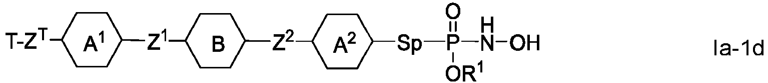 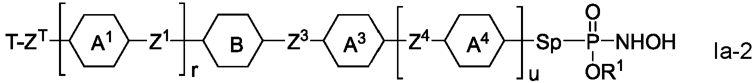
where in the compounds of the formulae la-1a, la-1b, la-1c and la-1d, r is 1 or 2, and s is 1 or 2,
and in the compound of the formula la-2, r and u, identically or differently, are 0, 1 or 2,
and in which
T is selected from the group of radicals consisting of the following groups:
a) straight chain or branched alkyl or alkoxy each having 1 to 20 C atoms, where one or more CH₂ groups in these radicals may each be replaced, independently of one another, by -C≡C- , -CH=CH-, 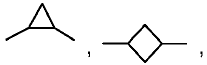 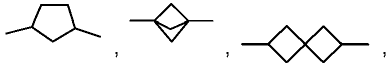 -O-, -S-, -CF₂O-, -OCF₂-, -CO-O-, -O-CO- -SiR⁰R⁰⁰- , -NH- , -NR⁰- or -SO₂- in such a way that O atoms are not linked directly to one another, and in which one or more H atoms may be replaced by halogen, CN, SCN or SF₅, wherein R° and R⁰⁰, identically or differently, denote an alkyl or alkoxy radical having 1 to 15 C atoms, in which, in addition, one or more H atoms may be replaced by halogen,
b) a three- to ten-membered saturated or partially unsaturated aliphatic ring, in which at least one -CH₂- group is replaced with -O-, -S-, -S(O)-, -SO₂-, -NR^{x}- or -N(O)R^{x}-, or in which at least one -CH= group is replaced with -N=,
c) a diamondoid radical,
Z^{T}, Z¹, Z², and Z⁴, on each occurrence, identically or differently, denote a single bond, -CF₂O-, -OCF₂-, -CF₂S-, -SCF₂-, -CH₂O-, -OCH₂-, -C(O)O-, -OC(O)-, -C(O)S-, -SC(O)-, -(CH₂)ₙ₁-, -(CF₂)ₙ₂-, -CF₂ CH₂-, -CH₂CF₂-, -CH=CH-,-CF=CF-, -CF=CH-, -CH=CF-, -(CH₂)ₙ₃O-, -O(CH₂)ₙ₄-, -C≡C-, -O-, -S-, -CH=N-, -N=CH-, -N=N-, -N=N(O)-, -N(O)=N- or -N=C-C=N-, wherein n1, n2, n3, n4, identically or differently, are 1, 2, 3, 4, 5, 6, 7, 8, 9 or 10,
Z³ denotes -O-, -S-, -CH₂-, -C(O)-, -CF₂-, -CHF-, -C(R^{x})₂-, -S(O)- or -SO₂-, 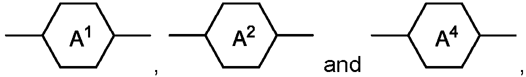 on each occurrence, identically or differently, denote an aromatic, heteroaromatic, alicyclic or heteroaliphatic ring having 4 to 25 ring atoms, which may also contain condensed rings and which may be mono- or polysubstituted by Y, 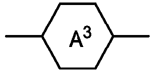 denotes an aromatic or heteroaromatic ring having 5 to 25 ring atoms, which may also contain condensed rings and which may be mono- or polysubstituted by R^{C},
Y on each occurrence, identically or differently, denotes F, Cl, CN, SCN, SF₅ or straight-chain or branched, in each case optionally fluorinated alkyl, alkoxy, alkylcarbonyl, alkoxycarbonyl, alkylcarbonyloxy or alkoxycarbonyloxy having 1 to 12 C atoms, 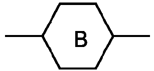 denotes a group 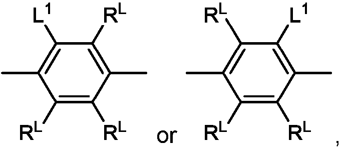 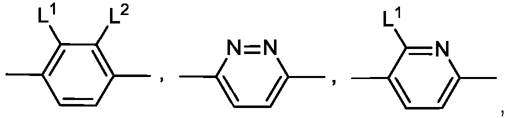 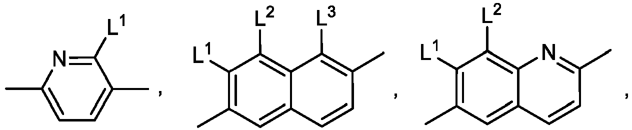 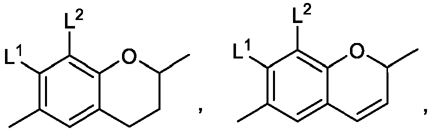 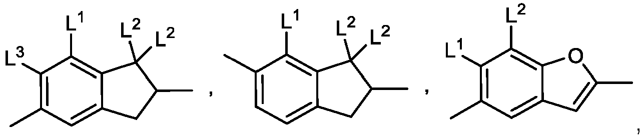 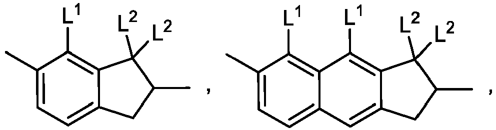 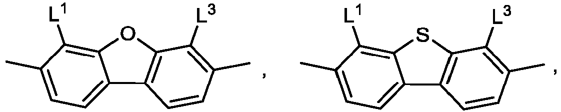 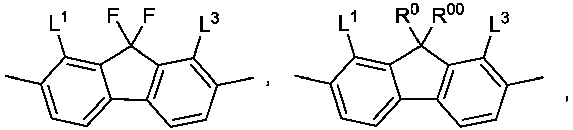 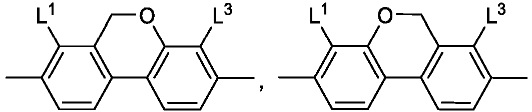 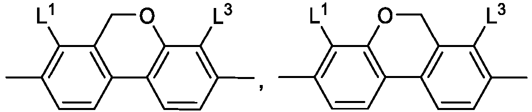 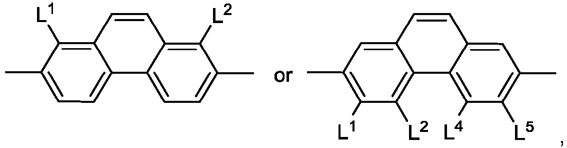 wherein the groups may be oriented in both directions,
L¹ to L⁵, identically or differently, denote H, F, Cl, Br, I, CN, SF₅, CF₃, OCF₃, or OCHF₂, where at least one of the present radicals L¹ to L⁵ in the respective groups is not H,
R^{L} on each occurrence, identically or differently, denotes H, alkyl having 1 to 6 C atoms, alkenyl having 2 to 6 C atoms or alkoxy having 1 to 5 C atoms,
R^{C} on each occurrence, identically or differently, denotes straight-chain or branched, in each case optionally fluorinated alkyl, alkoxy, alkylthio, alkylcarbonyl, alkoxycarbonyl, alkylcarbonyloxy or alkoxycarbonyloxy having 1 to 12 C atoms or cycloalkyl or alkylcycloalkyl each having 3 to 12 C atoms,
R⁰, R⁰⁰, R^{x} denote straight-chain or branched alkyl having 1 to 6 C atoms,
R¹ denotes H or straight chain or branched alkyl having 1 to 12 C atoms,
Sp denotes a single bond or Sp'-X' in which X' is bonded to a ring A², A³, A⁴ or B
in which
Sp' denotes straight-chain or branched alkylene having 1 to 20, preferably 1 to 12 C atoms, which is optionally mono- or polysubstituted by F, Cl, Br, I or CN and in which, in addition, one or more non-adjacent CH₂ groups may each be replaced, independently of one another, by - O-, -S-, -NH-, -NR⁰-, -SiR⁰⁰R⁰⁰⁰-, -CO-, -COO-, -OCO-, -OCO-O-, -S-CO-, -CO-S-, -NR⁰-CO-O-, -O-CO-NR⁰-, -NR⁰-CO-NR⁰-, -CH=CH- or -C≡C- in such a way that O and/or S atoms are not linked directly to one another,
X' denotes -O-, -S-, -CO-, -COO-, -OCO-, -O-COO-, -CO-NR⁰⁰-, -NR⁰⁰-CO-, -NR⁰⁰-CO-NR⁰⁰-, -OCH₂-, -CH₂O-, -SCH₂-, -CH₂S-, -CF₂O-, -OCF₂-, -CF₂S-, -SCF₂-, -CF₂CH₂-, -CH₂CF₂-, -CF₂CF₂-, -CH=N-, -N=CH-, -N=N-, -CH=CR⁰⁰-, -CY^{x}=CY^{x'}-, -C≡C-, -CH=CH-COO-, -OCO-CH=CH- or a single bond, in which R⁰, R⁰⁰ and R⁰⁰⁰ each, independently of one another, denote H or alkyl having 1 to 12 C atoms, and Y^{x} and Y^{×'} each, independently of one another, denote H, F, Cl or CN.

2. The compound according to claim 1, wherein
T denotes H, 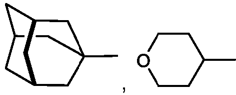 or straight chain or branched alkyl or alkoxy each having 1 to 7 C atoms or straight chain or branched alkenyl having 2 to 7 C atoms,
Z^{T} denotes CH₂O, OCH₂, CH₂CH₂, or a single bond,
Z¹ and Z², identically or differently, denote CH₂O, OCH₂, CH₂CH₂, CF₂O, OCF₂, C(O)O, OC(O) or a single bond, 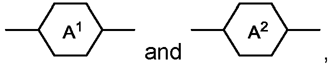 identically or differently, denote 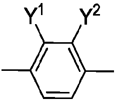 or 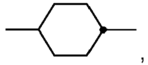
Y¹ and Y², on each occurrence, identically or differently, denote H, F of Cl,
Sp denotes branched or unbranched 1,ω-alkylene having 1 to 12 C atoms, in which one or more non-adjacent CH₂-groups may be replaced by O,
R¹ denotes H, and 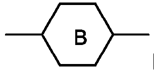 has the meanings defined in claim 1.

3. The compound according to claim 1, wherein in formula la-2 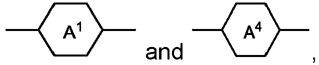 identically or differently, denote 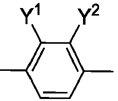 or 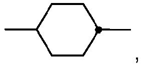
A³-Z³ denotes 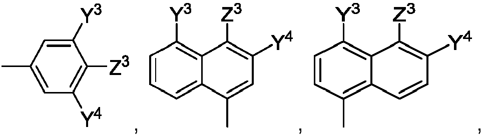 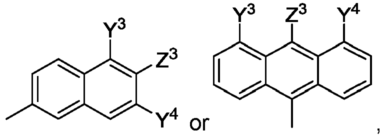
Z^{T} denotes a single bond, -CH₂O-, -OCH₂- or -CH₂CH₂-,
Y¹ and Y² denote H, F or Cl,
Y³ and Y⁴ denote methyl, ethyl, isopropyl, cyclopropyl, cyclobutyl, cyclopentyl, cyclopentenyl, cyclohexyl, cyclohexenyl, methoxy, trifluoromethyl, trifluoromethoxy, or trifluoromethylthio,
Z³ denotes CH₂ or O,
Z¹ and Z⁴, independently of one another, denote a single bond, -C(O)O-, -OC(O)-, -CF₂O-, -OCF₂-, -CH₂O-, OCH₂- or -CH₂CH₂-,
r and u independently are 0, 1 or 2.

4. The compound according to one or more of claims 1 to 3, wherein the group 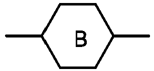 denotes 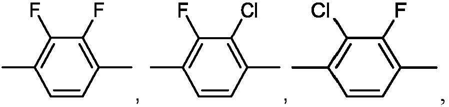 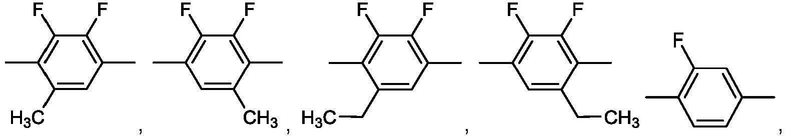 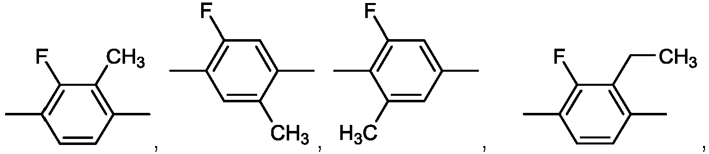 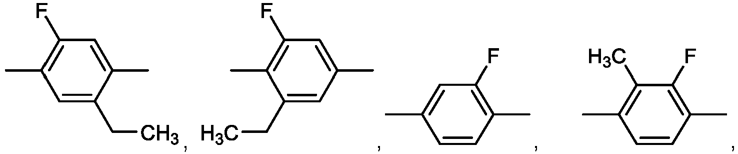 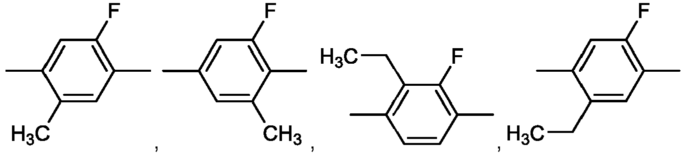 or

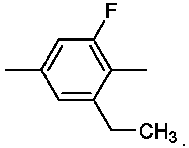

5. A process for the preparation of a compound of formula Ib comprising the steps of
a) reaction of a phosphonochloridate of formula II with an O-(trialkylsilyl)hydroxylamine in the presence of a base to give N-[(alkoxy)phosphoryl]hydroxylamines of formula la, and
b) ester cleavage of the compound of formula la to give the compounds of the formula Ib 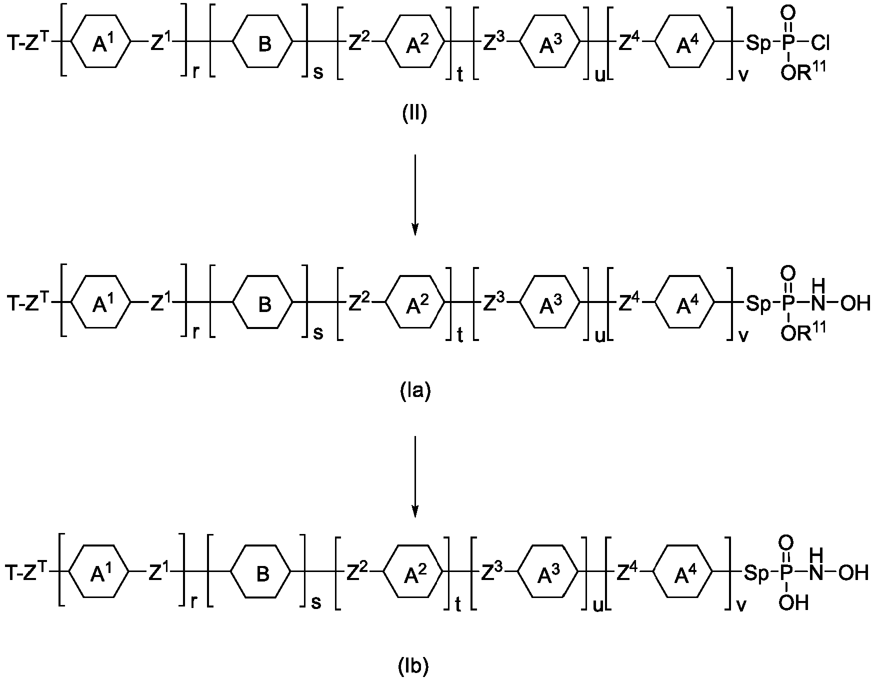
wherein T, Z^{T}, 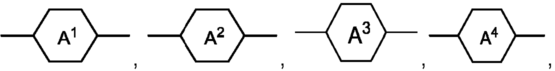 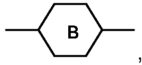 Z¹, Z², Z³, Z⁴, Sp, r, s, t, u, and v have the meanings given in claim 1, and
R¹¹ denotes straight chain alkyl having 1 to 12 C atoms or branched alkyl having 3 to 12 C atoms.

6. An electronic switching device (100) which comprises, in this sequence,
a first electrode (102),
a molecular layer (103) bonded to the first electrode, and
a second electrode (104),
wherein the first and second electrodes (102, 104), identically or differently, preferably comprise a material selected from Ag, Al, Au, Co, Cr, Cu, Mo, Nb, Ni, Pt, Ru, Si, W, CrN, HfN, MoN, NbN, TiN, TaN, Ta₃N₅, TaNx, TaON, WN, WCN, VN, ZrN, Ta₂O₅, SiO₂, ZrO₂, HfO₂, WO₃, RuO₂, Cu₂O, TiO₂, Co₂O₃, and niobium-doped strontium titanate,
**characterised in that** the molecular layer (103) is essentially formed from one or more compounds selected from the group of compounds of the formulae la-1a, la-1b, la-1c, la-1d, and la-2, according to one or more of claims 1 to 4.

7. Electronic switching device (100) according to claim 6, wherein an interlayer (105) is arranged between the first electrode (102) and the molecular layer (103), where the interlayer (105) comprises an oxidic material and where the molecular layer (103) is bonded to said oxidic material, and where the first electrode (102) and the interlayer (105) are operable as a first electrode (102').

8. Electronic switching device (100) according to claim 6 or 7, wherein the one or more compounds selected from the group of compounds of the formulae la-1a, la-1b, la-1c, la-1d, and la-2 are bonded to the first electrode (102) by chemisorption or covalently.

9. Electronic switching device (100) according to one or more of claims 6 to 8, wherein the molecular layer (103) is a molecular monolayer.

10. Electronic component comprising one or more switching devices (100) according to one or more of claims 6 to 9.

11. Electronic component according to claim 10, wherein the component has a multitude of switching devices (100), where the first electrodes (102) and second electrodes (104) of the switching devices (100) form a crossbar array.

12. Electronic component according to claim 10 or 11, wherein the switching devices (100) are configured to change between a state having high electrical resistance and a state having low electrical resistance, where the quotient between high electrical resistance and low electrical resistance is between 10 and 100,000.

13. Use of a compound selected from the group of compounds of the formulae la-1a, la-1b, la-1c, la-1d, and la-2 according to claim 1 for the fabrication of a self-assembled monolayer.

## Patentansprüche

1. Verbindung ausgewählt aus den Verbindungen der Formeln la-1a bis la-1d und la-2: 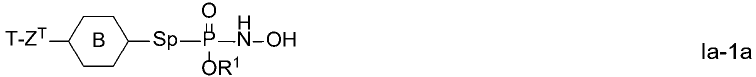 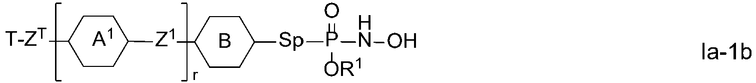 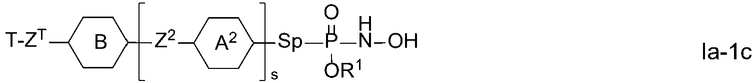 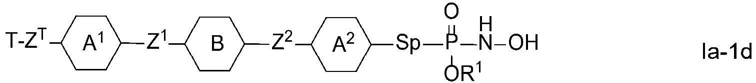 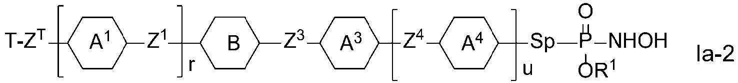
wobei in den Verbindungen der Formeln Ia-1a, la-1b, Ia-1c und Ia-1d r 1 oder 2 ist und s 1 oder 2 ist,
und in den Verbindung der Formel la-2 r und u gleich oder verschieden 0, 1 oder 2 sind,
und worin
T ausgewählt ist aus der Gruppe von Resten, die aus den folgenden Gruppen besteht:
a) geradkettiges oder verzweigtes Alkyl oder Alkoxy mit jeweils 1 bis 20 C-Atomen, wobei in diesen Resten eine oder mehrere CH₂-Gruppen jeweils unabhängig voneinander so durch -C≡C-, -CH=CH-, 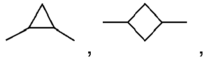 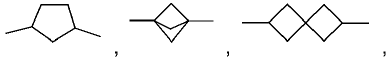 -O-, -S-, -CF₂O-, -OCF₂-, -CO-O-, -O-CO-, -SiR⁰R⁰⁰-, -NH-, -NR⁰- oder -SO₂- ersetzt sein können, dass O-Atome nicht direkt miteinander verknüpft sind, und worin ein oder mehrere H-Atome durch Halogen, CN, SCN oder SF₅ ersetzt sein können, bei denen R⁰ und R⁰⁰ gleich oder verschieden einen Alkyl- oder Alkoxyrest mit 1 bis 15 C-Atomen bedeuten, worin zusätzlich ein oder mehrere H-Atome durch Halogen ersetzt sein können,
b) ein drei- bis zehngliedriger gesättigter oder teilweise ungesättigter aliphatischer Ring, worin mindestens eine -CH₂-Gruppe durch -O-, -S-, -S(O)-, -SO₂-, -NR^{x}- oder -N(O)R^{×}- ersetzt ist oder worin mindestens eine -CH=-Gruppe durch -N= ersetzt ist,
c) ein Diamantoidrest,
Z^{T}, Z¹, Z² und Z⁴ bei jedem Auftreten gleich oder verschieden eine Einfachbindung, -CF₂O-, -OCF₂-, -CF₂S-, -SCF₂-, -CH₂O-, -OCH₂-, -C(O)O-, -OC(O)-, -C(O)S-, -SC(O)-, -(CH₂)ₙ₁-, -(CF₂)ₙ₂-, -CF₂ CH₂-, -CH₂CF₂-, -CH=CH-, -CF=CF-, -CF=CH-, -CH=CF-, -(CH₂)ₙ₃O-, -O(CH₂)ₙ₄-, -C≡C-, -O-, -S-, -CH=N-, -N=CH-, -N=N-, -N=N(O)-, -N(O)=N- oder -N=C-C=N- bedeuten, bei denen n1, n2, n3, n4 gleich oder verschieden 1, 2, 3, 4, 5, 6, 7, 8, 9 oder 10 sind,
Z³ -O-, -S-, -CH₂-, -C(O)-, -CF₂-, -CHF-, -C(R^{x})₂-, -S(O)- oder -SO₂-bedeutet, 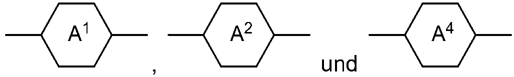 bei jedem Auftreten gleich oder verschieden einen aromatischen, heteroaromatischen, alicyclischen oder heteroaliphatischen Ring mit 4 bis 25 Ringatomen bedeuten, der auch kondensierte Ringe enthalten kann und der ein- oder mehrfach durch Y substituiert sein kann, 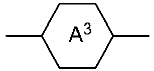 einen aromatischen oder heteroaromatischen Ring mit 5 bis 25 Ringatomen bedeutet, der auch kondensierte Ringe enthalten kann und der ein- oder mehrfach durch R^{C} substituiert sein kann,
Y bei jedem Auftreten gleich oder verschieden F, Cl, CN, SCN, SF₅ oder geradkettiges oder verzweigtes, jeweils gegebenenfalls fluoriertes Alkyl, Alkoxy, Alkylcarbonyl, Alkoxycarbonyl, Alkylcarbonyloxy oder Alkoxycarbonyloxy mit 1 bis 12 C-Atomen bedeutet, 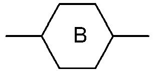 eine Gruppe 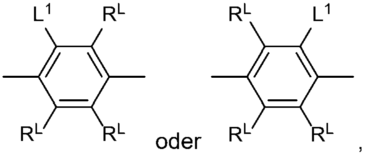 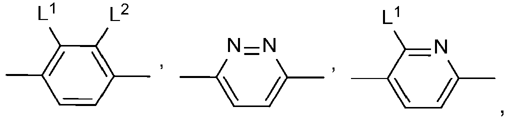 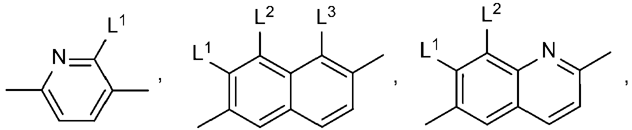 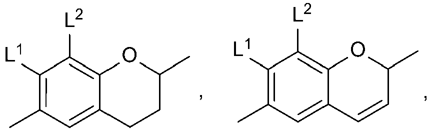 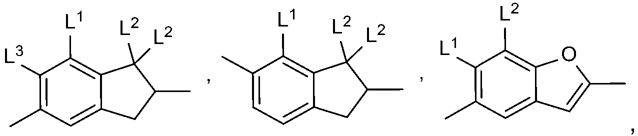 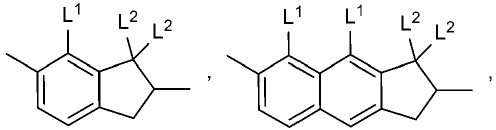 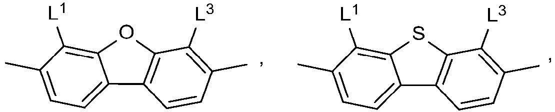 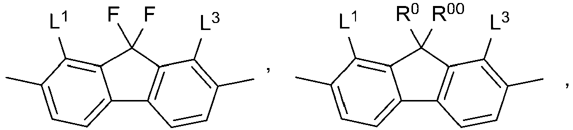 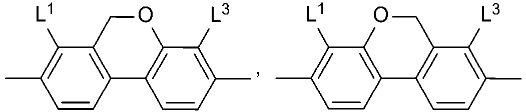 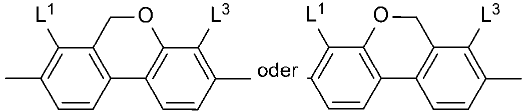 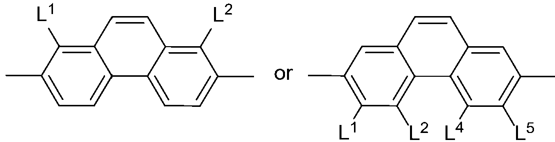 bedeutet, bei denen die Gruppen in beide Richtungen orientiert sein können,
L¹ bis L⁵ gleich oder verschieden H, F, Cl, Br, I, CN, SF₅, CF₃, OCF₃ oder OCHF₂ bedeuten, wobei mindestens einer der vorhandenen Reste L¹ bis L⁵ in den jeweiligen Gruppen nicht H ist,
R^{L} bei jedem Auftreten gleich oder verschieden H, Alkyl mit 1 bis 6 C-Atomen, Alkenyl mit 2 bis 6 C-Atomen oder Alkoxy mit 1 bis 5 C-Atomen bedeutet,
R^{C} bei jedem Auftreten gleich oder verschieden geradkettiges oder verzweigtes, jeweils gegebenenfalls fluoriertes Alkyl, Alkoxy, Alkylthio, Alkylcarbonyl, Alkoxycarbonyl, Alkylcarbonyloxy oder Alkoxycarbonyloxy mit 1 bis 12 C-Atomen oder Cycloalkyl oder Alkylcycloalkyl mit jeweils 3 bis 12 C-Atomen bedeutet,
R⁰, R⁰⁰, R^{x} geradkettiges oder verzweigtes Alkyl mit 1 bis 6 C-Atomen bedeuten,
R¹ H oder geradkettiges oder verzweigtes Alkyl mit 1 bis 12 C-Atomen bedeutet,
Sp eine Einfachbindung oder Sp'-X' bedeutet, worin X' an einen Ring A², A³, A⁴ oder B gebunden ist,
worin
Sp' geradkettiges oder verzweigtes Alkylen mit 1 bis 20, vorzugsweise 1 bis 12, C-Atomen bedeutet, das gegebenenfalls ein- oder mehrfach durch F, Cl, Br, I oder CN substituiert ist und worin zusätzlich eine oder mehrere nicht benachbarte CH₂-Gruppen jeweils unabhängig voneinander so durch -O-, -S-, -NH-, -NR⁰-, -SiR⁰⁰R⁰⁰⁰-, -CO-, -COO-, -OCO-, -OCO-O-, -S-CO-, -CO-S-, -NR⁰-CO-O-, -O-CO-NR⁰-, -NR⁰-CO-NR⁰-, -CH=CH- oder -C≡C- ersetzt sein können, dass O- und/oder S-Atome nicht direkt miteinander verknüpft sind,
X' -O-, -S-, -CO-, -COO-, -OCO-, -O-COO-, -CO-NR⁰⁰-, -NR⁰⁰-CO-, -NR⁰⁰-CO-NR⁰⁰-, -OCH₂-, -CH₂O-, -SCH₂-, -CH₂S-, -CF₂O-, -OCF₂-, -CF₂S-, -SCF₂-, -CF₂CH₂-, -CH₂CF₂-, -CF₂CF₂-, -CH=N-, -N=CH-, -N=N-, -CH=CR⁰⁰-, -CY^{x}=CY^{x'}-, -C≡C-, -CH=CH-COO-, -OCO-CH=CH- oder eine Einfachbindung bedeutet, worin R⁰, R⁰⁰ und R⁰⁰⁰ jeweils unabhängig voneinander H oder Alkyl mit 1 bis 12 C-Atomen bedeuten und Y^{x} und Y^{x'} jeweils unabhängig voneinander H, F, CI oder CN bedeuten.

2. Verbindung nach Anspruch 1, bei der
T H, 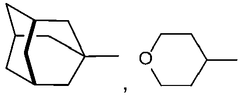 oder geradkettiges oder verzweigtes Alkyl oder Alkoxy mit jeweils 1 bis 7 C-Atomen oder geradkettiges oder verzweigtes Alkenyl mit 2 bis 7 C-Atomen bedeutet,
Z^{T} CH₂O, OCH₂, CH₂CH₂ oder eine Einfachbindung bedeutet,
Z¹ und Z² gleich oder verschieden CH₂O, OCH₂, CH₂CH₂, CF₂O, OCF₂, C(O)O, OC(O) oder eine Einfachbindung bedeuten, 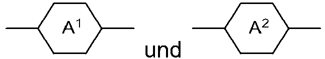 gleich oder verschieden 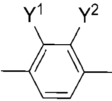 oder 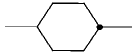 bedeuten,
Y¹ und Y² bei jedem Auftreten gleich oder verschieden H, F oder CI bedeuten,
Sp verzweigtes oder unverzweigtes 1,ω-Alkylen mit 1 bis 12 C-Atomen bedeutet, worin eine oder mehrere nicht benachbarte CH₂-Gruppen durch O ersetzt sein können,
R¹ H bedeutet, und 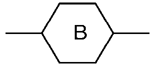 die in Anspruch 1 definierten Bedeutungen besitzt.

3. Verbindung nach Anspruch 1, bei der in Formel la-2 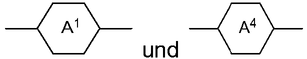 gleich oder verschieden 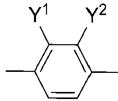 oder 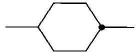 bedeuten,
A³-Z³ 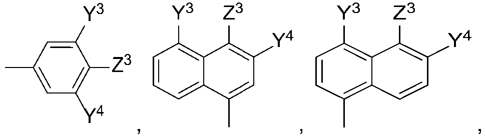 bedeutet, 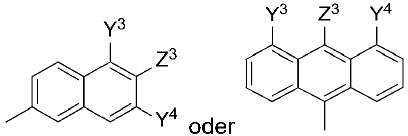
Z^{T} eine Einfachbindung, -CH₂O-, -OCH₂- oder -CH₂CH₂- bedeutet,
Y¹ und Y² H , F oder CI bedeuten,
Y³ und Y⁴ Methyl, Ethyl, Isopropyl, Cyclopropyl, Cyclobutyl, Cyclopentyl, Cyclopentenyl, Cyclohexyl, Cyclohexenyl, Methoxy, Trifluormethyl, Trifluormethoxy oder Trifluormethylthio bedeuten,
Z³ CH₂ oder O bedeutet,
Z¹ und Z⁴ unabhängig voneinander eine Einfachbindung, -C(O)O-, -OC(O)-, -CF₂O-, -OCF₂-, -CH₂O-, OCH₂- oder -CH₂CH₂-bedeuten,
r und u unabhängig 0, 1 oder 2 sind.

4. Verbindung nach einem oder mehreren der Ansprüche 1 bis 3, bei der die Gruppe 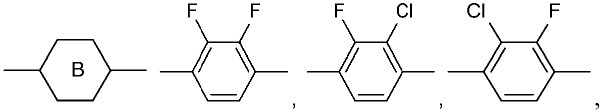 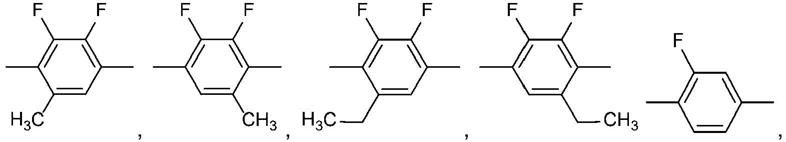 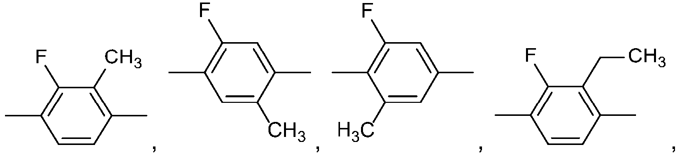 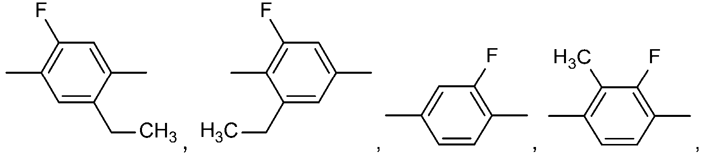 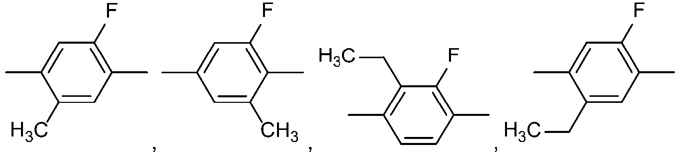 oder 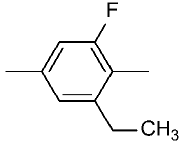 bedeutet.

5. Verfahren zur Herstellung einer Verbindung der Formel Ib mit den Schritten
a) Umsetzung eines Phosphonochloridats der Formel II mit einem O-(Trialkyl-silyl)hydroxylamin in Anwesenheit einer Base zu N-[(Alkoxy)phosphoryl]-hydroxylaminen der Formel la, und
b) Esterspaltung der Verbindung der Formel la zu den Verbindungen der Formel Ib 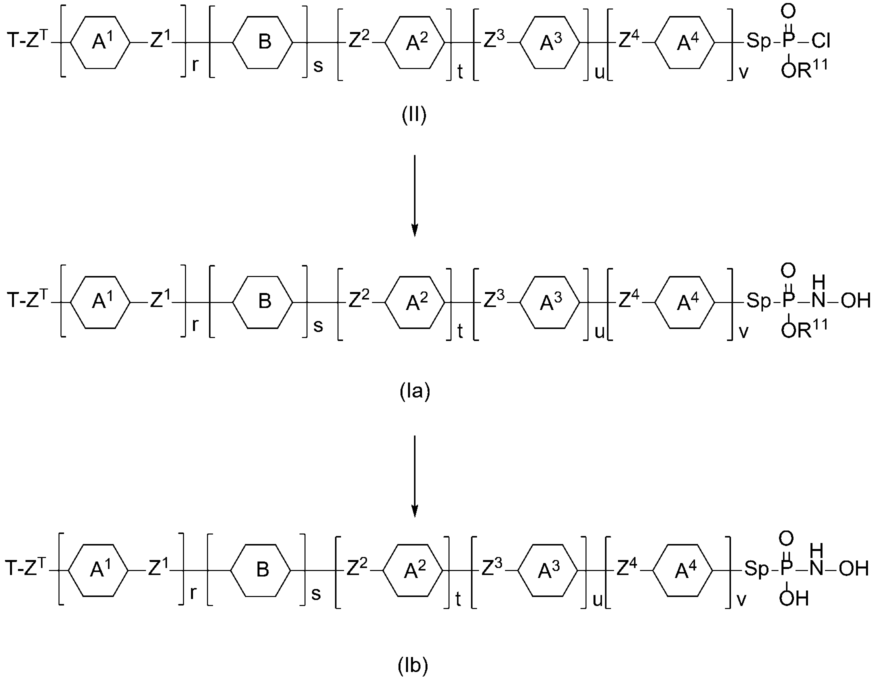
bei denen T, Z^{T}, 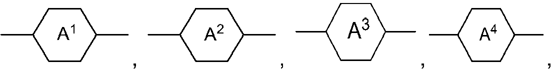 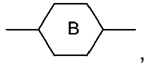 Z¹, Z², Z³, Z⁴, Sp, r, s, t, u und v die in Anspruch 1 genannten Bedeutungen besitzen, und
R¹¹ geradkettiges Alkyl mit 1 bis 12 C-Atomen oder verzweigtes Alkyl mit 3 bis 12 C-Atomen bedeutet.

6. Elektronische Schaltvorrichtung (100), die, in dieser Reihenfolge, umfasst:
eine erste Elektrode (102),
eine molekulare Schicht (103), die an die erste Elektrode gebunden ist, und
eine zweite Elektrode (104),
bei der die ersten und zweiten Elektroden (102, 104), gleich oder verschieden, vorzugsweise ein Material enthalten, das ausgewählt ist aus Ag, Al, Au, Co, Cr, Cu, Mo, Nb, Ni, Pt, Ru, Si, W, CrN, HfN, MoN, NbN, TiN, TaN, Ta₃N₅, TaNx, TaON, WN, WCN, VN, ZrN, Ta₂O₅, SiO₂, ZrO₂, HfO₂, WO₃, RuO₂, Cu₂O, TiO₂, Co₂O₃ und Niob-dotiertem Strontiumtitanat,
**dadurch gekennzeichnet, dass** die molekulare Schicht (103) im Wesentlichen aus einer oder mehreren Verbindungen gebildet ist, die ausgewählt sind aus der Gruppe der Verbindungen der Formeln Ia-1a, la-1b, la-1c, Ia-1d und la-2, nach einem oder mehreren der Ansprüche 1 bis 4.

7. Elektronische Schaltvorrichtung (100) nach Anspruch 6, bei der zwischen der ersten Elektrode (102) und der molekularen Schicht (103) eine Zwischenschicht (105) angeordnet ist, wobei die Zwischenschicht (105) ein oxidisches Material enthält und wobei die molekulare Schicht (103) an das oxidische Material gebunden ist und wobei die erste Elektrode (102) und die Zwischenschicht (105) als eine erste Elektrode (102') betreibbar sind.

8. Elektronische Schaltvorrichtung (100) nach Anspruch 6 oder 7, bei der die eine oder mehreren aus der Gruppe der Verbindungen der Formeln Ia-1a, Ia-1b, Ia-1c, Ia-1d und la-2 ausgewählten Verbindungen durch Chemisorption oder kovalent an die erste Elektrode (102) gebunden sind.

9. Elektronische Schaltvorrichtung (100) nach einem oder mehreren der Ansprüche 6 bis 8, bei der die molekulare Schicht (103) eine molekulare Monoschicht ist.

10. Elektronische Komponente enthaltend eine oder mehrere Schaltvorrichtungen (100) nach einem oder mehreren der Ansprüche 6 bis 9.

11. Elektronische Komponente nach Anspruch 10, bei der die Komponente eine Vielzahl von Schaltvorrichtungen (100) aufweist, wobei die ersten Elektroden (102) und zweiten Elektroden (104) der Schaltvorrichtungen (100) eine Kreuzdrahtvorrichtung bilden.

12. Elektronische Komponente nach Anspruch 10 oder 11, bei der die Schaltvorrichtungen (100) dafür konfiguriert sind, zwischen einem Zustand mit hohem elektrischen Widerstand und einem Zustand mit niedrigem elektrischen Widerstand zu wechseln, wobei der Quotient zwischen hohem elektrischen Widerstand und niedrigem elektrischen Widerstand zwischen 10 und 100.000 liegt.

13. Verwendung einer Verbindung aus der Gruppe der Verbindungen der Formeln la-1a, Ia-1b, Ia-1c, Ia-1d und la-2 nach Anspruch 1 zur Herstellung einer selbstorganisierten Monoschicht.

## Revendications

1. Composé choisi parmi les composés de formules la-1a à la-1d et la-2 : 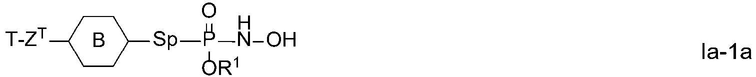 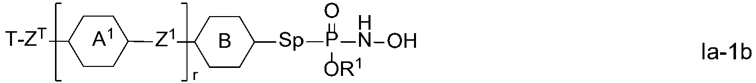 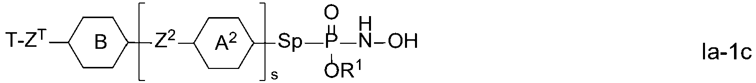 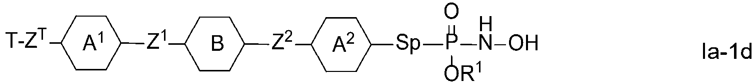 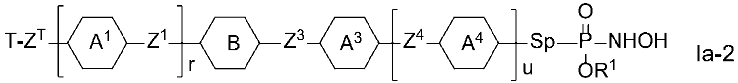
où, dans les composés de formules la-1a, la-1b, la-1c et la-1d, r vaut 1 ou 2, et s vaut 1 ou 2,
et dans le composé de formule la-2, r et u, de manière identique ou différente, valent 0, 1 ou 2,
et où
T est choisi dans le groupe constitué par les radicaux constitués par les groupements suivants :
a) alkyle ou alcoxy à chaîne linéaire ou ramifiée ayant chacun de 1 à 20 atomes de C, où un ou plusieurs groupements CH₂ dans ces radicaux peuvent chacun être remplacés, indépendamment les uns des autres, par -C≡C-, -CH=CH-, 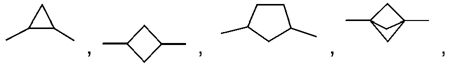 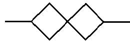 -O-, -S-, -CF₂O-, -OCF₂-, -CO-O-, -O-CO-, -SiR⁰R⁰⁰-, -NH-, -NR⁰- ou -SO₂- de telle sorte que les atomes de O ne soient pas liés directement les uns aux autres, et où un ou plusieurs atomes de H peuvent être remplacés par halogène, CN, SCN ou SF₅, où R⁰ et R⁰⁰, de manière identique ou différente, désignent un radical alkyle ou alcoxy ayant de 1 à 15 atomes de C, où, de plus, un ou plusieurs atomes de H peuvent être remplacés par halogène,
b) un cycle aliphatique de trois à dix chaînons saturé ou partiellement insaturé, où au moins un groupement -CH₂- est remplacé par -O-, -S-, -S(O)-, -SO₂-, -NR^{x}- ou -N(O)R^{x}-, ou où au moins un groupement -CH= est remplacé par -N=,
c) un radical diamantoïde,
Z^{T}, Z¹, Z², et Z⁴, à chaque occurrence, de manière identique ou différente, désignent une liaison simple, -CF₂O-, -OCF₂-, -CF₂S-, -SCF₂-, -CH₂O-, -OCH₂-, -C(O)O-, -OC(O)-, -C(O)S-, -SC(O)-, -(CH₂)ₙ₁-, -(CF₂)ₙ₂-, -CF₂CH₂-, -CH₂CF₂-, -CH=CH-, -CF=CF-, -CF=CH-, -CH=CF-, -(CH₂)ₙ₃O-, -O(CH₂)ₙ₄-, -C≡C-, -O-, -S-, -CH=N-, -N=CH-, -N=N-, -N=N(O)-, -N(O)=N- ou -N=C-C=N-, où n1, n2, n3, n4, de manière identique ou différente, valent 1, 2, 3, 4, 5, 6, 7, 8, 9 ou 10,
Z³ désigne -O-, -S-, -CH₂-, -C(O)-, -CF₂-, -CHF-, -C(R^{x})₂-, -S(O)- ou -SO₂-, 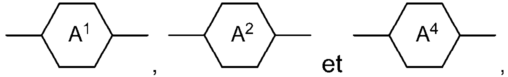 à chaque occurrence, de manière identique ou différente, désignent un cycle aromatique, hétéroaromatique, alicyclique ou hétéroaliphatique ayant de 4 à 25 atomes de cycle, pouvant également contenir des cycles condensés et pouvant être mono- ou polysubstitué par Y, 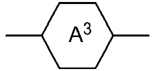 désigne un cycle aromatique ou hétéroaromatique ayant de 5 à 25 atomes de cycle, pouvant également contenir des cycles condensés et pouvant être mono- ou polysubstitué par R^{C},
Y à chaque occurrence, de manière identique ou différente, désigne F, CI, CN, SCN, SF₅ ou alkyle, alcoxy, alkylcarbonyle, alcoxycarbonyle, alkylcarbonyloxy ou alcoxycarbonyloxy à chaîne linéaire ou ramifiée, dans chaque cas éventuellement fluoré, ayant de 1 à 12 atomes de C, 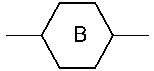 désigne un groupement 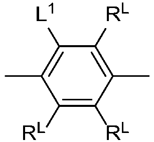 ou 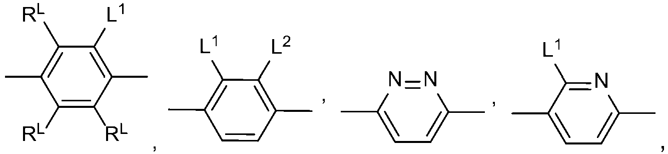 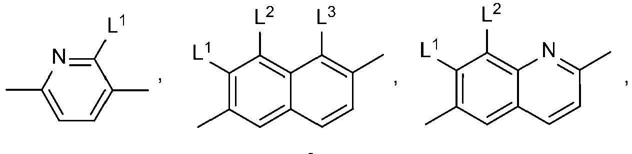 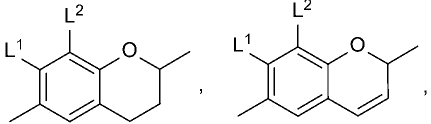 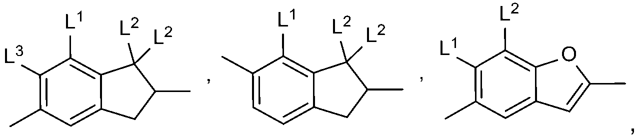 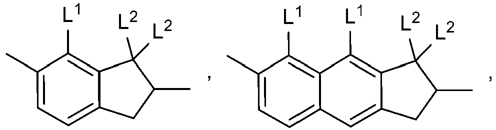 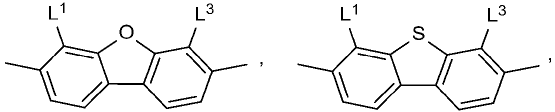 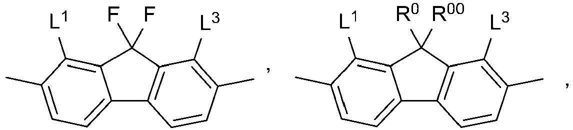 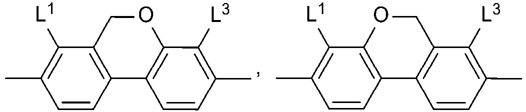 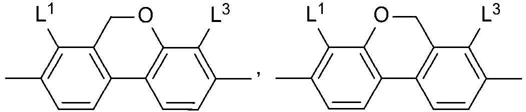 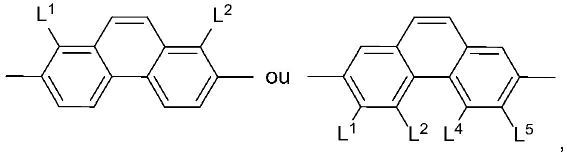 où les groupements peuvent être orientés dans les deux sens,
L¹ à L⁵, de manière identique ou différente, désignent H, F, Cl, Br, I, CN, SF₅, CF₃, OCF₃, ou OCHF₂, où au moins l'un des radicaux L¹ à L⁵ présents dans les groupements respectifs n'est pas H,
R^{L} à chaque occurrence, de manière identique ou différente, désigne H, alkyle ayant de 1 à 6 atomes de C, alcényle ayant de 2 à 6 atomes de C ou alcoxy ayant de 1 à 5 atomes de C,
R^{C} à chaque occurrence, de manière identique ou différente, désigne alkyle, alcoxy, alkylthio, alkylcarbonyle, alcoxycarbonyle, alkylcarbonyloxy ou alcoxycarbonyloxy à chaîne linéaire ou ramifiée, dans chaque cas éventuellement fluoré, ayant de 1 à 12 atomes de C ou cycloalkyle ou alkylcycloalkyle ayant chacun de 3 à 12 atomes de C,
R⁰, R⁰⁰, R^{x} désignent alkyle à chaîne linéaire ou ramifiée ayant de 1 à 6 atomes de C,
R¹ désigne H ou alkyle à chaîne linéaire ou ramifiée ayant de 1 à 12 atomes de C,
Sp désigne une liaison simple ou Sp'-X' où X' est lié à un cycle A², A³, A⁴ ou B
où
Sp' désigne alkylène à chaîne linéaire ou ramifiée ayant de 1 à 20, préférablement de 1 à 12 atomes de C, qui est éventuellement mono- ou polysubstitué par F, Cl, Br, I ou CN et où, de plus, un ou plusieurs groupements CH₂ non adjacents peuvent chacun être remplacés, indépendamment les uns des autres, par -O-, -S-, -NH-, -NR⁰-, -SiR⁰⁰R⁰⁰⁰-, -CO-, -COO-, -OCO-, -OCO-O-, -S-CO-, -CO-S-, -NR⁰-CO-O-, -O-CO-NR⁰-, -NR⁰-CO-NR⁰-, -CH=CH- ou -C≡C- de telle sorte que les atomes de O et/ou S ne soient pas liés directement les uns aux autres,
X' désigne -O-, -S-, -CO-, -COO-, -OCO-, -O-COO-, -CO-NR⁰⁰-, -NR⁰⁰-CO-, -NR⁰⁰-CO-NR⁰⁰-, -OCH₂-, -CH₂O-, -SCH₂-, -CH₂S-, -CF₂O-, -OCF₂-, -CF₂S-, -SCF₂-, -CF₂CH₂-, -CH₂CF₂-, -CF₂CF₂-, -CH=N-, -N=CH-, -N=N-, -CH=CR⁰⁰-, -CY^{x}=CY^{x'}-, -C≡C-, -CH=CH-COO-, -OCO-CH=CH- ou une liaison simple, où R⁰, R⁰⁰ et R⁰⁰⁰ désignent chacun, indépendamment les uns des autres, H ou alkyle ayant de 1 à 12 atomes de C, et Y^{x} et Y^{x'} désignent chacun, indépendamment l'un de l'autre, H, F, Cl ou CN.

2. Composé selon la revendication 1, dans lequel
T désigne H, 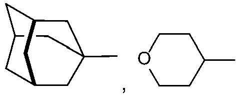 ou alkyle ou alcoxy à chaîne linéaire ou ramifiée ayant chacun de 1 à 7 atomes de C ou alcényle à chaîne linéaire ou ramifiée ayant de 2 à 7 atomes de C,
Z^{T} désigne CH₂O, OCH₂, CH₂CH₂, ou une liaison simple,
Z¹ et Z², de manière identique ou différente, désignent CH₂O, OCH₂, CH₂CH₂, CF₂O, OCF₂, C(O)O, OC(O) ou une liaison simple, 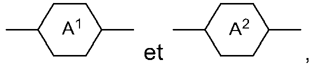 de manière identique ou différente, désignent 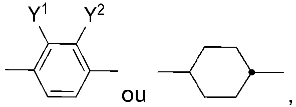
Y¹ et Y², à chaque occurrence, de manière identique ou différente, désignent H, F ou Cl,
Sp désigne 1,ω-alkylène ramifié ou non ramifié ayant de 1 à 12 atomes de C, où un ou plusieurs groupements CH₂ non adjacents peuvent être remplacés par O,
R¹ désigne H, et 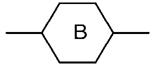 revêt les significations définies selon la revendication 1.

3. Composé selon la revendication 1, dans lequel, dans la formule la-2, 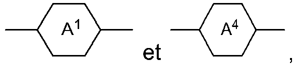 de manière identique ou différente, désignent 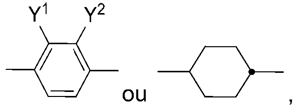
A³-Z³ désigne 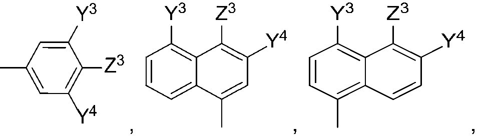 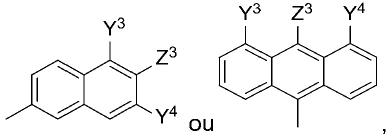
Z^{T} désigne une liaison simple, -CH₂O-, -OCH₂- ou -CH₂CH₂-,
Y¹ et Y² désignent H, F ou Cl,
Y³ et Y⁴ désignent méthyle, éthyle, isopropyle, cyclopropyle, cyclo-butyle, cyclopentyle, cyclopentényle, cyclohexyle, cyclo-hexényle, méthoxy, trifluorométhyle, trifluorométhoxy, ou trifluorométhylthio,
Z³ désigne CH₂ ou O,
Z¹ et Z⁴, indépendamment l'un de l'autre, désignent une liaison simple, -C(O)O-, -OC(O)-, -CF₂O-, -OCF₂-, -CH₂O-, OCH₂- ou -CH₂CH₂-,
r et u valent indépendamment 0, 1 ou 2.

4. Composé selon l'une ou plusieurs parmi les revendications 1 à 3, dans lequel le groupement 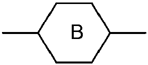 désigne

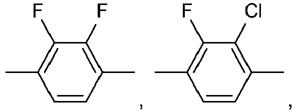

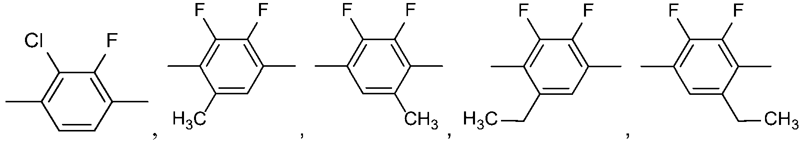

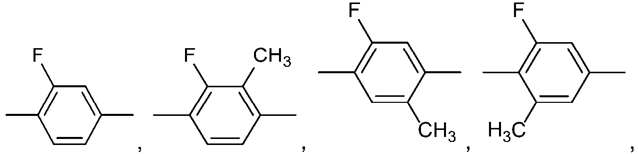

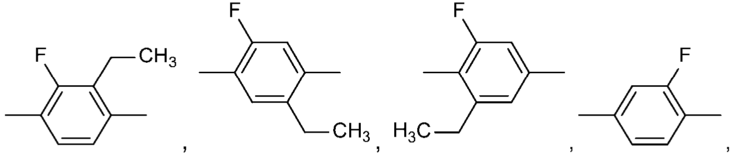

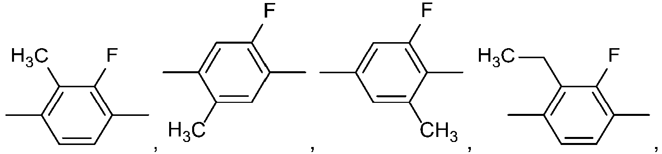

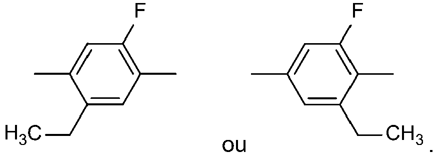

5. Procédé de préparation d'un composé de formule Ib, comprenant les étapes
a) de réaction d'un phosphonochloridate de formule II avec une O-(trialkyl-silyl)hydroxylamine en présence d'une base pour conduire aux N-[(alcoxy)-phosphoryl]hydroxylamines de formule la, et
b) l'hydrolyse d'ester du composé de formule la pour conduire aux composés de formule Ib 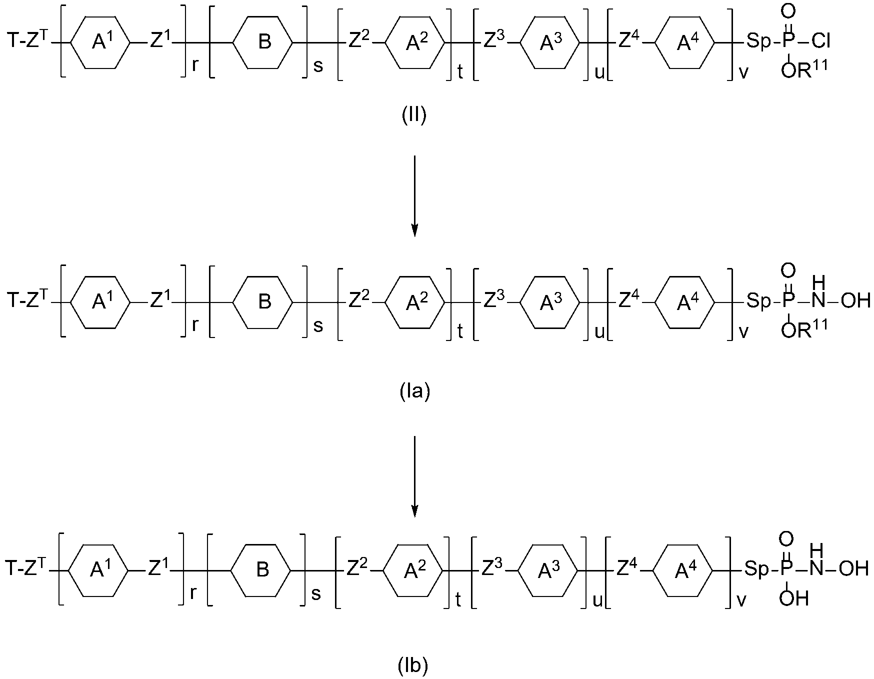
où T, Z^{T}, 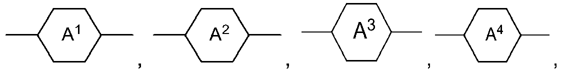 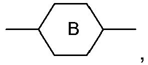 Z¹, Z², Z³, Z⁴, Sp, r, s, t, u, et v revêtent les significations données selon la revendication 1, et
R¹¹ désigne alkyle à chaîne linéaire ayant de 1 à 12 atomes de C ou alkyle ramifié ayant de 3 à 12 atomes de C.

6. Dispositif de commutation électronique (100) qui comprend, dans cet ordre,
une première électrode (102),
une couche moléculaire (103) liée à la première électrode, et
une deuxième électrode (104),
où la première et la deuxième électrode (102, 104), de manière identique ou différente, comprennent préférablement un matériau choisi parmi Ag, Al, Au, Co, Cr, Cu, Mo, Nb, Ni, Pt, Ru, Si, W, CrN, HfN, MoN, NbN, TiN, TaN, Ta₃N₅, TaNx, TaON, WN, WCN, VN, ZrN, Ta₂O₅, SiO₂, ZrO₂, HfO₂, WO₃, RuO₂, Cu₂O, TiO₂, Co₂O₃, et du titanate de strontium dopé au niobium,
**caractérisé en ce que** la couche moléculaire (103) est essentiellement formée à partir d'un ou plusieurs composés choisis dans le groupe constitué par les composés de formule la-1a, la-1b, la-1c, la-1d, et la-2, selon l'une ou plusieurs parmi les revendications 1 à 4.

7. Dispositif de commutation électronique (100) selon la revendication 6, dans lequel une couche intermédiaire (105) est disposée entre la première électrode (102) et la couche moléculaire (103), où la couche intermédiaire (105) comprend un matériau oxygéné et où la couche moléculaire (103) est liée audit matériau oxygéné, et où la première électrode (102) et la couche intermédiaire (105) sont utilisables comme première électrode (102').

8. Dispositif de commutation électronique (100) selon la revendication 6 ou 7, dans lequel les un ou plusieurs composés choisis dans le groupe constitué par les composés de formules la-1a, la-1b, la-1c, Ia-1d, et la-2 sont liés à la première électrode (102) par adsorption chimique ou de manière covalente.

9. Dispositif de commutation électronique (100) selon l'une ou plusieurs parmi les revendications 6 à 8, dans lequel la couche moléculaire (103) est une monocouche moléculaire.

10. Composant électronique comprenant un ou plusieurs dispositifs de commutation (100) selon l'une ou plusieurs parmi les revendications 6 à 9.

11. Composant électronique selon la revendication 10, le composant ayant une multitude de dispositifs de commutation (100), où les premières électrodes (102) et les deuxièmes électrodes (104) des dispositifs de commutation (100) forment un réseau à barres croisées.

12. Composant électronique selon la revendication 10 ou 11, dans lequel les dispositifs de commutation (100) sont configurés pour passer d'un état présentant une résistance électrique élevée à un état présentant une résistance électrique faible, le quotient entre la résistance électrique élevée et la résistance électrique faible étant compris entre 10 et 100 000.

13. Utilisation d'un composé choisi dans le groupe constitué par les composés de formules la-1a, la-1b, la-1c, la-1d, et la-2 selon la revendication 1, pour la fabrication d'une monocouche auto-assemblée.
